(19) Europäisches Patentamt
European Patent Office
Office européen des brevets

(11) EP 2 339 401 B1

(12) # EUROPEAN PATENT SPECIFICATION

(45) Date of publication and mention of the grant of the patent:
**17.02.2016 Bulletin 2016/07**

(51) Int Cl.:
***G03F 7/11*** *(2006.01)* ***B41C 1/10*** *(2006.01)*

(21) Application number: **10197132.3**

(22) Date of filing: **28.12.2010**

(54) **Method of preparing lithographic printing plate**

Verfahren zur Herstellung einer Lithographiedruckplatte

Procédé de préparation de plaque d'impression lithographique

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **28.12.2009 JP 2009298572**

(43) Date of publication of application:
**29.06.2011 Bulletin 2011/26**

(73) Proprietor: **Fujifilm Corporation**
**Minato-ku**
**Tokyo (JP)**

(72) Inventors:
- **Sasaki, Tomoya**
  **Shizuoka (JP)**
- **Iwai, Yu**
  **Shizuoka (JP)**

(74) Representative: **Hoffmann Eitle**
**Patent- und Rechtsanwälte PartmbB**
**Arabellastraße 30**
**81925 München (DE)**

(56) References cited:

**EP-A1- 1 892 572** **EP-A1- 2 078 984**
**EP-A1- 2 107 422** **EP-A1- 2 226 681**
**EP-A2- 1 767 352** **EP-A2- 2 006 738**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 339 401 B1

## Description

AFIELD OF THE INVENTION

The present invention relates to a method of preparing a lithographic printing plate, particularly, to a method of preparing a lithographic printing plate which exhibits excellent processing property and enables processing with one solution or one bath.

BACKGROUND OF THE INVENTION

In general, a lithographic printing plate is composed of an oleophilic image area accepting ink and a hydrophilic non-image area accepting dampening water in the process of printing. Lithographic printing is a printing method which comprises rendering the oleophilic image area of the lithographic printing plate to an ink-receptive area and the hydrophilic non-image area thereof to a dampening water-receptive area (ink unreceptive area), thereby making a difference in adherence of ink on the surface of the lithographic printing plate, and depositing the ink only on the image area by utilizing the nature of water and printing ink to repel with each other, and then transferring the ink to a printing material, for example, paper.

In order to prepare the lithographic printing plate, a lithographic printing plate precursor (PS plate) comprising a hydrophilic support having provided thereon an oleophilic photosensitive resin layer (also referred to as a photosensitive layer or an image-recording layer) has heretofore been broadly used. Ordinarily, the lithographic printing plate is obtained by conducting plate making according to a method of exposing the lithographic printing plate precursor through an original, for example, a lith film, and then removing the unnecessary portion of the image-recording layer by dissolving with an alkaline developer or an organic solvent thereby revealing the hydrophilic surface of support to form the non-image area while leaving the image-recording layer in the portion for forming the image area.

In recent years, digitalized technique of electronically processing, accumulating and outputting image information using a computer has been popularized, and various new image outputting systems responding to the digitalized technique have been put into practical use. Correspondingly, attention has been drawn to a computer-to-plate (CTP) technique of carrying digitalized image information on highly converging radiation, for example, laser light and conducting scanning exposure of a lithographic printing plate precursor with the light thereby directly preparing a lithographic printing plate without using a lith film.

On the other hand, in the hitherto known plate making process of lithographic printing plate precursor, after exposure, the step of removing the unnecessary portion of the image-recording layer by dissolving, for example, with a developer is required. However, in view of the environment and safety, a processing with a developer closer to a neutral range and a small amount of waste liquid are problems to be solved. Particularly, since disposal of waste liquid discharged accompanying the wet treatment has become a great concern throughout the field of industry in view of the consideration for global environment in recent years, the demand for the resolution of the above-described problems has been increased more and more.

As described above, the decrease in alkali concentration of developer and the simplification of processing step have been further strongly required from both aspects of the consideration for global environment and the adaptation for space saving and low running cost. However, since hitherto known development processing comprises three steps of developing with an aqueous alkali solution having pH of 10 or more, washing of the alkali agent with a water-washing bath and then treating with a gum solution mainly comprising a hydrophilic resin as described above, an automatic developing machine per se requires a large space and problems of the environment and running cost, for example, disposal of the development waste liquid, water-washing waste liquid and gum waste liquid still remain.

In response to the above problems, for instance, in JP-A-2006-239867 (the term "JP-A" as used herein means an "unexamined published Japanese patent application"), a lithographic printing plate precursor which contains a copolymer having a weight average molecular weight of 30,000 or more and containing a repeating unit having an ethylenically unsaturated bond and a repeating unit having a functional group capable of interacting with a surface of support and is capable of forming an image without undergoing alkali development is described.

In JP-A-200 8-256742, a negative lithographic printing plate precursor having on a support, a layer containing an organic resin fine particle and a photosensitive layer containing a sensitizing dye having an absorption maximum in a range from 350 to 450 nm. As a specific example of the organic resin for forming the organic resin fine particle, a resin having a methacryl group connected with an ammonium structure in its side chain is described.

There is no description with respect to a plate making method including development using a developer having a buffer function in any of JP-A-2006-239867 and JP-A-2008-256742.

According to the prior art techniques, it is difficult to balance stain resistance and stain resistance when the lithographic printing plate precursor is preserved for a long period of time with printing durability by processing with an aqueous solution having a buffer function. Also, the prior art techniques are insufficient in chemical resistance.

The chemical resistance means durability of the image area against a specific dampening water. Various kinds of the dampening waters for use at printing are present and the components thereof widely varied. The dampening water is ordinarily marketed as its stock solution and it is used after dilution. When the stock solution of the specific dampening water is brought into contact with a lithographic printing plate before printing, the image area is dissolved or peeled to cause a problem of the generation of printing failure. Though the reason for this is not quite clear, it is presumed that an organic solvent contained in the specific dampening water may engage.

EP-A-2 226 681, which is prior art pursuant to Article 54(3) EPC, relates to a lithographic printing plate precursor and a method of preparing a lithographic printing plate that is suitable for simple processing.

EP-A-2 107 422 relates to a method of preparing a lithographic printing plate which exhibits good developing property.

EP-A-2 006 738 relates to a lithographic printing plate precursor capable of undergoing image recording with a laser and capable of undergoing-machine development.

EP-A-1 767 352 relates to a lithographic printing plate precursor capable of undergoing so-called direct plate-making and a printing method using the lithographic printing plate precursor.

SUMMARY OF THE INVENTION

An object of the present invention is to provide a method of preparing a lithographic printing plate by processing with an aqueous solution having a buffer function in which the lithographic printing plate exhibits good stain resistance which does not degrade even when a lithographic printing plate precursor is preserved for a long period of time and is excellent in printing durability and chemical resistance.

The inventors have found that by a method of preparing a lithographic printing plate comprising imagewise exposing a lithographic printing plate precursor comprising an intermediate layer containing a copolymer containing a repeating unit derived from a monomer having a specific hydrophilic-hydrophobic property and containing a carbon-carbon unsaturated double bond through a covalent bond and having thereof an image-forming layer containing (A)' a polymerization initiator, (B) a polymerizable compound and (C) a binder polymer and removing an unexposed area of the image-forming layer by processing with an aqueous solution having a buffer function, a good balance between the stain resistance, the stain resistance after preservation for a long period of time and the printing durability can be achieved and further surprisingly found that the chemical resistance is improved to complete the invention.

The present invention includes the method of preparing a lithographic printing plate described below.

(1) A method of preparing a lithographic printing plate comprising: a step of imagewise exposing a lithographic printing plate precursor comprising, in the following order, a support, an intermediate layer containing a copolymer containing a repeating unit derived from a monomer having a C log P value of -0.14 or less wherein C log P is the logarithm of the octanol/water partition coefficient (P) of a compound calculated using the program ClogP v4.82 (available from Daylight Chemical Information System, Inc.) and containing a carbon-carbon unsaturated double bond through a covalent bond and an image-forming layer containing (A) a polymerization initiator, (B) a polymerizable compound and (C) a binder polymer; and a step of removing an unexposed area of the image-forming layer by processing the exposed lithographic printing plate precursor with an aqueous solution having a buffer function.

(2) The method of preparing a lithographic printing plate as described in the above (1), wherein the repeating unit contains at least one structure selected from a carboxylate anion, a sulfonate anion, a sulfate anion, a phosphate anion, a phosphonate anion, an ammonium cation, a phosphonium cation and a hydroxy group.

(3) The method of preparing a lithographic printing plate as described in any one of the above (1) or (2), wherein the repeating unit is a repeating unit represented by any of formulae (I) to (VI) shown below:

Formula (I):

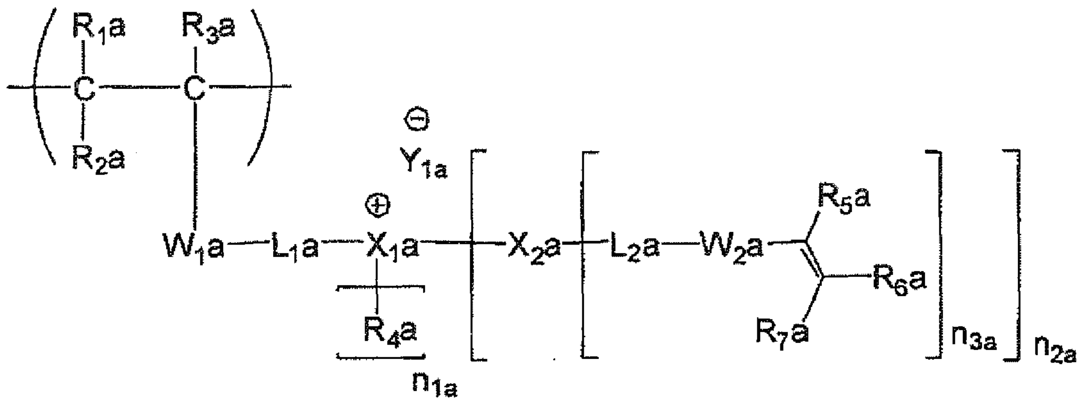

Formula (II):

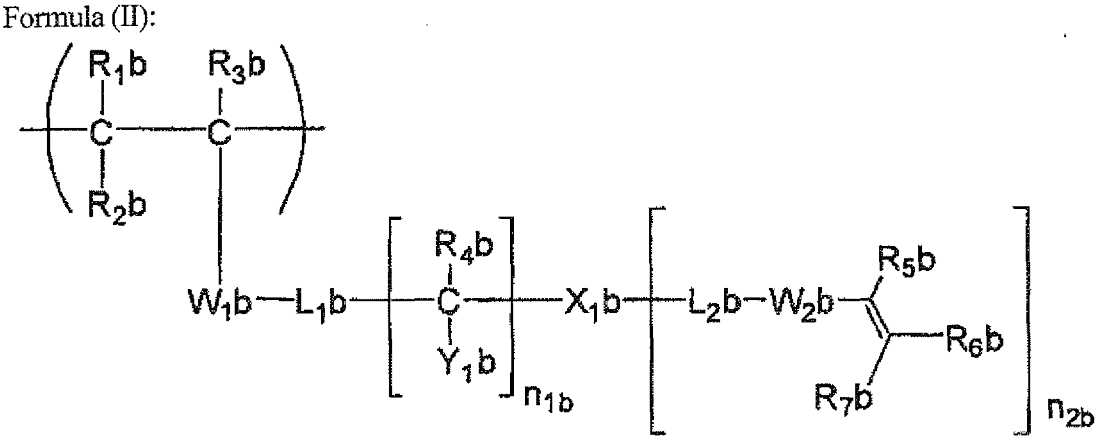

Formula (III):

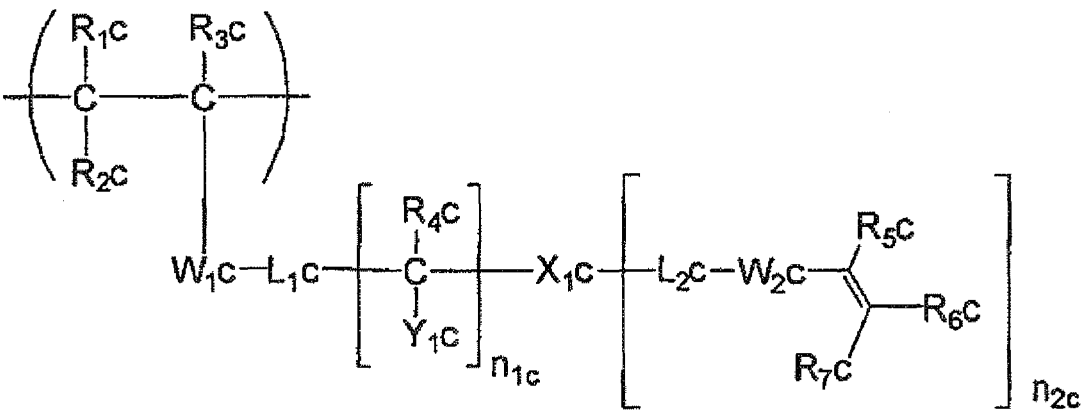

Formula (IV):

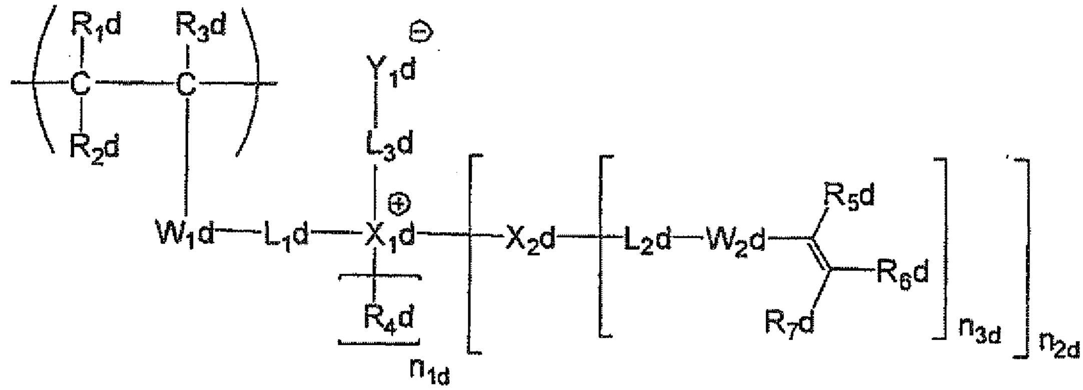

Formula (V):

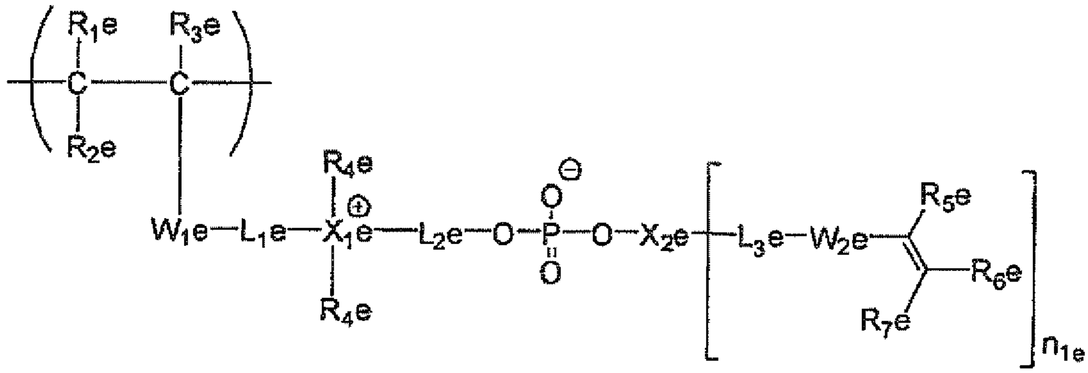

Formula (VI):

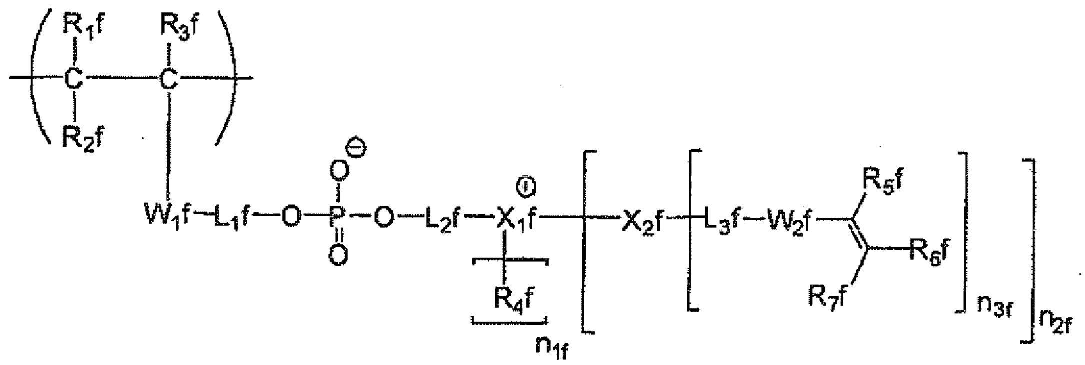

The definition of each symbol in formula (I) is described below:

$R_1a$ to $R_3a$ each represents a hydrogen atom, an alkyl group, a halogen atom or a cyano group,
$R_4a$ each represents a hydrogen atom or a substituent having from 1 to 30 carbon atoms,
$R_5a$ to $R_7a$ each represents a hydrogen atom, an alkyl group, -CO-O-Rx or-CO-N(Ry)(Rz),
Rx represents an alkyl group,
Ry and Rz each represents a hydrogen atom, an alkyl group or an aryl group,
$L_1a$ and $L_2a$ each represents a single bond or a divalent connecting group,
$W_1a$ and $W_2a$ each represents an alkylene group, an arylene group, -O-, -S-, -CO-, -N(Rw)-, $-SO_2-$ or a divalent connecting group composed of an appropriate combination of these groups,
Rw represents a hydrogen atom, an alkyl group or an aryl group,
$X_1a$ represents N or P,
$X_2a$ represents an ($n_3a$ + 1) valent connecting group, provided that when $n_3a$ is 1, $X_2a$ represents a single bond,
$Y_1a$ represents an organic or inorganic anion,

$n_1$p represents an integer from 0 to 2,
$n_2$a represents an integer from I to 3, provided that $n_1a + n_2a = 3$,
$n_3$a represents an integer from 1 to 4;

The definition of each symbol in formula (II) is described below:

$R_1$b to $R_3$b, $R_4$b, $R_5$b to $R_7$b, $L_1$b, $L_2$b, $W_1$b and $W_2$b have the same meanings as $R_1$a to $R_3$a, $R_4$a, $R_5$a to $R_7$a, $L_1$a, $L_2$a, $W_1$a and $W_2$a in formula (I), respectively,
$X_1$b represents an ($n_2$b + 1) valent connecting group, provided that when $n_2$b is 1, $X_1$b represents a single bond,
$Y_1$b each represents a hydrogen atom, a hydroxy group or an alkyl group, provided that at least one of $Y_1$b represents a hydroxy group,
$n_1$b represents an integer from 1 to 10,
$n_2$b represents an integer from 1 to 4;

The definition of each symbol in formula (III) is described below:

$R_1$c to $R_3$c, $R_4$c, $R_5$c to $R_7$c, $L_1$c, $L_2$c, $W_1$c and $W_2$c have the same meanings as $R_1$a to $R_3$a, $R_4$a, $R_5$a to $R_7$a, $L_1$a, $L_2$a, $W_1$a and $W_2$a in formula (I), respectively,
$n_1$c and $n_2$c have the same meanings as $n_1$b and $n_2$b in formula (II), respectively,
$X_1$c represents an ($n_2$c + 1) valent connecting group, provided that when $n_2$c is 1, $X_1$c represents a single bond,
$Y_1$c each represents a hydrogen atom, a hydroxy group, an alkyl group or a group represented by $L_3$c-Q, provided that at least one of $Y_1$c represents a group represented by $L_3$c-Q,
$L_3$c represents a single bond or a divalent connecting group,
Q represents $-CO_2M$, $-SO_3M$, $-OSO_3M$, $-OPO(OM_1)(OM_2)$ or $-PO(OM_3)(OM_4)$,
M, $M_1$ and $M_3$ each represents a monovalent metal ion or $N^+R_0)_4$,
$M_2$ and $M_4$ each represents a hydrogen atom, a monovalent metal ion or $N^+(R_0)_4$,
$R_0$ each represents a hydrogen atom or an alkyl group;

The definition of each symbol in formulae (IV) is described below:

$R_1$d to $R_3$d, $R_4$d, $R_5$d to $R_7$d, $L_1$d, $L_2$d, $W_1$d, $W_2$d, $n_3$d and $X_1$d have the same meanings as $R_1$a to $R_3$a, $R_4$a, $R_5$a to $R_7$a, $L_1$a, $L_2$a, $W_1$a. $W_2$a, $n_3$a and $X_1$a in formula (I), respectively,
$L_3$d represents a divalent connecting group,
$X_2$d represents an ($n_3$d +1) valent connecting group, provided that when $n_3$d is 1, $X_2$d represents a single bond,
$Y_1$d represents $-CO_2^-$, $-SO_3^-$ or $-OPO(O^-)(ORp)$,
Rp represents an alkyl group,
$n_3$d represents 0 or 1,
$n_2$d represents 1 or 2, provided that $n_1d + n_2d = 2$;

The definition of each symbol in formula (V) is described below:

$R_1$e to $R_3$e, $R_4$e, $R_5$e to $R_7$e, $W_1$e, $W_2$e and $X_1$e have the same meanings as $R_1$a to $R_3$a, $R_4$a, $R_5$a to $R_7$a, $W_1$a, $W_2$a and $X_1$a in formula (I), respectively,
$L_1$e and $L_2$e have the same meanings as $L_1$a in formula (I), respectively,
$L_3$e has the same meaning as $L_2$a in formula (I),
$n_1$e has the same meaning as $n_2$b in formula (II),
$X_2$e represents an ($n_1$e + 1) valent connecting group, provided that when $n_1$e is 1, $X_2$e represents a single bond;

The definition of each symbol in formula (VI) is described below:

$R_1$f to $R_3$f, $R_4$f, $R_5$f to $R_7$f, $W_1$f, $W_2$f, $X_1$f, $X_2$f and $n_1$f to $n_3$f have the same meanings as $R_1$a to $R_3$a, $R_4$a, $R_5$a to $R_7$a, $W_1$a, $W_2$a, $X_1$a, $X_2$a and $n_1$a to $n_3$a in formula (I), respectively,
$L_1$f and $L_2$f have the same meanings as $L_1$a in formula (I), respectively,

$L_3f$ has the same meaning as $L_2a$ in formula (I).

(4) The method of preparing a lithographic printing plate as described in any one of the above (1) to (3), wherein the aqueous solution having a buffer function contains at least one of (a) a carbonate ion and a hydrogen carbonate ion, (b) a borate ion, and (c) a water-soluble amine compound and an ion of the amine compound.
(5) The method as described in any one of the above (2) to (4), wherein the repeating unit contains at least one of a sulfonate anion, a phosphate anion, an ammonium cation and a phosphonium cation.

The method of preparing a lithographic printing plate according to the invention is excellent in view of safety and consideration for global environment due to processing with a developer closer to a neutral range and elimination of a water washing step. Also, it makes possible processing with one solution or one bath. Further, the method of preparing a lithographic printing plate according to the invention can provide a lithographic printing plate exhibiting good stain resistance which does not degrade even when a lithographic printing plate precursor is preserved for a long period of time and being excellent in printing durability and chemical resistance.

BRIEF DESCRIPTION OF THE DRAWINGS

Fig. 1 is a view schematically showing a structure of an automatic development processor.

[Description of reference numerals and signs]

1: Rotating brush roller
2: Backing roller
3: Transport roller
4: Transport guide plate
5: Spray pipe
6: Pipe line
7: Filter
8: Plate supply table
9: Plate discharge table
10: Developer tank
11: Circulating pump
12: Lithographic printing plate precursor

DETAILED DESCRIPTION OF THE INTENTION

First, a lithographic printing plate precursor for use in the method of preparing a lithographic printing plate according to the invention is described below.

[Lithographic printing plate precursor]

The lithographic printing plate precursor according to the invention comprises, in the following order, (1) a support, (2) an intermediate layer and (3) an image-forming layer containing (A) a polymerization initiator, (B) a polymerizable compound and (C) a binder polymer, and the intermediate layer contains a copolymer containing a repeating unit (d1) derived from a monomer having a C log P value of -0.14 or less and containing a carbon-carbon unsaturated double bond through a covalent bond. The term "in the following order" does not exclude the possibility that other layer(s) may be provided in between the support and the intermediate layer or between the intermediate layer and the image-forming layer.
The factors on which the lithographic printing plate precursor according to the invention exhibits the excellent performances described above are believed to be as follows. Specifically, since the specific repeating unit (d1) in the copolymer contained in the intermediate layer has a carbon-carbon unsaturated double bond, it has a function of causing a polymerization reaction with the image-forming layer in the exposed area to increase the adhesion property between the intermediate layer and the image-forming layer thereby increasing printing durability. Heretofore, the repeating unit having such a function has high hydrophobicity and rises a problem of deteriorating stain resistance of the unexposed area when incorporated in a large amount. According to the invention, on the contrary, since the repeating unit (d1) has hydrophilicity above a certain level, it is believed that the printing durability can be increased without the deterioration

of stain resistance even when introduced in the large amount.

The reason for exhibiting the remarkable effects in the stain resistance and stain resistance after preservation particularly in the case of processing with an aqueous solution having a buffer function is believed to be as follows. Specifically, in the case of processing with an aqueous solution having no buffer function (for example, an aqueous alkali solution having no buffer function), since the alkali attaches on the surface of intermediate layer in the non-image area (particularly on the portion where the hydrophilicity is high, such as the repeating unit (d1)), the hydrophilicity of the surface becomes high. However, at the printing, the alkali attached is diluted or removed by supplying dampening water and the hydrophilicity of the surface in the non-image area decreases. On the other hand, in the case of processing with the aqueous solution having a buffer function (for example, an aqueous alkali solution having a buffer function), similar to the case of processing with an aqueous solution having no buffer function, since the alkali attaches on the surface of intermediate layer in the non-image area (particularly on the portion where the hydrophilicity is high, such as the repeating unit (d1)), the hydrophilicity of the surface becomes high. However, even when dampening water is supplied at the printing, due to the buffering function the decrease in the alkali concentration in the non-image area is prevented to maintain the state of the high hydrophilicity. Thus, it is believed that the stain resistance and stain resistance after preservation are improved in comparison with the case of processing with an aqueous solution having no buffer function.

Further, the factors of improving the chemical resistance are believed to be as follows. Specifically, since the repeating unit (d1) has low affinity to a specific dampening water, it is believed that the specific dampening water hardly penetrates into the interface between the intermediate layer and the image-forming layer thereby improving the chemical resistance.

[Intermediate layer]

The intermediate layer of the lithographic printing plate precursor according to the invention contains a copolymer (hereinafter, also referred to as a "specific copolymer") containing a repeating unit (d1) derived from a monomer having a C log P value of -0.14 or less and containing a carbon-carbon unsaturated double bond through a covalent bond.

The monomer for forming the repeating unit (d1) in the specific copolymer has a feature that the C log P value thereof is 1.4 or less.

The C log P value is a value calculated by a program "CLOGP" available from Daylight Chemical Information System, Inc. The program provides a value of "calculated log P" calculated by fragment approach of Hansch, Leo. The fragment approach is based on the chemical structure of a compound, and the chemical structure is divided into partial structures (fragments) and each share of log P assigned to the fragment are totalized to estimate the log P value of the compound. The details thereof are described in literatures shown below. In the invention, a C log P value calculated using the program CLOGP v4.82 was used.

A.J. Leo, Comprehensive Medicinal Chemistry, Vol. 4, C. Hansch, P.G. Sammens, J.B. Taylor and C.A. Ramsden, Eds., p.295, Pergamon Press, (1990).

C. Hansch and A.J. Leo, Substituent Constants for Correlation Analysis in Chemistry and Biology, John Wiley & Sons.

A.J. Leo, Calculating logPoct from Structure, Chem. Rev., 93, 1281-1306, (1993).

The log P means a common logarithm of partition coefficient P, and is a physical property value indicating, as a quantitative value, how a certain organic compound is distributed at equilibrium in a two-phase system of oil (ordinarily, 1-octanol) and water and is represented by the following equation:

$$\log P = \log(Coil/Cwater)$$

wherein Coil represents a mol concentration of the compound in the oil phase and Cwater represents a mol concentration of the compound in the aqueous phase.

As the value of log P increases in a positive direction from 0, solubility in oil increases. As an absolute value of the log P increases in a negative direction from 0, solubility in water increases. There is a negative correlation between the value of log P and a water-solubility of an organic compound, and the value is widely utilized as a parameter for estimating the hydrophilic-hydrophobic property of the organic compound.

According to the invention, it is essential that the C log P value of the monomer for forming the repeating unit (d1) of the specific copolymer is -0.14 or less. When the Clog P value of the monomer is larger than -0.14 the stain resistance (particularly, stain resistance after preservation) of the non-image area deteriorates and it is impossible to achieve the good balance between the stain resistance and the printing durability and chemical resistance.

The lower limit of the C log P value of the monomer for forming the repeating unit (d1) is -10. When the C log P value of the monomer is less than -10, the printing durability and chemical resistance deteriorate although the satin

resistance of the non-image area is good. Though the reason for this is not quite clear, it is presumed that when the C log P value of the monomer for forming the repeating unit (d1) decreases less than -10 (specifically, the hydrophilicity increases), a large difference in the hydrophilic-hydrophobic property arises among the carbon-carbon unsaturated double bond and the polymerizable compound in the image-forming layer to decrease the compatibility and thus, the polymerization reactivity between the intermediate layer and the image-forming layer (hereinafter, referred to as an interlayer) in the exposed area deteriorates or even when the interlayer polymerization proceeds, due to the excessively high hydrophilicity, the effect of improving the interlayer adhesion property in the image area is damaged.

The repeating unit derived from a monomer containing a carbon-carbon unsaturated double bond through a covalent bond at its side chain in the specific copolymer is described using a schematic view represented by formula (A) shown below. In formula (A), $C_1=C_2$ represents a carbon-carbon unsaturated double bond, $S_1$ represents an atomic group for forming a main chain of the copolymer, and $T_1$ represents an (N + 1) valent connecting group. $R_5a$ to $R_7a$ have the same meanings as $R_5a$ to $R_7a$ in formula (I) shown below, respectively. The term "containing a carbon-carbon unsaturated double bond through a covalent bond" as used herein means that the connecting chain(s) included in the connecting group $T_1$ connecting $S_1$ and $C_1$ are all composed of the covalent bond(s).

Formula (A):

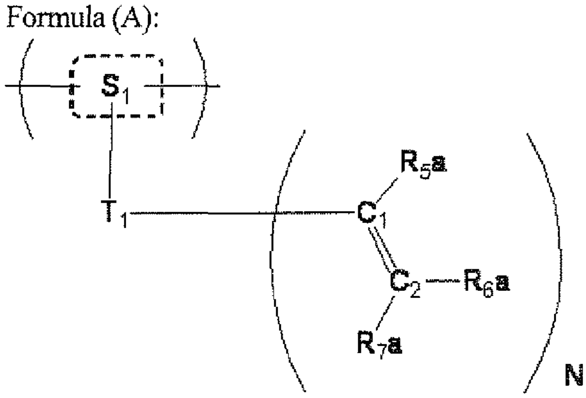

(A)

It is desired that the repeating unit (d1) contains a structure of high hydrophilicity in order to obtain the desired hydrophilic-hydrophobic property. The term "contain" as used herein means that the structure of high hydrophilicity is connected to an atom constituting a main chain of the repeating unit (d1) through a covalent bond. Specifically, the structure of high hydrophilicity may be present in any appropriate position of the repeating unit (d1). For instance, it may be present as a monovalent substituent, on an atom constituting the main chain, on an atom constituting the linking group or on an atom constituting the carbon-carbon unsaturated double bond or may be present in the connecting chain.

The structure of high hydrophilicity may be any structures which can adjust the C log P of the monomer for forming the repeating unit (d1)to -0.14 or less. The structure of high hydrophilicity is particularly preferably a structure having a charge. The structures having a charge are preferred because they ordinarily exhibit a low C log P value, such as from -1.3 to -6.1. Specific examples of the structures having a charge include an anion structure, for example, an anion formed by eliminating a proton from a protonic acid, e.g., a sulfonic acid, a sulfuric acid, a phosphoric acid, a phosphonic acid, a carboxylic acid or an alcohol or a polyvalent anion, e.g., a borate or a silicate, and a cation structure, for example, an onium cation, e.g., a phosphonium or an ammonium. In the case where the repeating unit has the anion structure, as a counter ion thereof, a metal ion and the cation structure described above are exemplified. In the case where the repeating unit has the cation structure, as a counter ion thereof, a halide ion (e.g., $F^-$, $Cl^-$, $BF^-$ or $I^-$) and the anion structure described above are exemplified. Further, the repeating unit (d1) may have both the anion structure and the cation structure. In such a case, there may be a state where the anion structure and the cation structure act each other as the counter ions to form an intramolecular salt or a state where the anion structure and the cation structure have separate counter ions, respectively.

Of the structures of high hydrophilicity, specific examples of those having no charge include a monovalent group, for example, a hydroxy group or a cyano group, and a divalent connecting group, for example, a (poly)ethyleneoxy group, an amido group, a urea group, an imido group or a bissulfonylimido group.

The structure of high hydrophilicity is preferably a carboxylate anion, a sulfonate anion, a sulfate anion, a phosphate anion, a phosphonate anion, an ammonium cation, a phosphonium cation or a hydroxy group, more preferably, a sulfonate anion, a phosphate anion, an ammonium cation or a phosphonium cation, and particularly preferably a sulfonate anion or an ammonium cation.

It is also preferred that the repeating unit (d1) has both of a sulfonate anion, a phosphate anion or a carboxylate anion and an ammonium cation or a phosphonium cation.

As the repeating unit (d1) for constituting the specific copolymer, a repeating unit (d1') derived from a monomer

having a C log P value of -0.14 or less and containing a carbon-carbon unsaturated double bond through a covalent bond at its side chain is preferred, a repeating unit (d1") derived from a monomer having a C log P value of -1.0 or less and containing a carbon-carbon unsaturated double bond through a covalent bond at its side chain is more preferred, and a repeating unit (d1"') derived from a monomer having a C log P value or -1.5 or less and containing a carbon-carbon unsaturated double bond through a covalent bond at its side chain is particularly preferred.

As the repeating unit (d1) for constituting the specific copolymer, a repeating unit represented by any of formulae (I) to (VI) shown below is preferred.

Formula (I):

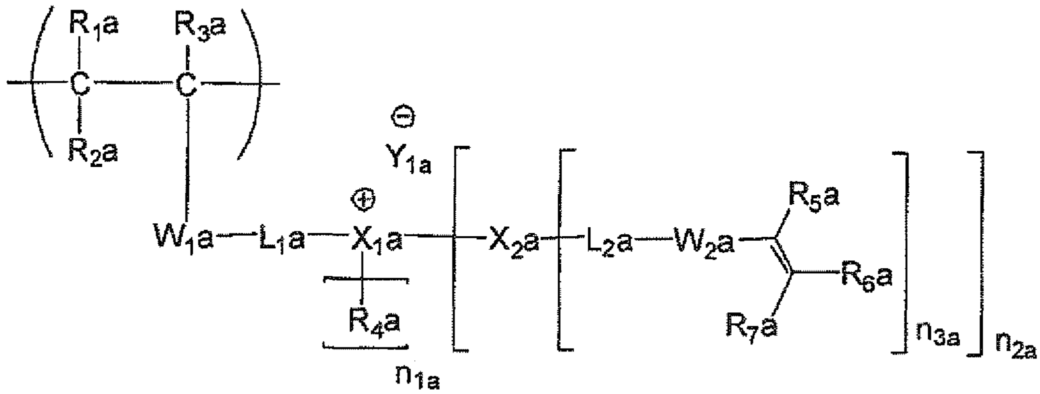

Formula (II):

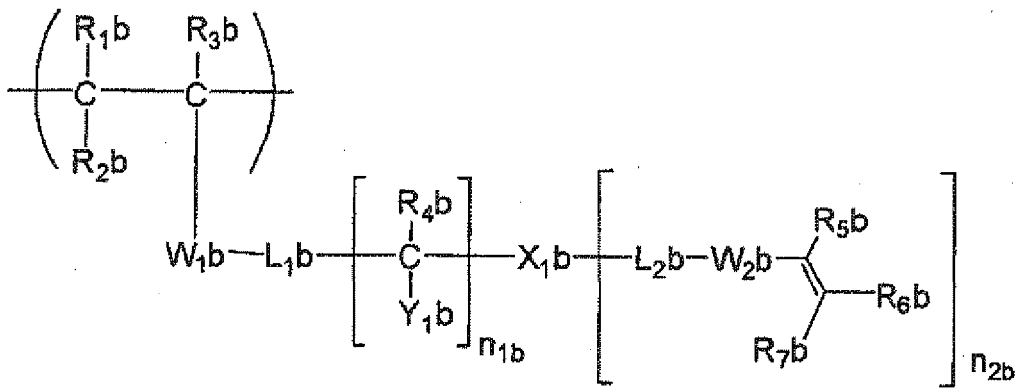

Formula (III):

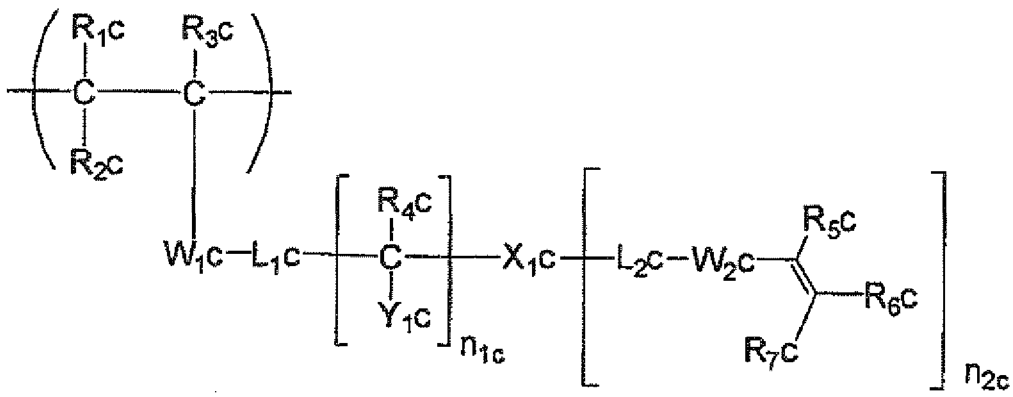

Formula (IV):

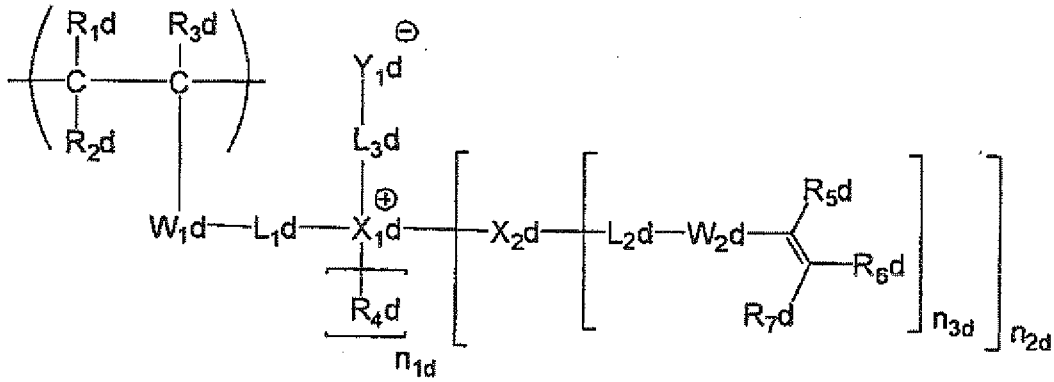

Formula (V):

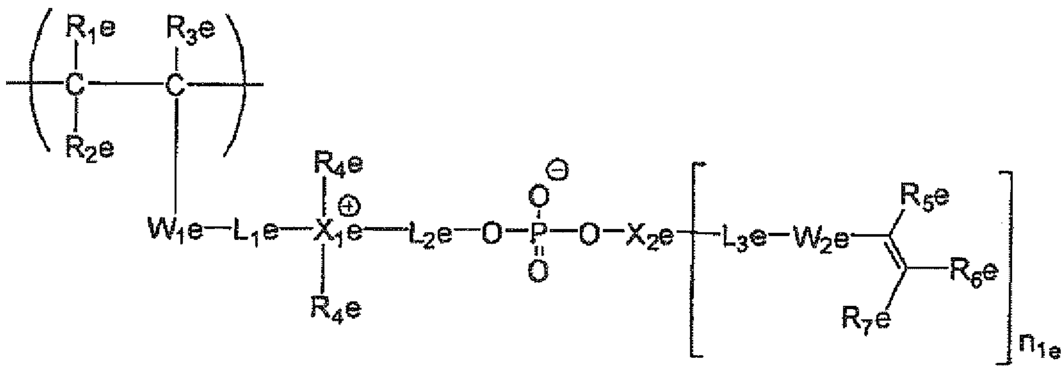

Formula (VI):

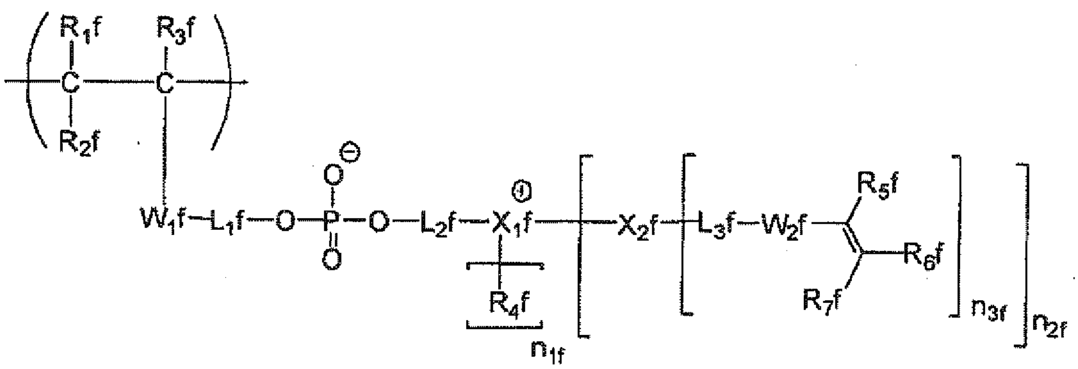

The definition of each symbol in formula (I) is described below.

$R_1a$ to $R_3a$ each represents a hydrogen atom, an alkyl group, a halogen atom or a cyano group.

$R_4a$ each represents a hydrogen atom or a substituent having from 1 to 30 carbon atoms.

$R_5a$ to $R_7a$ each represents a hydrogen atom, an alkyl group, -CO-O-Rx or -CO-N(Ry)(Rz).

Rx represents an alkyl group.

Ry and Rz each represents a hydrogen atom, an alkyl group or an aryl group.

$L_1a$ and $L_2a$ each represents a single bond or a divalent connecting group.

$W_1a$ and $W_2a$ each represents an alkylene group, an arylene group, -O-, -S-, -CO-, -N(Rw)-, $-SO_2-$ or a divalent connecting group composed of an appropriate combination of these groups. Rw represents a hydrogen atom, an alkyl group or an aryl group.

$X_1a$ represents N or P.

$X_2a$ represents an ($n_3a$ + 1) valent connecting group, provided that when $n_3a$ is 1, $X_2a$ represents a single bond.
$Y_1a$ represents an organic or inorganic anion.
$n_1a$ represents an integer from 0 to 2.
$n_2a$ represents an integer from 1 to 3, provided that $n_1a + n_2a = 3$.
$n_3a$ represents an integer from 1 to 4.

The definition of each symbol in formula (II) is described below.

$R_1b$ to $R_3b$, $R_4b$, $R_5b$ to $R_7b$, $L_1b$, $L_2b$, $W_1b$ and $W_2b$ have the same meanings as $R_1a$ to $R_3a$, $R_4a$, $R_5a$ to $R_7a$, $L_1a$, $L_2a$, $W_1a$ and $W_2a$ in formula (I), respectively.

$X_1b$ represents an ($n_2b$ + 1) valent connecting group, provided that when $n_2b$ is 1, $X_1b$ represents a single bond.

$Y_1b$ each represents a hydrogen atom, a hydroxy group or an alkyl group, provided that at least one of $Y_1b$ represents a hydroxy group.

$n_1b$ represents an integer from 1 to 10.

$n_2b$ represents an integer from 1 to 4.

The definition of each symbol in formula (III) is described below.

$R_1c$ to $R_3c$, $R_4c$, $R_5c$ to $R_7c$, $L_1c$, $L_2c$, $W_1c$ and $W_2c$ have the same meanings as $R_1a$ to $R_3a$, $R_4a$, $R_5a$ to $R_7a$, $L_1a$, $L_2a$, $W_1a$ and $W_2a$ in formula (I), respectively.

$n_1c$ and $n_2c$ have the same meanings as $n_1b$ and $n_2b$ in formula (II), respectively.

$X_1c$ represents an ($n_2c$ + 1) valent connecting group, provided that when $n_2c$ is 1, $X_1c$ represents a single bond.

$Y_1c$ each represents a hydrogen atom, a hydroxy group, an alkyl group or a group represented by $L_3c$-Q, provided that at least one of $Y_1c$ represents a group represented by $L_3c$-Q.

$L_3c$ represents a single bond or a divalent connecting group.

Q represents $-CO_2M$, $-SO_3M$, $-OSO_3M$, $-OPO(OM_1)(OM_2)$ or $-PO(OM_3)(OM_4)$.

M, $M_1$ and $M_3$ each represents a monovalent metal ion or $N^+(R_0)_4$.

$M_2$ and $M_4$ each represents a hydrogen atom, a monovalent metal ion or $N^+(R_0)_4$.

$R_0$ represents a hydrogen atom or an alkyl group.

The definition of each symbol in formula (IV) is described below.

$R_1d$ to $R_3d$, $R_4d$, $R_5d$ to $R_7d$, $L_1d$, $L_2d$, $W_1d$, $W_2d$, $n_3d$ and $X_1d$ have the same meanings as $R_1a$ to $R_3a$, $R_4a$, $R_5a$ to $R_7a$, $L_1a$, $L_2a$, $W_1a$, $W_2a$, $n_3a$ and $X_1a$ in formula (I), respectively.

$L_3d$ represents a divalent connecting group.

$X_2d$ represents an ($n_3d$ + 1) valent connecting group, provided that when $n_3d$ is 1, $X_2d$ represents a single bond.

$Y_1d$ represents $-CO_2^-$, $-SO_3^-$ or -OPO(O-)(ORp).

Rp represents an alkyl group.

$n_1d$ represents 0 or 1.

$n_2d$ represents 1 or 2, provided that $n_1d + n_2d = 2$.

The definition of each symbol in formula (V) is described below.

$R_1e$ to $R_3e$, $R_4e$, $R_5e$ to $R_7e$, $W_1e$, $W_2e$ and $X_1e$ have the same meanings as $R_1a$ to $R_3a$, $R_4a$, $R_5a$ to $R_7a$, $W_1a$, $W_2a$ and $X_1a$ in formula (I), respectively.

$L_1e$ and $L_2e$ have the same meanings as $L_1a$ in formula (I), respectively.

$L_3e$ has the same meaning as $L_2a$ in formula (I).

$n_1e$ has the same meaning as $n_2b$ in formula (II)

$X_2e$ represents an ($n_1e$ + 1) valent connecting group, provided that when $n_1e$ is 1, $X_2e$ represents a single bond.

The definition of each symbol in formula (VI) is described below.

$R_1f$ to $R_3f$, $R_4f$, $R_5f$ to $R_7f$, $W_1f$, $W_2f$, $X_1f$, $X_2f$ and $n_1f$ to $n_3f$ have the same meanings as $R_1a$ to $R_3a$, $R_4a$, $R_5a$ to $R_7a$, $W_1a$, $W_2a$, $X_1a$, $X_2a$ and $n_1a$ to $n_3a$ in formula (I), respectively.

$L_1f$ and $L_2f$ have the same meanings as $L_1a$ in formula (I), respectively.

$L_3f$ has the same meaning as $L_2a$ in formula (I).

Formulae (I) to (VI) will be described in detail below.

In formula (I), the alkyl group for any one of $R_1a$ to $R_3a$ represents a straight-chain, branched or cyclic, substituted or unsubstituted alkyl group. A total number of carbon atoms of the alkyl group is preferably from 1 to 10. The alkyl group may have a substituent and examples of the substituent include a halogen atom, a hydroxy group, an alkoxy group, an alkoxycarbonyloxy group and an aryl group.

For any one of $R_1a$ and $R_2a$, a hydrogen atom or a methyl group is preferred, and a hydrogen atom is more preferred. For $R_3a$, a hydrogen atom, a methyl group, an ethyl group, a hydroxymethyl group, a methoxymethyl group or a methylcarbonyloxy group is preferred, and a hydrogen atom, a methyl group or a hydroxymethyl group is more preferred.

The substituent having from 1 to 30 carbon atoms for $R_4a$ includes a straight-chain, branched or cyclic, substituted or unsubstituted alkyl group and a substituted or unsubstituted aryl group (preferably having from 6 to 30 carbon

atoms). Among them, an alkyl group having a total number of carbon atoms of 20 or less is preferred, an alkyl group having a total number of carbon atoms of 10 or less is more preferred, and an alkyl group having a total number of carbon atoms of 5 or less is particularly preferred. Examples of the alkyl group include a methyl group, an ethyl group, an n-propyl group, an isopropyl group, an n-butyl group and an isobutyl group. The alkyl group may have a substituent and examples of the substituent include an aryl group, a halogen atom, a hydroxy group and an alkoxy group. Further, when $R_1a$ represents an alkyl group, -O- or -S- may be introduced between the carbon-carbon bond thereof The aryl group may have a substituent and the examples of the substituent include a halogen atom, a hydroxy group and an alkoxy group.

When plural $R_4a$ are present, two $R_4a$ may be combined with each other to form a ring structure.

$R_4a$ is preferably a hydrogen atom, a methyl group, an ethyl group, an n-propyl group, an n-butyl group, a $-(CH_2CH_2O)_p$-Rt group (wherein p represents an integer from 1 to 4 and Rt represents a hydrogen atom or a methyl group) or an aralkyl group, more preferably a methyl group, an ethyl group, a $-(CH_2CH_2O)_p$-Rt group or a substituted or unsubstituted benzyl group, and particularly preferably a methyl group, an ethyl group, a hydroxyethyl group or a substituted or unsubstituted benzyl group.

The alkyl group for any one of $R_5a$ to $R_7a$ is same as the alkyl group for any one of $R_1a$ to $R_3a$. Preferable examples thereof are also same as those for any one of $R_1a$ to $R_3a$.

In the case where any one of $R_5a$ to $R_7a$ represents -CO-O-Rx or -CO-N(Ry)(Rz), the alkyl group for any one of Rx, Ry and Rz is same as the alkyl group for any one of $R_1a$ to $R_3a$. The aryl group for any one of Ry and Rz may have a substituent and is preferably an aryl group having from 6 to 30 carbon atoms. Examples of the aryl group include a phenyl group and a naphthyl group.

Preferable examples of Rx include a methyl group, an ethyl group, an n-propyl group, an n-butyl group and a hydroxyethyl group. Preferable examples of Ry or Rz include a hydrogen atom, a methyl group, an ethyl group, an n-propyl group, an n-butyl group and a hydroxyethyl group.

Preferable examples of $R_5a$ are same as those of $R_3a$, and preferable examples of $R_6a$ and $R_7a$ are same as those of $R_1a$ and $R_2a$.

The divalent connecting group for $L_1a$ or $L_2a$ specifically includes an alkylene group, a cycloalkylene group, an arylene group, -O-, -S-, -CO-, -N(Rw)-, $-SO_2^-$ and a divalent connecting group composed of an appropriate combination of these groups. $L_1a$ or $L_2a$ is preferably a single bond, an alkylene group having 10 or less carbon atoms, an arylene group, a cycloalkylene group having 10 or less carbon atoms, -O-, -CO-, -N(Rw)- or a divalent connecting group composed of an appropriate combination of these groups, and more preferably a single bond, an alkylene group having 6 or less carbon atoms, a 1,4-phenylene group, -O-, -CO-, -N(H)- or a divalent connecting group composed of an appropriate combination of these groups.

For $W_1a$ and $W_2a$, $W_1a$ is preferably an alkylene group having 5 or less carbon atoms, a phenylene group, -O-, -S-, -CO-, -N(Rw)- or a divalent connecting group composed of an appropriate combination of these groups, more preferably a 1,4-phenylene group, -O-, -CO-, -N(Rw)- or a divalent connecting group composed of an appropriate combination of these groups, still more preferably -CO-O-or -CO-N(Rw)-, and particularly preferably -CO-N(H)-.

$W_2a$ is preferably an alkylene group having 5 or less carbon atoms, a phenylene group, -O-, -S-, -CO-, -N(Rw)- or a divalent connecting group composed of an appropriate combination of these groups, more preferably an alkylene group having 3 or less carbon atoms, a 1,4-phenylene group, -O-, -CO-, -N(Rw)- or a divalent connecting group composed of an appropriate combination of these groups, still more preferably $-O-CH_2-$, $-N(Rw)-CH_2-$, $-O-CO-O-CH_2-$, $-O-CO-N(Rw)-CH_2-$, $-N(Rw)-CO-O-CH_2-$, $-N(Rw)-CO-N(Rw)-CH_2-$, -CO-O-, -CO-N(Rw)-, $-CO-O-CH_2-$, $-CO-N(Rw)-CH_2-$ or $-O-CO-CH_2-$, and particularly preferably -CO-O-, -CO-N(H)-, $-CO-O-CH_2-$ or $-CO-N(H)-CH_2-$.

The alkyl group and aryl group for Rw are same as the alkyl group and aryl group for Ry above respectively. Rw is preferably a hydrogen atom, a methyl group, an ethyl group, an n-propyl group, an n-butyl group or a hydroxyethyl group, and more preferably a hydrogen atom, a methyl group or an ethyl group.

$X_1a$ is preferably N.

The ($n_3a$ + 1) valent connecting group for $X_2a$ is a residue formed by eliminating ($n_3a$ + 1) hydrogen atoms from a hydrocarbon having a total number of carbon atoms of 30 or less. The hydrocarbon includes an aliphatic hydrocarbon, an aromatic hydrocarbon and a combination thereof. The aliphatic hydrocarbon may be any of straight-chain, branched, monocyclic and polycyclic. The aromatic hydrocarbon may be either monocyclic or polycyclic. Further, between an appropriate carbon-carbon bond of the hydrocarbon may be introduced -O-, -N(Rw)-, -S-, -CO-, $-SO_2-$ or a divalent connecting group composed of an appropriate combination of these groups. A total number of carbon atoms included in $X_2a$ is preferably 20 or less, and more preferably 10 or less. $X_2a$ is preferably a ($n_3a$ + 1) valent connecting group having a total number of carbon atoms of 20 or less, more preferably a ($n_3a$ + 1) valent connecting group having a total number of carbon atoms of 10 or less, and further more preferably a ($n_3a$ + 1) valent connecting group having a total number of carbon atoms of 5 or less. In this regard, $X_2a$ is a single bond in case $n_3a$ is 1.

The organic anion for $Y_1a$ includes, for example, an anion of an organic acid, for example, a carboxylic acid, a sulfonic acid, a phosphoric acid or a phosphonic acid and a borate. A total number of carbon atoms included in the

organic anion is preferably 20 or less, more preferably 15 or less, and still more preferably 10 or less. The inorganic anion for $Y_1a$ includes, for example, $PF_6^-$, $BF_4^-$, $AsF_6^-$, $SbF_6^-$, $Cl^-$, $Br^-$ or $I^-$. $Y_1a$ is preferably a sulfonate anion, $PF_6^-$, $BF4^-$, $Cl^-$, $Br^-$ or $I^-$, more preferably an alkylsulfonate anion which may have a substituent, an aromatic sulfonate anion which may have a substituent, $PF_6^-$, $BF4^-$, $Cl^-$, $Br^-$ or $I^-$, and still more preferably a fluorinated alkylsulfonate anion, a benzenesulfonate anion which may have a substituent, $Cl^-$ or $Br^-$. Examples of the substituent include a halogen atom, a hydroxy group, an alkyl group having 4 or less carbon atoms, a cyano group, a nitro group and a carboxyl group.

$n_1a$ and $n_2a$ are preferably (1, 2) or (2, 1), and more preferably (2, 1), indicated in terms of ($n_1a$, $n_2a$).

$n_3a$ is preferably 1 to 2, and more preferably 1.

With respect to the repeating unit represented by formula (I), preferable combinations of each partial stricture are set forth below.

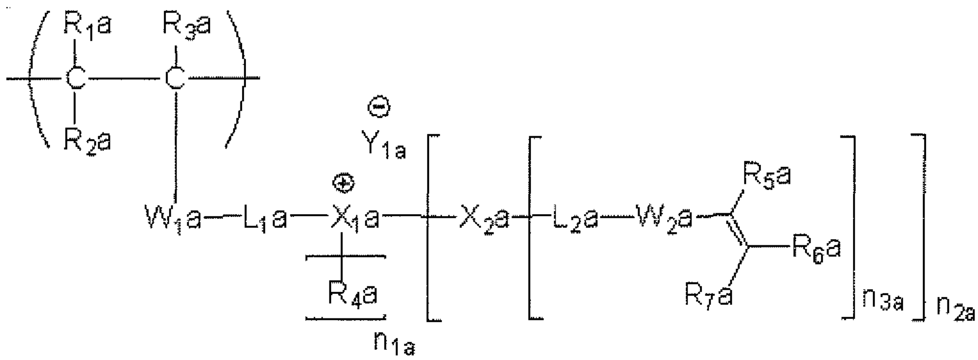

| | Preferable Combination | More Preferable Combination | Particularly Preferable Combination |
|---|---|---|---|
| $R_1a$, $R_2a$ | Hydrogen atom or Methyl group | Hydrogen atom | Hydrogen atom |
| $R_3a$ | Hydrogen atom, Methyl group, Ethyl group, Hydroxymethyl group, Methoxymethyl group or Methylcarbonyloxy group | Hydrogen atom, Methyl group or Hydroxymethyl group | Hydrogen atom or Methyl group |
| $R_4a$ | Hydrogen atom, Methyl group, Ethyl group, n-Propyl group, n-Butyl group,-$(CH_2CH_26)_p$-Rt group or Aralkyl group | Methyl group, Ethyl group, -$(CH_2CH_2O)_p$-Rt group or Substituted or unsubstituted benzyl group | Methyl group, Ethyl group, Hydroxyethyl group or Substituted or unsubstituted benzyl group |
| $R_5a$ | Hydrogen atom, Methyl group, Ethyl group, Hydroxyethyl group, Methoxymethyl group or Methylcarbonyloxy group | Hydrogen atom, Methyl group or Hydroxymethyl group | Hydrogen atom or Methyl group |
| $R_6a$, $R_7a$ | Hydrogen atom or Methyl group | Hydrogen atom | Hydrogen atom |
| $W_1a$ | 1,4-Phenylene group, -O-, -CO-, -N(Rw)- or Divalent connecting group composed of appropriate combination of these groups | -CO-O- or -CO-N(Rw)- | CO-N(H)- |
| $W_2a$ | Alkylene group having 3 or less carbon atoms, 1,4-Phenylene group, -O-, -CO-, -N(Rw)- or Divalent connecting group composed of appropriate combination of these groups | -O-$CH_2$-, -N(Rw)-$CH_2$-, -O-CO-O-$CH_2$-, -O-CO-N(Rw)-$CH_2$-, -N(Rw)-CO-O-$CH_2$-, -N(Rw)-CO-N(Rw)-$CH_2$-, -CO-O-, -CO-N(Rw)-, -CO-O-$CH_2$-, -CO-N(Rw)-$CH_2$- or -O-CO-$CH_2$- | -CO-O-, -CO-N(H)-, -CO-O-$CH_2$- or -CO-N(H)-$CH_2$- |

(continued)

| | Preferable Combination | More Preferable Combination | Particularly Preferable Combination |
|---|---|---|---|
| $L_1a$, $L_2a$ | Single bond, Alkylene group having 10 or less carbon atoms, Arylene group, Cycloalkylene group having 10 or less carbon atoms, -O-, -CO-, -N(Rw)- or Divalent connecting group composed of appropriate combination of these groups | Single bond, Alkylene group having 6 or less carbon atoms, 1,4-Phenylene group, -O-, -CO-, -N(H)- or Divalent connecting group composed of appropriate combination of these groups | Single bond, Alkylene group having 6 or less carbon atoms, 1,4-Phenylene group, -O-, -CO-, -N(H)- or Divalent connecting group composed of appropriate combination of these groups |
| $X_1a$ | N or P | N | N |
| $X_2a$ | ($n_3a$+ 1) Valent connecting group having total number of carbon atoms of 10 or less, provided that when $n_3a$ is 1, $X_2a$ represents single bond | Single bond | Single bond |
| $Y_1a$ | Sulfonate anion, $PF_6^-$, $BF_4^-$, $Cl^-$, $Br^-$ or $I^-$ | Alkylsulfonate anion which may have substituent, Aromatic sulfonate anion which may have substituent, $PF_6^-$, $BF_4^-$,$Cl^-$, $Br^-$ or $I^-$, | Fluorinated alkylsulfonate anion, Benzenesulfonate anion which may have substituent, $Cl^-$ or $Br^-$. |
| ($n_1a$, $n_2a$) | (1, 2) or (2, 1) | (2, 1) | (2, 1) |
| $n_3a$ | 1 to 2 | 1 | 1 |

In formula (II), the descriptions (including preferred embodiments) with respect to $R_1b$ to $R_3b$, $R_4b$, $R_5b$ to $R_7b$, $L_1b$, $L_2b$, $W_1b$ and $W_2b$ are same as the descriptions (including preferred embodiments) with respect to $R_1a$ to $R_3a$, $R_4a$, $R_5a$ to $R_7a$, $L_1a$, $L_2a$, $W_1a$ and $W_2a$ in formula (I), respectively.

The descriptions (including preferred embodiments) with respect to the ($n_2b$ +1) valent connecting group for $X_1b$ are same as the descriptions (including preferred embodiments) with respect to the ($n_3a$ + 1) valent connecting group for $X_2a$ in formula (I) except for changing the ($n_3a$ + 1) valent to the ($n_2b$ + 1) valent.

The descriptions (including preferred embodiments) with respect to the alkyl group for $Y_1b$ are same as the descriptions (including preferred embodiments) with respect to the alkyl group for $R_4a$ in formula (I). A number of the hydroxy groups for $Y_1b$ in formula (II) is preferably from 1 to 3, and more preferably from 1 to 2. However, when $n_1b$ is 1, the number of the hydroxy groups for $Y_1b$ in formula (II) is 1, and when $n_1b$ is 2, the number of the hydroxy groups for $Y_1b$ in formula (II) is 1 or 2.

$n_1b$ is preferably from 1 to 5, more preferably from 1 to 3, and still more preferably from 1 to 2

$n_2b$ is preferably from 1 to 2, and more preferably 1.

With respect to the repeating unit represented by formula (II), preferable combinations of each partial stricture are set forth below.

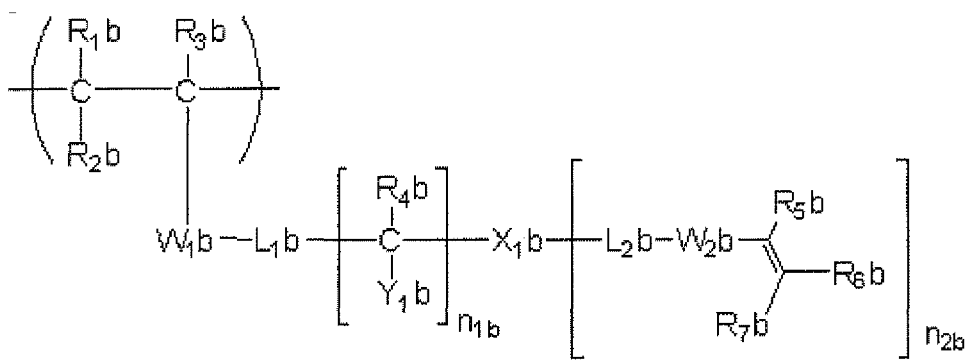

| | Preferable Combination | More Preferable Combination | Particularly Preferable Combination |
|---|---|---|---|
| $R_1b$, $R_2b$ | Hydrogen atom or Methyl group | Hydrogen atom | Hydrogen atom |
| $R_3b$ | Hydrogen atom, Methyl group, Ethyl group, Hydroxymethyl group, Methoxymethyl group or Methylcarbonyloxy group | Hydrogen atom, Methyl group or Hydroxymethyl group | Hydrogen atom or Methyl group |
| $R_4b$ | Hydrogen atom, Methyl group, Ethyl group, n-Propyl group, n-Butyl group,$-(CH_2CH_2O)_p-$Rt group or Aralkyl group | Methyl group, Ethyl group, $-(CH_2CH_2O)_p-$Rt group or Substituted or unsubstituted benzyl group | Methyl group, Ethyl group, Hydroxyethyl group or Substituted or unsubstituted benzyl group |
| $R_5b$ | Hydrogen atom, Methyl group, Ethyl group, Hydroxymethyl group, Methoxymethyl group or Methylcarbonyloxy group | Hydrogen atom, Methyl group or Hydroxymethyl group | Hydrogen atom or Methyl group |
| $R_6b$, $R_7b$ | Hydrogen atom or Methyl group | Hydrogen atom | Hydrogen atom |
| $W_1b$ | 1,4-Phenylene group, -O-, -CO-, -N(Rw)- or Divalent connecting group composed of appropriate combination of these groups | -CO-O- or -CO-N(Rw)- | -CO-O-, -CO-N(H)- |
| $W_2b$ | Alkylene group having 3 or less carbon atoms, 1,4-Phenylene group, -O-, -CO-, -N(Rw)- or Divalent connecting group composed of appropriate combination of these groups | $-O-CH_2$, $-N(Rw)-CH_2-$, $-O-CO-O-CH_2-$, $-O-CO-N(Rw)-CH_2-$, $-N(Rw)-CO-O-CH_2-$, $-N(Rw)-CO-N(Rw)-CH_2-$, -CO-O-, -CO-N(Rw)-, $-CO-O-CH_2-$, $-CO-N(Rw)-CH_2-$ or $-O-CO-CH_2-$ | -CO-O-, -CO-N(H)-, $-CO-O-CH_2-$ or $-CO-N(H)-CH_2-$ |
| $L_1b$, $L_2b$ | Single bond, Alkylene group having 10 or less carbon atoms, Arylene group, Cycloalkylene group having 10 or less carbon atoms, -O-, -CO-, -N(Rw)- or Divalent connecting group composed of appropriate combination of these groups | Single bond, Alkylene group having 6 or less carbon atoms, 1,4-Phenylene group, -O-, -CO-, -N(Rw)- or Divalent connecting group composed of appropriate combination of these groups | Single bond, Alkylene group having 6 or less carbon atoms, 1,4-Phenylene group, -O-, -CO-, -N(Rw)- or Divalent connecting group composed of appropriate combination of these groups |
| $X_1b$ | ($n_2b$ + 1) Valent connecting group having total number of carbon atoms of 10 or less, provided that when $n_2b$ is 1, $X_1b$ represents single bond | Single bond | Single bond |
| $Y_1b$ (other than hydroxy group) | Hydrogen atom, Methyl group, Ethyl group, n-Propyl group, n-Butyl group,$-(CH_2Ch_2O)_p-$Rt group or Aralkyl group | Methyl group, Ethyl group, $-(CH_2CH_2O)_p-$Rt group or Substituted or unsubstituted benzyl group | Methyl group, Ethyl group, Hydroxyethyl group or Substituted or unsubstituted benzyl group |

(continued)

| | Preferable Combination | More Preferable Combination | Particularly Preferable Combination |
|---|---|---|---|
| Number of hydroxy group for $Y_1b$ in formula (II) | 1 to 3 (provided that when $n_1b$ is 1, the number of hydroxy group is 1, and when $n_1b$ is 2, the number of hydroxy group is 1 or 2) | 1 to 2 (provided that when $n_1b$ is 1, the number of hydroxy group is 1, and when $n_1b$ is 2, the number ofhydroxy group is 1 or 2) | 1 to 2 (provided that when $n_1b$ is 1, the number of hydroxy group is 1, and when $n_1b$ is 2, the number of hydroxy group is 1 or 2) |
| $n_1b$ | 1 to 5 | 1 to 3 | 1 to 2 |
| $N_2b$ | 1 to 2 | 1 | 1 |

In formula (III), the descriptions (including preferred embodiments) with respect to $R_1c$ to $R_3c$, $R_4c$, $R_5c$ to $R_7c$, $L_1c$, $L_2c$, $W_1c$ and $W_2c$ are same as the descriptions (including preferred embodiments) with respect to $R_1a$ to $R_3a$, $R_4a$, $R_5a$ to $R_7a$, $L_1a$, $L_2a$, $W_1a$ and $W_2a$ in formula (I), respectively. The descriptions (including preferred embodiments) with respect to $n_1c$ and $n_2c$ are same as the descriptions (including preferred embodiments) with respect to $n_1b$ and $n_2b$ in formula (II), respectively.

The descriptions (including preferred embodiments) with respect to the ($n_2c$ + 1) valent connecting group for $X_1c$ are same as the descriptions (including preferred embodiments) with respect to the ($n_2b$ + 1) valent connecting group for $X_1b$ in formula (II) except for changing the ($n_2b$ + 1) valent to the ($n_2c$ + 1) valent.

The descriptions (including preferred embodiments) with respect to the alkyl group for $Y_1c$ are same as the descriptions (including preferred embodiments) with respect to the alkyl group for $R_4a$ in formula (I). A number of the group represented by $L_3c$-Q in formula (III) is preferably from 1 to 2, and more preferably 1.

The descriptions (including preferred embodiments) with respect to the divalent connecting group for $L_3c$ are same as the descriptions (including preferred embodiments) with respect to the divalent connecting group for $L_2a$ in formula (I).

Q is preferably, $-SO_3M$, $-OPO(OM_1)(OM_2)$ or $-PO(OM_3)(OM_4)$, and more preferably $-SO_3M$.

The monovalent metal ion for M includes elements in 1A group of the Periodic Table, preferably Li, Na or K, and more preferably, Na or K. $R_0$ each represents a hydrogen atom or an alkyl group. The descriptions (including preferred embodiments) with respect to the alkyl group are same as the descriptions (including preferred embodiments) with respect to the alkyl group for $R_4a$ in formula (I). $R_0$ is preferably a hydrogen atom, a methyl group, an ethyl group or a hydroxyethyl group.

M is preferably Na, K, $N^+H_4$, $N^+(CH_3)_4$, $N^+(H)(CH_3)_3$, $N^+(C_2H_5)_4$, $N^+(H)(C_2H_5)_3$, $N^+(H)_2(C_2H_5)_2$, $N^+(CH_2CH_2OH)_4$, $N^+(H)(CH_2CH_2OH)_3$, $N^+(H)_2(CH_2CH_2OH)_2$ or $N^+(H)_3(CH_2CH_2OH)$, more preferably Na, K, $N^+H_4$, $N^+(CH_3)_4$, $N^+(H)(CH_3)_3$, $N^+(C_2H_5)_4$, $N^+(H)(C_2H_5)_3$, $N^+(CH_2CH_2OH)_4$, $N^+(H)(CH_2CH_2OH)_3$, $N^+(H)_2(CH_2CH_2OH)_2$ or $N^+(H)_3(CH_2CH_2OH)$, and particularly preferably Na, K, $N^+H_4$, $N^+(CH_3)_4$, $N^+(C_2H_5)_4$, $N^+(H)(C_2H_5)_3$, $N^+(H)(CH_2CH_2OH)_3$ or $N^+(H)_2(CH_2CH_2OH)_2$.

The descriptions (including preferred embodiments) with respect to the monovalent metal ion for $M_1$ or $M_3$ and $N^+(R_0)_4$ are same as the descriptions (including preferred embodiments) with respect to the monovalent metal ion for M and $N^+(R_0)_4$, respectively.

The descriptions (including preferred embodiments) with respect to the monovalent metal ion for $M_2$ or $M_4$ and $N^+(R_0)_4$ are same as the descriptions (including preferred embodiments) with respect to the monovalent metal ion for M and $N^+(R_0)_4$, respectively.

With respect to the repeating unit represented by formula (III), preferable combinations of each partial stricture are set forth below.

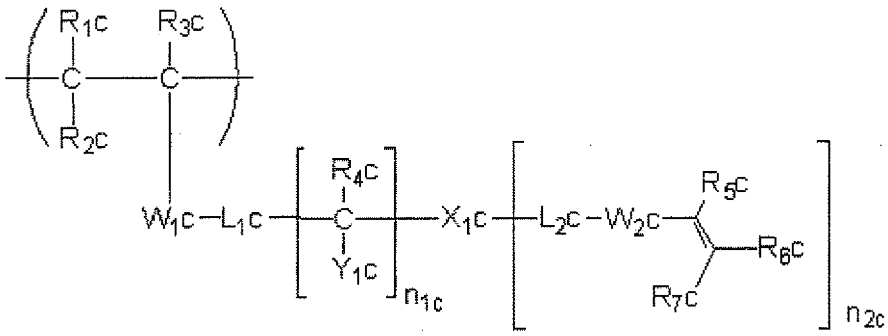

| | Preferable Combination | More Preferable Combination | Particularly Preferable Combination |
|---|---|---|---|
| $R_1c$, $R_2c$ | Hydrogen atom or Methyl group | Hydrogen atom | Hydrogen atom |
| $R_3c$ | Hydrogen atom, Methyl group, Ethyl group, Hydroxymethyl group, Methoxymethyl group or Methylcarbonyloxy group | Hydrogen atom, Methyl group or Hydroxymethyl group | Hydrogen atom or Methyl group |
| $R_4c$ | Hydrogen atom, Methyl group, Ethyl group, n-Propyl group, n-Butyl group,-$(CH_2CH_2O)_p$-Rt group or Aralkyl group | Methyl group, Ethyl group, -$(CH_2CH_2O)_p$-Rt group or Substituted or unsubstituted benzyl group | Methyl group, Ethyl group, Hydroxyethyl group or Substituted or unsubstituted benzyl group |
| $R_5c$ | Hydrogen atom, Methyl group, Ethyl group, Hydroxymethyl group, Methoxymethyl group or Methylcarbonyloxy group | Hydrogen atom, Methyl group or Hydroxymethyl group | Hydrogen atom or Methyl group |
| $R_6c$, $R_7c$ | Hydrogen atom or Methyl group | Hydrogen atom | Hydrogen atom |
| $W_1c$ | 1,4-Phenylene group, -O-, -CO-, -N(Rw)- or Divalent connecting group composed of appropriate combination of these groups | -CO-O- or -CO-N(Rw)- | -CO-O- or -CO-N(H)- |
| $W_2c$ | Alkylene group having 3 or less carbon atoms, 1,4-Phenylene group, -O-, -CO-, -N(Rw)- or Divalent connecting group composed of appropriate combination of these groups | -O-$CH_2$-, -N(Rw)-$CH_2$-, -O-CO-O-$CH_2$-, -O-CO-N(Rw)-$CH_2$-, -N(Rw)-CO-O-$CH_2$-, -N(Rw)-CO-N(Rw)-$CH_2$-, -CO-O-, -CO-N(Rw)-, -CO-O-$CH_2$-, -CO-N(Rw)-$CH_2$- or -O-CO-$CH_2$- | -CO-O-, -O-N(H)-, -CO-O-$CH_2$- or -CO-N(H)-$CH_2$- |
| $L_1c$, $L_2c$ | Single bond, Alkylene group having 10 or less carbon atoms, Arylene group, Cycloalkylene group having 10 or less carbon atoms, -O-, -CO-, -N(Rw)- or Divalent connecting group composed of appropriate combination of these groups | Single bond, Alkylene group having 6 or less carbon atoms, 1,4-Phenylene group, -O-, -CO-, -N(H)- or Divalent connecting group composed of appropriate combination of these groups | Single bond, Alkylene group having 6 or less carbon atoms, 1,4-Phenylene group, -O-, -CO-, -N(H)- or Divalent connecting group composed of appropriate combination of these groups |
| $X_1c$ | ($n_2c$ + 1) Valent connecting group having total number of carbon atoms of 10 or less, provided that when $n_2c$ is 1, $X_1c$ represents single bond | Single bond | Single bond |

(continued)

| | Preferable Combination | More Preferable Combination | Particularly Preferable Combination |
|---|---|---|---|
| $Y_1c$ (other than $L_3c$-Q) group | Hydrogen atom, Methyl group, Ethyl group, n-Propyl group, n-Butyl group,$-(CH_2CH_2O)_p$-Rt group or Aralkyl group | Methyl group, Ethyl group, $-(CH_2CH_2O)_p$-Rt group or Substituted or unsubstituted benzyl group | Methyl group, Ethyl group, Hydroxyethyl group or Substituted or unsubstituted benzyl group |
| $L_3c$-Q group in $Y_1c$ | $L_3$: Alkylene group having 10 or less carbon atoms, Arylene group, Cycloalkylene group having 10 or less carbon atoms, -O-, -CO-, -N(Rw)- or Divalent connecting group composed of appropriate combination of these groups Q: $-SO_3M$, $-OPO(OM_1)(OM_2)$ or $-PO(OM_3)(OM_4)$ | $L_3$: Alkylene group having 6 or less carbon atoms, 1,4-Phenylene group, -O-, -CO-, -N(H)- or Divalent connecting group composed of appropriate combination of these groups Q: $-SO_3M$ | $L_3$: Alkylene group having 6 or less carbon atoms, 1,4-Phenylene group, -O-, -CO-, -N(H)- or Divalent connecting group composed of appropriate combination of these groups Q: $-SO_3M$ |
| M | Na, K, $N^+H_4$, $N^+(CH_3)_4$, $N^+(H)(CH_3)_3$, $N^+(C_2H_5)_4$, $N^+(H)(C_2H_5)_3$, $N^+(H)_2(C_2H_5)_2$, $N^+(CH_2CH_2OH)_4$, $N^+(H)(CH_2CH_2OH)_3$, $N^+(H)_2(CH_2CH_2OH)_2$ or $N^+(H)_3(CH_2CH_2OH)$ | Na, K, $N^+H_4$, $N^+(CH_3)_4$, $N^+(H)(CH_3)_3$, $N^+(C_2H_5)_4$, $N^+(H)(C_2H_5)_3$, $N^+(CH_2CH_2OH)_4$, $N^+(H)(CH_2CH_2OH)_3$, $N^+(H)_2(CH_2CH_2OH)_2$ or $N^+(H)_3(CH_2CH_2OH)$ | Na, K, $N^+H_4$, $N^+(CH_3)_4$, $N^+(C_2H_5)_4$, $N^+(H)(C_2H_5)_3$, $N^+(H)(CH_2CH_2OH)_3$ or $N^+(H)_2(CH_2CH_2OH)_2$ |
| $M_1$, $M_3$ | ditto | ditto | ditto |
| $M_2$, $M_4$ | ditto | ditto | ditto |
| Number of $L_3c$-Q group in formula (III) | 1 to 2 (provided that when $n_1c$ is 1, the number of $L_3c$-Q group is 1) | 1 | 1 |
| $n_1c$ | 1 to 5 | 1 to 3 | 1 to 2 |
| $n_2c$ | 1 to 2 | 1 | 1 |

In formula (IV), the descriptions (including preferred embodiments) with respect $R_1d$ to $R_3d$, $R_4d$, $R_5d$ to $R_7d$, $L_1d$, $L_2d$, $W_1d$, $W_2d$, $n_3d$ and $X_1d$ are same as the descriptions (including preferred embodiments) with respect to $R_1a$ to $R_3a$, $R_4a$, $R_5a$ to $R_7a$, $L_1a$, $L_2a$, $W_1a$, $W_2a$, $n_3a$ and $X_1a$ in formula (I), respectively.

The descriptions (including preferred embodiments) with respect to the divalent connecting group for $L_3d$ are same as the descriptions (including preferred embodiments) with respect to the divalent connecting group for $L_3c$ in formula (III).

The descriptions (including preferred embodiments) with respect to the $(n_3d + 1)$ valent connecting group for $X_2d$ are same as the descriptions (including preferred embodiments) with respect to the $(n_2b + 1)$ valent connecting group for $X_1b$ in formula (II) except for changing the $(n_2b + 1)$ valent to the $(n_3d + 1)$ valent.

$Y_1d$ is preferably $-CO_2^-$, $-SO_3^-$ or $-OPO(O^-)(ORp)$, and more preferably $-CO_2^-$ or $-SO_3^-$.

The descriptions (including preferred embodiments) with respect to the alkyl group for Rp are same as the descriptions (including preferred embodiments) with respect to the alkyl group for $R_4a$ in formula (I). Rp is preferably a methyl group, an ethyl group, an n-propyl group, an n-butyl group or a $-(CH_2CH_2O)_v$-Rv group (wherein v represents an integer from 1 to 4 and Rv represents a methyl group or an ethyl group), and more preferably a methyl group, an ethyl group or a $-(CH_2CH_2O)_v$-Rv group.

With respect to the repeating unit represented by formula (IV), preferable combinations of each partial stricture are set forth below.

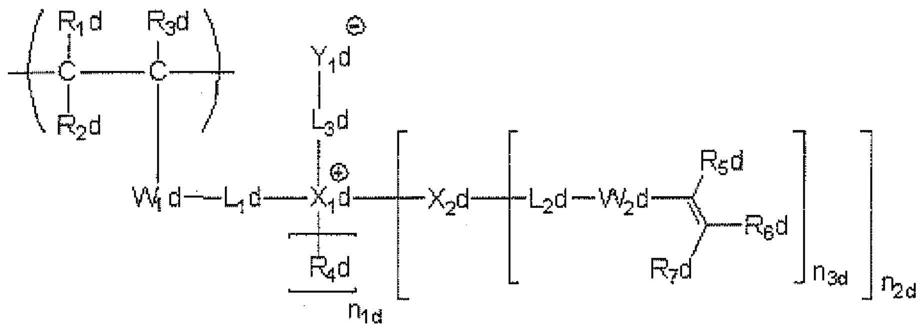

| | Preferable Combination | More Preferable Combination | Particularly Preferable Combination |
|---|---|---|---|
| $R_1$d, $R_2$d | Hydrogen atom or Methyl group | Hydrogen atom | Hydrogen atom |
| $R_3$d | Hydrogen atom, Methyl group, Ethyl group, Hydroxyethyl group, Methoxymethyl group or Methylcarbonyloxy group | Hydrogen atom, Methyl group or Hydroxymethyl group | Hydrogen atom or Methyl group |
| $R_4$d | Hydrogen atom, Methyl group, Ethyl group, n-Propyl group, n-Butyl group,-$(CH_2CH_2O)_p$-Rt group or Aralkyl group | Methyl group, Ethyl group, -$(CH_2CH_2O)_p$-Rt group or Substituted or unsubstituted benzyl group | Methyl group, Ethyl group, Hydroxyethyl group or Substituted or unsubstituted benzyl group |
| $R_5$d | Hydrogen atom, Methyl group, Ethyl group, Hydroxymethyl group, Methoxymethyl group or Methylcarbonyloxy group | Hydrogen atom, Methyl group or Hydroxyethyl group | Hydrogen atom or Methyl group |
| $R_6$d, $R_7$d | Hydrogen atom or Methyl group | Hydrogen atom | Hydrogen atom |
| $W_1$d | 1,4-Phenylene group, -0-, -CO-, -N(Rw)- or Divalent connecting group composed of appropriate combination of these groups | -CO-O- or -CO-N(Rw)- | -CO-O- or CO-N(H)- |
| $W_2$d | Alkylene group having 3 or less carbon atoms, 1,4-Phenylene group, -O-, -CO-, -N(Rw)- or Divalent connecting group composed of appropriate combination of these groups | -O-$CH_2$-, -N(Rw)-$CH_2$-, -O-CO-O-$CH_2$-, -O-CO-N(Rw)-$CH_2$-, N(Rw)-CO-O-$CH_2$-, -N(Rw)-CO-N(Rw)-$CH_2$-, -CO-O-, -CO-N(Rw)-, -CO-O-$CH_2$-, -CO-N(Rw)-$CH_2$-or -O-CO-$CH_2$- | -CO-O-, -CO-N(H)-, -CO-O-$CH_2$- or -CO-N(H)-$CH_2$- |
| $L_1$d, $L_2$d | Single bond, Alkylene group having 10 or less carbon atoms, Arylene group, Cycloalkylene group having 10 or less carbon atoms, -O-, -CO-, -N(Rw)- or Divalent connecting group composed of appropriate combination of these groups | Single bond, Alkylene group having 6 or less carbon atoms, 1,4-Phenylene group, -O-, -CO-, -N(H)- or Divalent connecting group composed of appropriate combination of these groups | Single bond, Alkylene group having 6 or less carbon atoms, 1,4-Phenylene group, -O-, -CO-, -N(H)- or Divalent connecting group composed of appropriate combination of these groups |

(continued)

| | Preferable Combination | More Preferable Combination | Particularly Preferable Combination |
|---|---|---|---|
| $L_3d$ | Alkylene group having 10 or less carbon atoms, Arylene group, Cycloalkylene group having 10 or less carbon atoms, -O-, -CO-, -N(Rw)- or Divalent connecting group composed of appropriate combination of these groups | Alkylene group having 6 or less carbon atoms, 1,4-Phenylene group, -O-, -CO-, -N(H)- or Divalent connecting group composed of appropriate combination of these groups | Alkylene group having 6 or less carbon atoms, 1,4-Phenylene group, -O-, -CO-, -N(H)- or Divalent connecting group composed of appropriate combination of these groups |
| $X_1d$ | NorP | N | N |
| $X_2d$ | $(n_3d + 1)$ Valent connecting group having total number of carbon atoms of 10 or less, provided that when $n_3d$ is 1, $X_2d$ represents single bond | Single bond | Single bond |
| $Y_1d^-$ | $-CO_2^-$, $-SO_3^-$ or $-OPO(O^-)(ORp)$ | $-CO_2^-$ or $-SO_3^-$ | $-CO_2^-$ or $-SO_3^-$ |
| $(n_1d, n_2d)$ | (0,2) or (1,1) | (0, 2) or (1, 1) | (0,2) or (1,1) |
| $n_3d$ | 1 or 2 | 1 | 1 |

In formula (V), the descriptions (including preferred embodiments) with respect to $R_1e$ to $R_3e$, $R_4e$, $R_5e$ to $R_7e$, $W_1e$, $W_2e$ and $X_1e$ are same as the descriptions (including preferred embodiments) with respect to $R_1a$ to $R_3a$, $R_4a$, $R_5a$ to $R_7a$, $W_1a$, $W_2a$ and $X_1a$ in formula (I), respectively. The descriptions (including preferred embodiments) with respect to $L_1e$ to $L_3e$ in formula (V) are same as the descriptions (including preferred embodiments) with respect to $L_1a$ in formula (I).

The descriptions (including preferred embodiments) with respect to the $(n_1e + 1)$ valent connecting group for $X_2e$ are same as the descriptions (including preferred embodiments) with respect to the $(n_2b + 1)$ valent connecting group for $X_1b$ in formula (II) except for changing the $(n_2b + 1)$ valent to the $(n_1e + 1)$ valent.

With respect to the repeating unit represented by formula (V), preferable combinations of each partial stricture are set forth below.

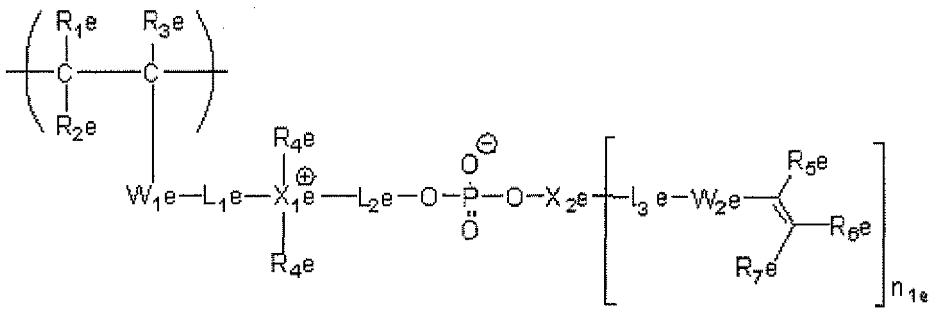

| | Preferable Combination | More Preferable Combination | Particularly Preferable Combination |
|---|---|---|---|
| $R_1e$, $R_2e$ | Hydrogen atom or Methyl group | Hydrogen atom | Hydrogen atom |
| $R_3e$ | Hydrogen atom, Methyl group, Ethyl group, Hydroxymethyl group, Methoxymethyl group or Methylcarbonyloxy group | Hydrogen atom, Methyl group or Hydroxymethyl group | Hydrogen atom or Methyl group |

(continued)

| | Preferable Combination | More Preferable Combination | Particularly Preferable Combination |
|---|---|---|---|
| $R_4e$ | Hydrogen atom, Methyl group, Ethyl group, n-Propyl group, n-Butyl group,-$(CH_2CH_2O)_p$-Rt group or Aralkyl group | Methyl group, Ethyl group, -$(CH_2CH_2O)_p$-Rt group or Substituted or unsubstituted benzyl group | Methyl group, Ethyl group, Hydroxyethyl group or Substituted or unsubstituted benzyl group |
| $R_5e$ | Hydrogen atom, Methyl group, Ethyl group, Hydroxymethyl group, Methoxymethyl group or Methylcarbonyloxy group | Hydrogen atom, Methyl group or Hydroxymethyl group | Hydrogen atom or Methyl group |
| $R_6e$, $R_7e$ | Hydrogen atom or Methyl group | Hydrogen atom | Hydrogen atom |
| $W_1e$ | 1,4-Phenylene group, -O-, -CO-, -N(Rw)- or Divalent connecting group composed of appropriate combination of these groups | -CO-O- or -CO-N(Rw)- | -CO-O- or -CO-N(H)- |
| $W_2e$ | Alkylene group having 3 or less carbon atoms, 1,4-Phenylene group, -O-, -CO-, -N(Rw)- or Divalent connecting group composed of appropriate combination of these groups | -O-$CH_2$-, -N(Rw)-$CH_2$-, -O-CO-O-$CH_2$-, -O-CO-N(Rw)-$CH_2$-, -N(Rw)-CO-O-$CH_2$-, -N(Rw)-CO-N(Rw)-$CH_2$-, -CO-O-, -CO-N(Rw)-, -CO-O-$CH_2$-, -CO-N(Rw)-$CH_2$- or -O-CO-$CH_2$- | -CO-O-, -CO-N(H)-, -CO-O-$CH_2$- or -CO-N(H)-$CH_2$- |
| $L_1e$, $L_2e$, $L_3e$ | Single bond, Alkylene group having 10 or less carbon atoms, Arylene group, Cycloalkylene group having 10 or less carbon atoms, -O-, -CO-, -N(Rw)- or Divalent connecting group composed of appropriate combination of these groups | Single bond, Alkylene group having 6 or less carbon atoms, 1,4-Phenylene group, -O-, -CO-, -N(H)- or Divalent connecting group composed of appropriate combination of these groups | Single bond, Alkylene group having 6 or less carbon atoms, 1,4-Phenylene group, -O-, -CO-, -N(H)- or Divalent connecting group composed of appropriate combination of these groups |
| $X_1e$ | N or P | N | N |
| $X_2e$ | ($n_1e$ +1) Valent connecting group having total number of carbon atoms of 10 or less, provided that when $n_1e$ is 1, $X_2e$ represents single bond | ($n_1e$ + 1) Valent connecting group having total number of carbon atoms of 5 or less, provided that when $n_1e$ is 1, $X_2e$ represents single bond | ($n_1e$ + 1) Valent connecting group having total number of carbon atoms of 5 or less, provided that when $n_1e$ is 1, $X_2e$ represents single bond |
| $n_1e$ | 1 or 2 | 1 or 2 | 1 or 2 |

In formula (VI), the descriptions (including preferred embodiments) with respect to $R_1f$ to $R_3f$, $R_4f$, $R_5f$ to $R_7f$, $W_1f$, $W_2f$, $X_1f$, $X_2f$ and $n_3f$ are same as the descriptions (including preferred embodiments) with respect to $R_1a$ to $R_3a$, $R_4a$, $R_5a$ to $R_7a$, $W_1a$, $W_2a$, $X_1a$, $X_2a$ and $n_3a$ in formula (I), respectively. The descriptions (including preferred embodiments) with respect to $L_1f$ to $L_3f$ in formula (VI) are same as the descriptions (including preferred embodiments) with respect to $L_1a$ in formula (I). $n_1f$ and $n_2f$ are preferably that ($n_1f$, $n_2f$) is (0, 3), (1, 2) or (2, 1).

The descriptions (including preferred embodiments) with respect to the ($n_3f$ + 1) valent connecting group for $X_2f$ are same as the descriptions (including preferred embodiments) with respect to the ($n_2b$ + 1) valent connecting group for $X_1b$ in formula (II) except for changing the ($n_2b$ + 1) valent to the ($n_3f$ + 1) valent.

With respect to the repeating unit represented by formula (VI), preferable combinations of each partial stricture are set forth below.

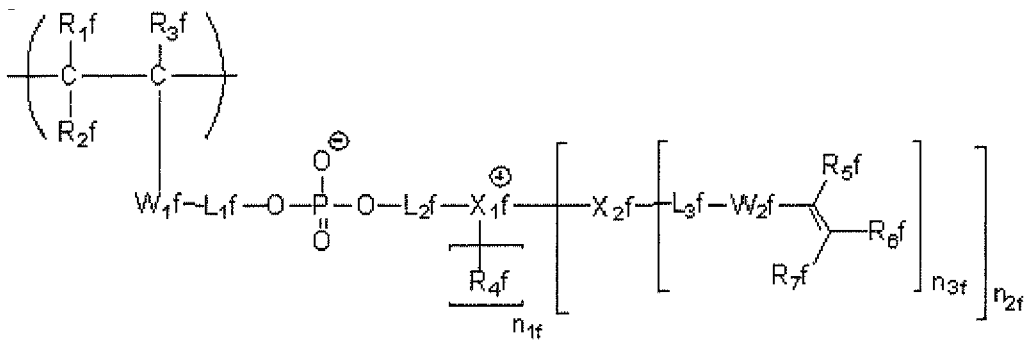

| | Preferable Combination | More Preferable Combination | Particularly Preferable Combination |
|---|---|---|---|
| $R_1f$, $R_2f$ | Hydrogen atom or Methyl group | Hydrogen atom | Hydrogen atom |
| $R_3f$ | Hydrogen atom, Methyl group, Ethyl group, Hydroxymethyl group, Methoxymethyl group or Methylcarbonyloxy group | Hydrogen atom, Methyl group or Hydroxymethyl group | Hydrogen atom or Methyl group |
| $R_4f$ | Hydrogen atom, Methyl group, Ethyl group, n-Propyl group, n-Butyl group,-$(CH_2CH_2O)_p$-Rt group or Aralkyl group | Methyl group, Ethyl group, -$(CH_2CH_2O)_p$-Rt group or Substituted or unsubstituted benzyl group | Methyl group, Ethyl group, Hydroxyethyl group or Substituted or unsubstituted benzyl group |
| $R_5f$ | Hydrogen atom, Methyl group, Ethyl group, Hydroxymethyl group, Methoxymethyl group or Methylcarbonyloxy group | Hydrogen atom, Methyl group or Hydroxymethyl group | Hydrogen atom or Methyl group |
| $R_6f$, $R_7f$ | Hydrogen atom or Methyl group | Hydrogen atom | Hydrogen atom |
| $W_1f$ | 1,4-Phenylene group, -O-, -CO-, -N(Rw)- or Divalent connecting group composed of appropriate combination of these groups | -CO-O- or -CON(Rw)- | -CO-O- or -CO-N(H)- |
| $W_2f$ | Alkylene group having 3 or less carbon atoms, 1,4-Phenylene group, -O-, -CO-, -N(Rw)- or Divalent connecting group composed of appropriate combination of these groups | -O-$CH_2$-, -N(Rw)-$CH_2$-, -O-CO-O-$CH_2$-, -O-CO-N(Rw)-$CH_2$-, -N(Rw)-CO-O-$CH_2$-, N(Rw)-CO-N(Rw)-$CH_2$-, -CO-O-, -CO-N(Rw)-, -CO-O-$CH_2$-, -CO-N(Rw)-$CH_2$- or -O-CO-$CH_2$- | CO-O-, -CO-N(H)-, -CO-O-$CH_2$- or -CO-N(H)-$CH_2$- |
| $L_1f$ to $L_3f$ | Single bond, Alkylene group having 10 or less carbon atoms, Arylene group, Cycloalkylene group having 10 or less carbon atoms, -O-, -CO-, -N(Rw)- or Divalent connecting group composed of appropriate combination of these groups | Single bond, Alkylene group having 6 or less carbon atoms, 1,4-Phenylene group, -O-, -CO-, -N(H)- or Divalent connecting group composed of appropriate combination of these groups | Single bond, Alkylene group having 6 or less carbon atoms, 1,4-Phenylene group, -0-, -CO-, -N(H)- or Divalent connecting group composed of appropriate combination of these groups |
| $X_1f$ | N or P | N | N |
| $X_2f$ | ($n_3f$ + 1) Valent connecting group having total number of carbon atoms of 10 or less, provided that when $n_3f$ is 1, $X_2f$ represents single bond | Single bond | Single bond |

(continued)

| | Preferable Combination | More Preferable Combination | Particularly Preferable Combination |
|---|---|---|---|
| ($n_1$f, $n_2$f) | (0,3), (1,2) or (2,1) | (0,3), (1, 2) or (2, 1) | (0,3), (1,2) or (2,1) |
| $n_3$f | 1 or 2 | 1 | 1 |

It is preferred in view of adjustment of hydrophilicity, ease of production or the like that $W_1$a is -CO-O- or -CO-N(Rw)- and $X_1$a is N in formule (I), $W_1$b is -CO-O- or -CO-N(Rw)- in formula (I), $W_1$c is -CO-O- or -CO-N(Rw)- and Q is $-SO_3M$, $-OPO(OM_1)(OM_2)$ or $-PO(OM_3)(OM_4)$ in formula (III), $W_1$d is -CO-O- or -CO-N(Rw)-, $X_1$d is N and $Y_1d^-$ is $-CO_2^-$, $-SO_3^-$ or $-OPO(O^-)(ORp)$ in formula (VI), $W_1$e is -CO-O- or -CO-N(Rw)- and $X_1$e is N in formula (V), or $W_1$f is -CO-O- or -CO-N(Rw)- and $X_1$f is N in formula (VI).

Specific examples of the repeating unit represented by formula (I) are set forth below together with the C log P value of a monomer (only a cation component thereof) which is a precursor of each repeating unit. Hereinafter, "Ts" represents a tosyl group (p-toluenesulfonyl group: $p-CH_3C_6H_4SO_2-$).

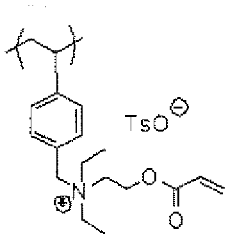

1.13 *

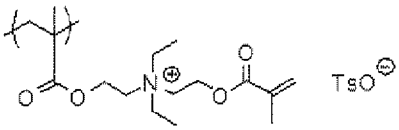

0.93 *

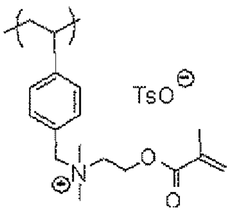

0.38 *

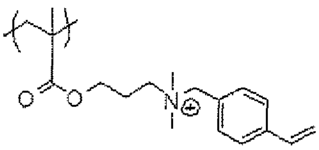

0.47 *

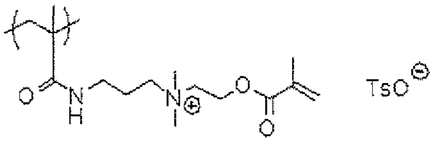

-0.09 *

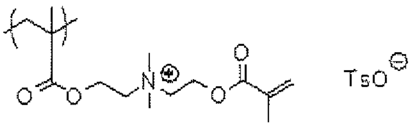

-0.13 *

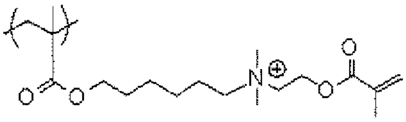

-0.16

Specific examples marked with * are reference examples.

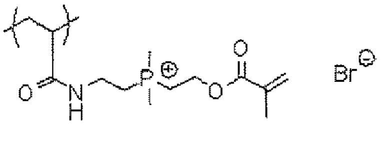

-0.41

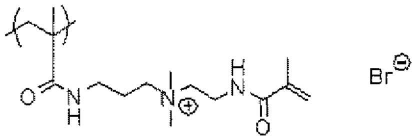

-2.22

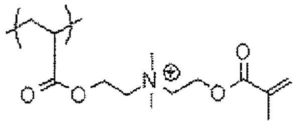 TsO$^{\ominus}$ -0.44

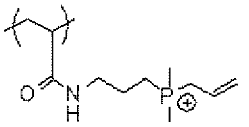 Br$^{\ominus}$ -2.22

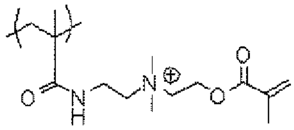 TsO$^{\ominus}$ -1.15

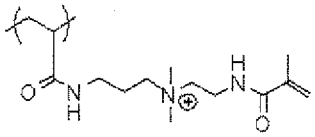 Br$^{\ominus}$ -2.53

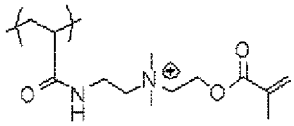 TsO$^{\ominus}$ -1.46

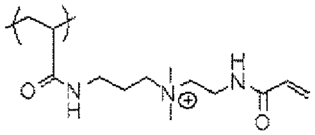 Br$^{\ominus}$ -2.84

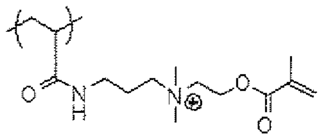 TsO$^{\ominus}$ -1.51

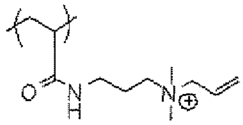 Br$^{\ominus}$ -3.33

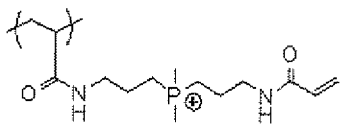 Br$^{\ominus}$ -1.83

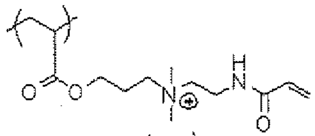 Br$^{\ominus}$ -1.73

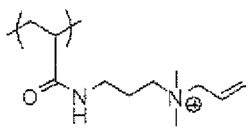 $CF_3SO_3^{\ominus}$ -3.33

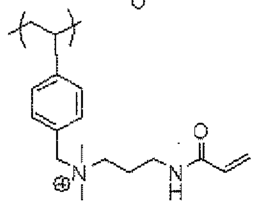 Cl$^{\ominus}$ -0.94

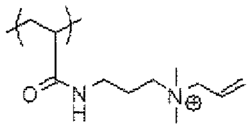 TsO$^{\ominus}$ -3.33

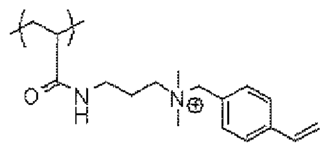 Cl$^{\ominus}$ -0.94

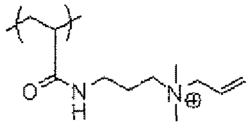 $PF_6^{\ominus}$ -3.33

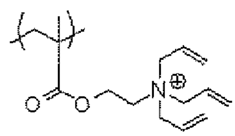 Br$^{\ominus}$ -0.37

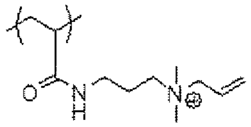 Cl$^{\ominus}$ -3.33

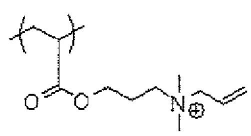 Br$^{\ominus}$ -2.19

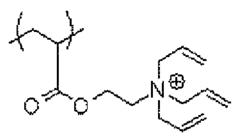 Br$^{\ominus}$ -0.68

Specific examples of the repeating unit represented by formula (II) are set forth below together with the C log

P value of a monomer which is a precursor of each repeating unit.

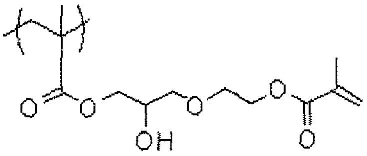

1.22 *

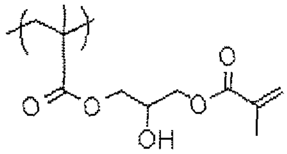

*
1.15

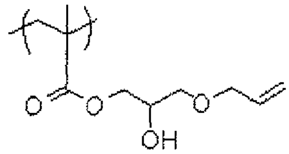

*
0.89

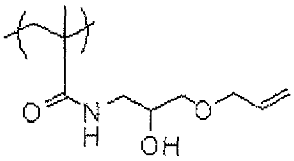

-0.15

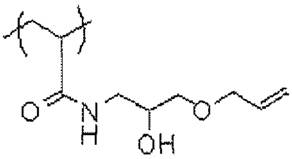

-0.46

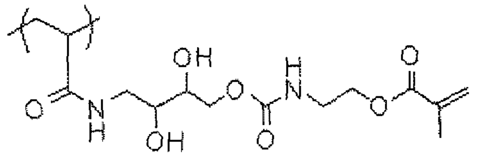

-0.15

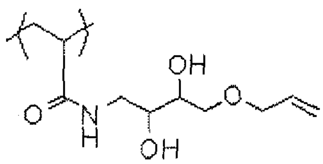

-0.50

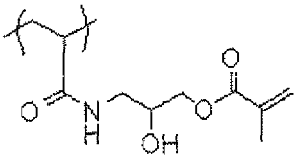

-0.18

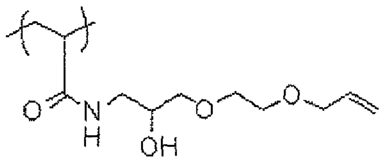

-0.59

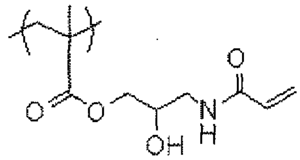

-0.18

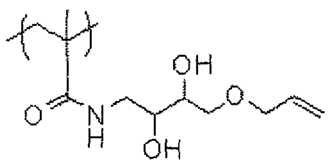

-0.19

Specific examples of the repeating unit represented by formula (III) are set forth below together with the C log P value of a monomer (only an anion component thereof) which is a precursor of each repeating unit.

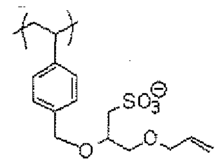

$Na^{\oplus}$ -1.80

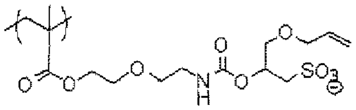

$Na^{\oplus}$ -2.91

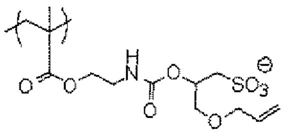

$Na^{\oplus}$ -2.97

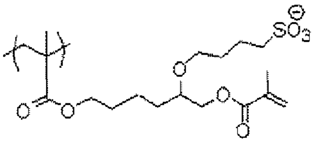

$Na^{\oplus}$ -3.06

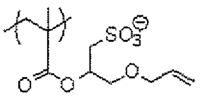

$Na^{\oplus}$ -3.29

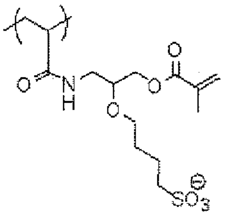

$Na^{\oplus}$ -5.27

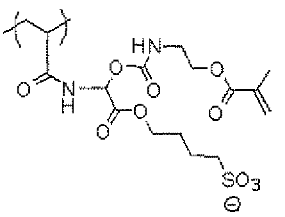

$Na^{\oplus}$ -5.55

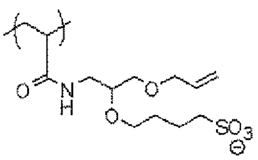

$Na^{\oplus}$ -5.75

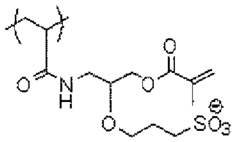

$Na^{\oplus}$ -4.0

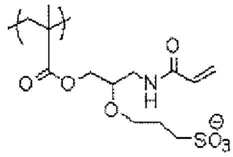

$Na^{\oplus}$ -4.0

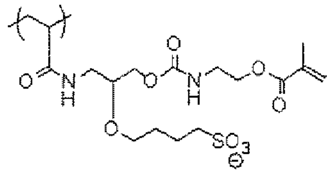

$Na^{\oplus}$ -5.19

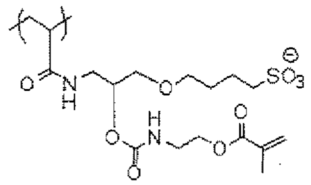

$Na^{\oplus}$ -5.20

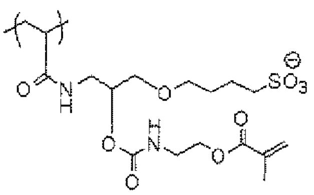

$K^{\oplus}$ -5.20

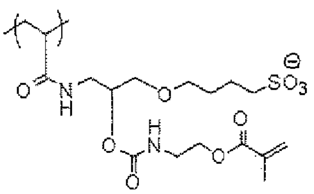

$^{\oplus}NH_4$ -5.20

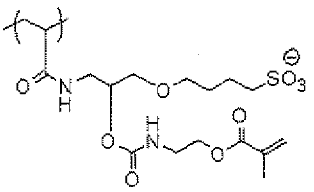

$^{\oplus}N(CH_3)_4$ -5.20

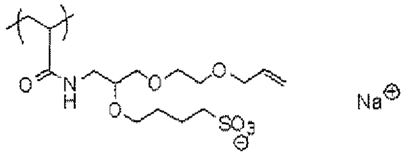

-5.88

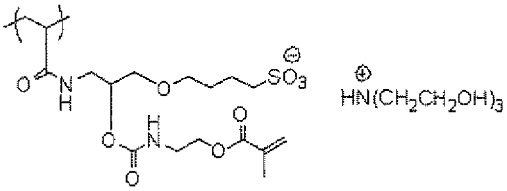

-5.20

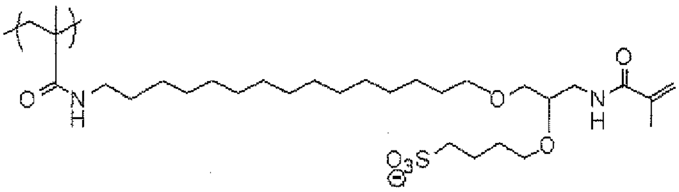

-0.30

Specific examples of the repeating unit represented by formula (IV) are set forth below together with the C log P value of a monomer which is a precursor of each repeating unit.

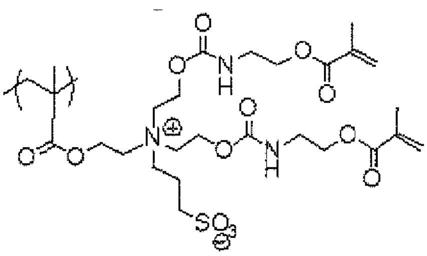

-0.81

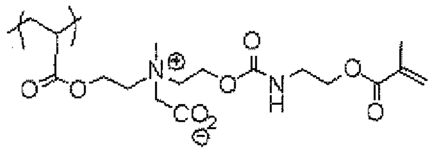

-1.47

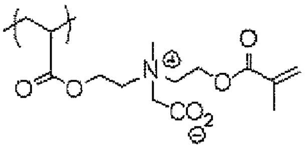

-1.55

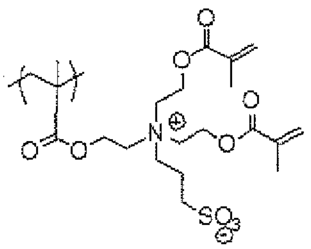

-0.97

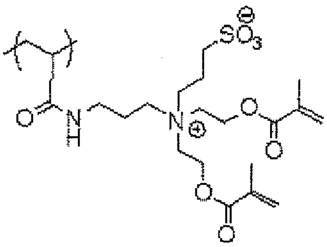

-2.35

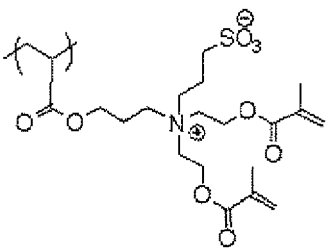

-1.25

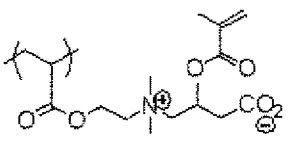

-3.69

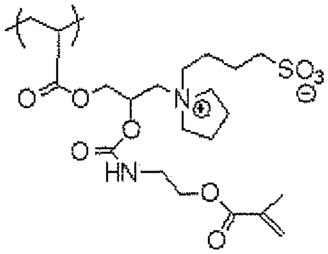

-6.32

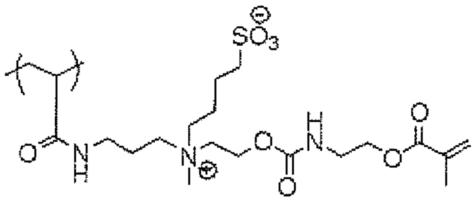

-7.19

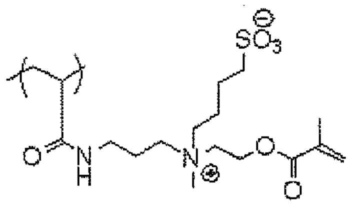

-7.27

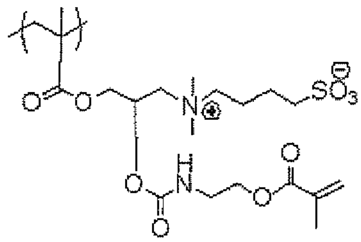

-7.49

Specific examples of the repeating unit represented by formula (V) are set forth below together with the C log P value of a monomer which is a precursor of each repeating unit.

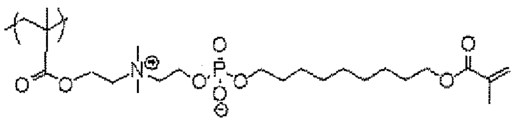

-3.64

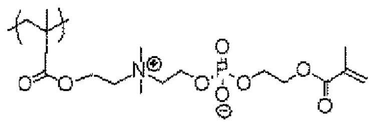

-7.34

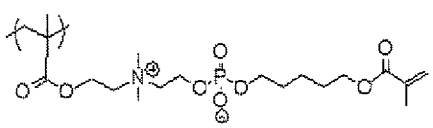

-5.75

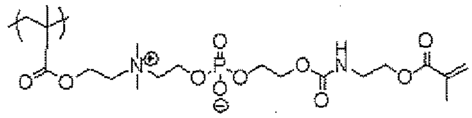

-7.50

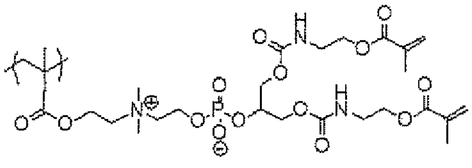 -6.75

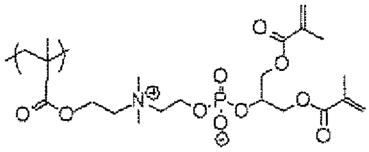 -6.80

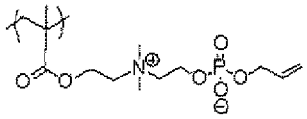 -7.18

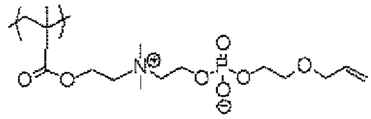 -7.66

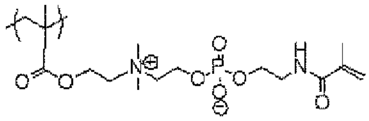 -8.72

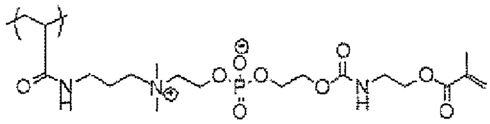 -8.88

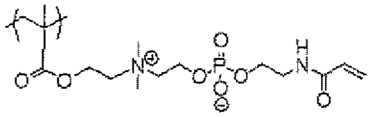 -9.03

Specific examples of the repeating unit represented by formula (VI) are set forth below together with the C log P value of a monomer which is a precursor of each repeating unit.

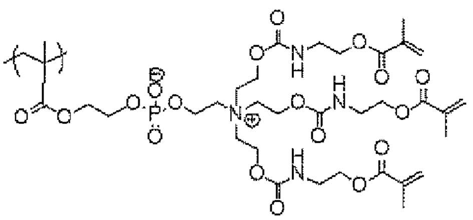 -1.98

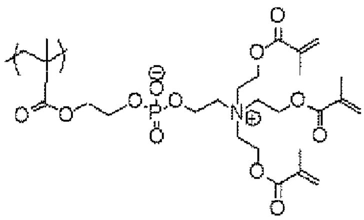 -2.21

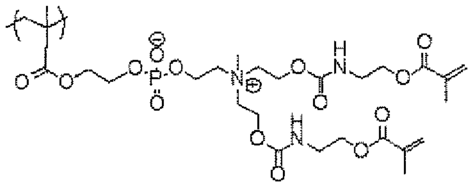 -4.62

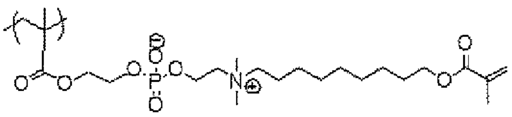 -5.79

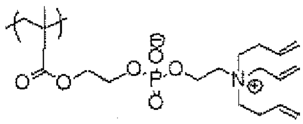 -6.93

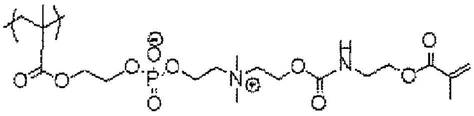 -7.26

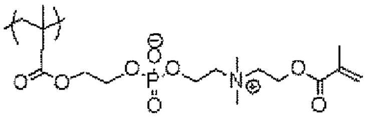 -7.34

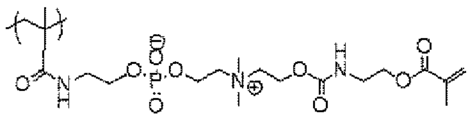 -8.64

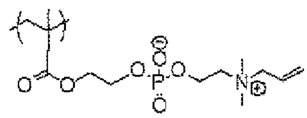 -9.13

The molar ratio of the repeating unit (d1) in the specific copolymer is ordinarily from 1 to 95% by mole, preferably from 2 to 90% by mole, and more preferably from 4 to 80% by mole. When the molar ratio is less than 1% by mole, the effects of the invention are not sufficiently exhibited. When it exceeds 95% by mole, the printing durability and chemical resistance are deteriorated although the stain resistance in the non-image area is good.

The specific copolymer according to the invention preferably contains (d2) a repeating unit having a functional

group capable of interacting with a surface of support and (d3) a repeating unit having a hydrophilic group in addition to the repeating unit (d1). Further, the specific copolymer according to the invention may contain (d4) a repeating unit having at least one ethylenically unsaturated bond, which does not correspond to the repeating unit (d1).

(d2) Repeating unit having functional group capable of interacting with surface of support

The functional group capable of interacting with a surface of support in the repeating unit (hereinafter, also referred to as "repeating unit (d2)") having a functional group capable of interacting with a surface of support includes, for example, a group capable of forming a covalent bond, an ionic bond, a hydrogen bond or the like or a group capable of undergoing interaction, for example, polar interaction, with metal, a metal oxide, a hydroxy group or the like present on a support subjected to anodizing treatment or hydrophilizing treatment

Specific examples of the functional group capable of interacting with a surface of support are set forth below.

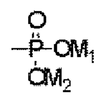 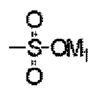 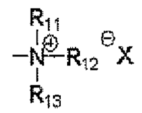 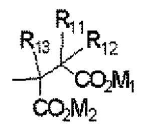 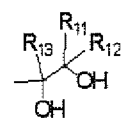 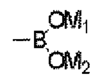 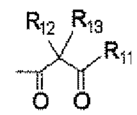

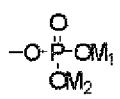 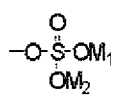 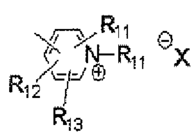 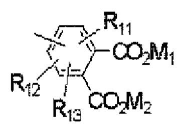 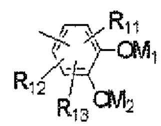 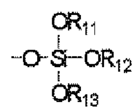 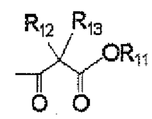

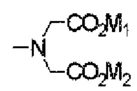

In the formulae above, $R_{11}$ to $R_{13}$ each independently represents a hydrogen atom, an alkyl group, an aryl group, an alkynyl group or an alkenyl group, $M_1$ and $M_2$ each independently represents a hydrogen atom, a metal atom or an ammonium group, and $X^-$ represents a counter anion.

As the functional group capable of interacting with a surface of support, for example, a sulfonic acid group or a salt thereof, a phosphoric acid ester group or a salt thereof, a phosphonic acid group or a salt thereof, a boric acid group, a β-diketone group, for example, an acetylacetone group, or an onium salt group, for example, an ammonium group and a pyridinium group is preferably used.

A sulfonic acid group or a salt thereof, a phosphoric acid ester group or a salt thereof, or a phosphonic acid group or a salt thereof is more preferred.

Of the repeating units (d2), repeating units represented by formula (d2a) or (d2b) shown below are preferred.

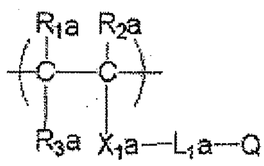 (d2a) 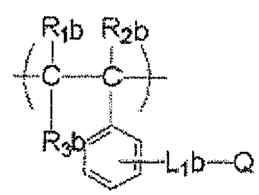 (d2b)

In formulae (d2a) and (d2b), $R_1a$ to $R_3a$ each independently represents a hydrogen atom, an alkyl group having from 1 to 6 carbon atoms, $-CH_2-OH$, $-CH_2-OR_{112}$, $-CH_2-O-CO-R_{112}$ or a halogen atom, in which $R_{112}$ represents an alkyl group having from 1 to 10 carbon atoms, an aryl group having from 6 to 10 carbon atoms or an aralkyl group having from 7 to 20 carbon atoms. $X_1a$ represents -O-, -CO-, -CO-O-, -O-CO-, $-NR_{500}-$, $-NR_{500}-CO-$ or $-CO-NR_{500}-$, $R_{500}$ represents a hydrogen atom, an alkyl group, an aryl group or an aralkyl group. $L_1a$ represents -CO-, -O-, $-NR_{500}-$, -S-, a divalent aliphatic group, a divalent aromatic group or a divalent connecting group composed of a combination of these groups. Q represents a functional group capable of interacting with a surface of support. $R_1b$ to $R_3b$ each independently represents a hydrogen atom, an alkyl group having from 1 to 6 carbon atoms, $-CH_2-OH$, $-CH_2-OR_{112}$, $-CH_2-O-CO-R_{112}$ or a halogen atom. $L_1b$ represents -CO-, -O-, $-NR_{500}-$, -S-, a divalent aliphatic group, a divalent aromatic group or a

divalent connecting group composed of a combination of these groups.

In formulae (d2a) and (d2b), $R_1a$, $R_2a$, $R_1b$, $R_2b$ each independently represents preferably a hydrogen atom, a methyl group or an ethyl group, and more preferably a hydrogen atom.

$R_3a$ and $R_3b$ each independently represents preferably a hydrogen atom, a methyl group, $-CH_2-OH$ or $-CH_2-O-CO-(C_1-$ to $C_4$-alkyl), and more preferably a hydrogen atom, a methyl group, $-CH_2-OH$ or $-CH_2-O-CO-CH_3$.

$X_1a$ represents preferably -CO-O- or $-CO-NR_{500}-$, and more -CO-O- or -CO-NH-.

$L_1a$ and $L_1b$ each independently represents preferably -O-, -S-, -CO-O-, -O-CO-, $-CO-NR_{500}-$, $-NR_{500}-CO-$, a divalent aliphatic group or a divalent connecting group composed of a combination of these groups, and more preferably -CO-O-, -O-CO-, -CO-NH-, -NH-CO-, a divalent aliphatic group or a divalent connecting group composed of a combination of these groups.

Q represents preferably a phosphoric acid ester group or a salt thereof, a phosphonic acid group or a salt thereof, a sulfonic acid group or a salt thereof, a dicarboxylic acid (for example, imininodiacetic acid or phthalic acid) group or a salt thereof, or an ammonium group, and more preferably a phosphoric acid ester group or a salt thereof, a phosphonic acid group or a salt thereof, or an ammonium group.

Specific examples of the repeating unit represented by formula (d2a) or (d2b) are set forth below, but the invention should not be construed as being limited thereto. In the specific examples shown below, when a number of repeating unit of ethyleneoxy groups is indicated as "4.5", the repeating unit means a mixture of repeating units wherein an average of the number of repeating unit of ethyleneoxy groups is 4.5.

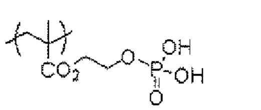
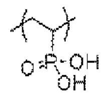
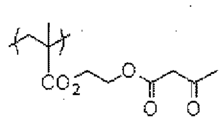
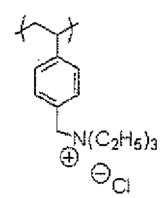
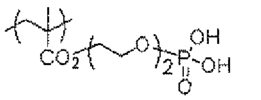
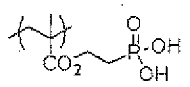
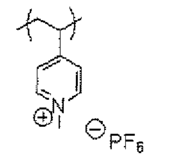
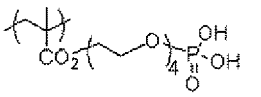
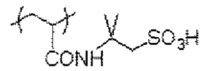
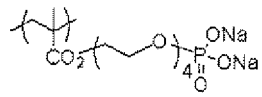
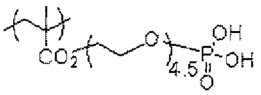
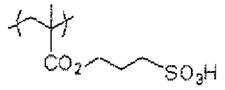
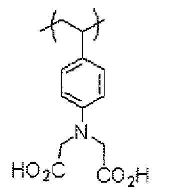
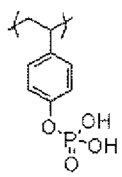
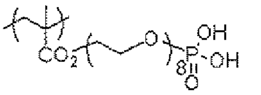
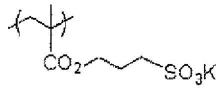
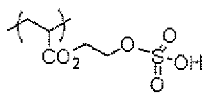
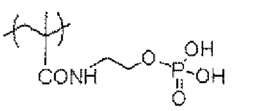
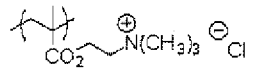
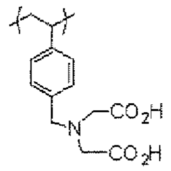
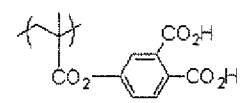
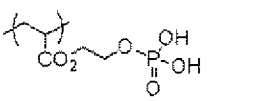
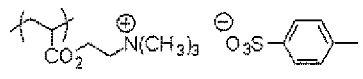
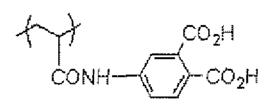

Of the repeating units (d2), in particular, those having as the functional group capable of interacting with a surface of support, a sulfonic acid group or a salt thereof, a phosphoric acid ester group or a salt thereof, or a phosphonic acid group or a salt thereof are preferred, and those having a phosphoric acid ester group or a salt thereof, or a phosphonic acid group or a salt thereof are more preferred.

The molar ratio of the repeating unit (d2) in the specific copolymer is ordinarily from 1 to 95% by mole, preferably from 5 to 90% by mole, and more preferably from 10 to 80% by mole.

(d3) Repeating unit having hydrophilic group

A hydrophilic group in the repeating unit (hereinafter, also referred to as "repeating unit (d3)") having a hydrophilic

group includes, for example, a sulfonic acid group or a salt thereof, a carboxylic acid group or a salt thereof, an amido group, an ammonium group and a poly(ethyleneoxy) group.

Of the repeating units (d3), repeating units represented by formula (d3a) or (d3b) shown below are preferred.

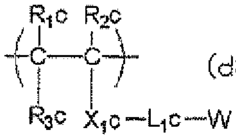 (d3a) 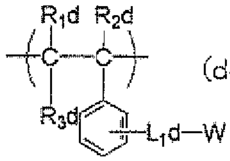 (d3b)

In formulae (d3a) and (d3b), $R_1c$ to $R_3c$ have the same meanings as $R_1a$ to $R_3a$ defined in formula (d2a) respectively. $X_1c$ has the same meaning as $X_1a$ defined in formula (d2a). $L_1c$ has the same meaning as $L_1a$ defined in formula (d2a). $R_1d$ to $R_3d$ have the same meanings as $R_1b$ to $R_3b$ defined in formula (d2b) respectively. $L_1d$ has the same meaning as $L_1b$ defined in formula (d2b). W represents a sulfonic acid group or a salt thereof, a carboxylic acid group or a salt thereof, an amido group, an ammonium group or a poly(ethyleneoxy) group.

In formulae (d3a) and (d3b), $R_1c$, $R_2c$, $R_1d$, $R_2d$ each independently represents preferably a hydrogen atom, a methyl group or an ethyl group, and more preferably a hydrogen atom.

$R_3c$ and $R_3d$ each independently represents preferably a hydrogen atom, a methyl group, $-CH_2-OH$ or $-CH_2-O-CO-(C_1-$ to $C_4$-alkyl), and more preferably a hydrogen atom, a methyl group, $-CH_2-OH$ or $-CH_2-O-CO-CH_3$.

$X_1c$ represents preferably -CO-O- or $-CO-NR_{500}-$, and more -CO-O- or -CO-NH-.

$L_1c$ and $L_1d$ each independently represents preferably -O-, -S-, -CO-O-, -O-CO-, $-CO-NR_{500}-$, $-NR_{500}-CO-$, a divalent aliphatic group or a divalent connecting group composed of a combination of these groups, and more preferably -CO-O-, -O-CO-, -CO-NH-, -NH-CO-, a divalent aliphatic group or a divalent connecting group composed of a combination of these groups.

W represents preferably a sulfonic acid group or a salt thereof, a carboxylic acid group or a salt thereof, an amido group or an ammonium group, and more preferably a sulfonic acid group or a salt thereof, a carboxylic acid salt group, an amido group or an ammonium group.

Specific examples of the repeating unit represented by formula (d3a) or (d3b) are set forth below, but the invention should not be construed as being limited thereto. In the specific examples shown below, when a number of repeating unit of ethyleneoxy groups is indicated as "4.5", the repeating unit means a mixture of repeating units wherein an average of the number of repeating unit of ethyleneoxy groups is 4.5.

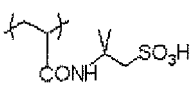 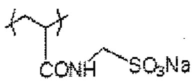 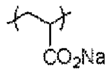 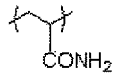

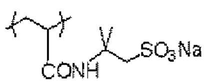 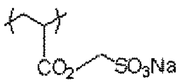 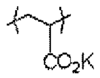 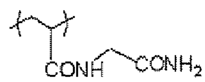

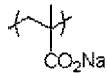

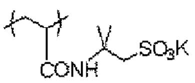 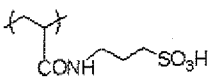 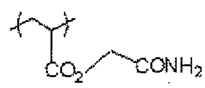 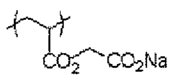

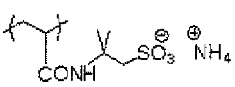 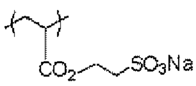 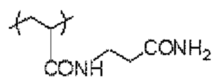 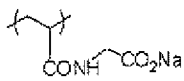

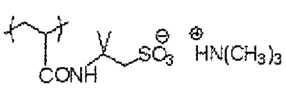 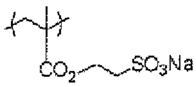 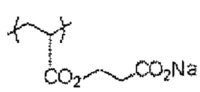 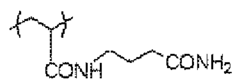

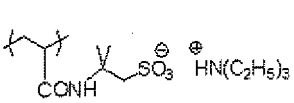 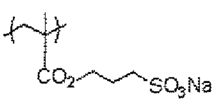 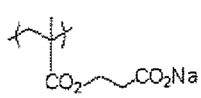 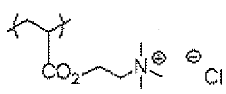

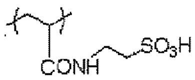 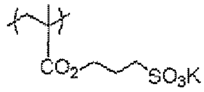 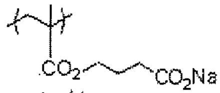 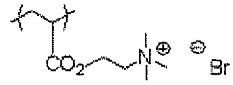

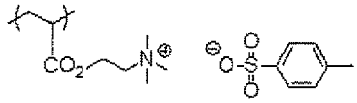 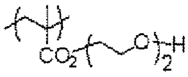 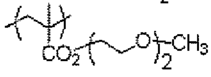 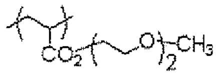

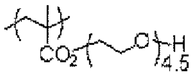 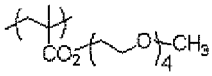 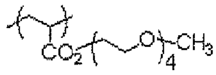

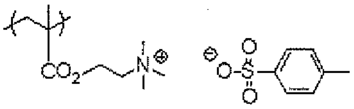

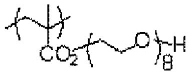 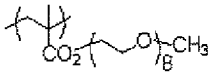 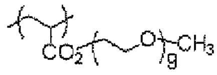

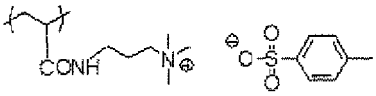 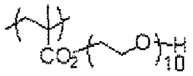 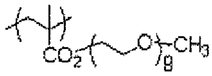 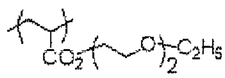

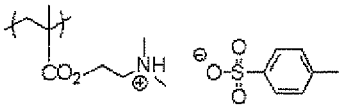 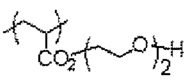 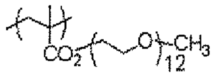

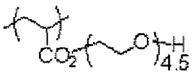 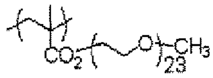

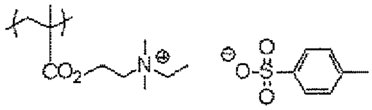 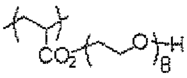 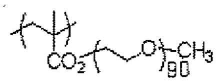

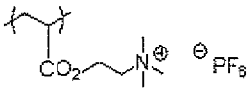 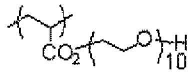

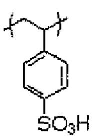 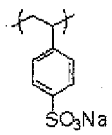 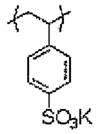 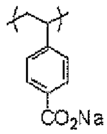 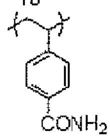 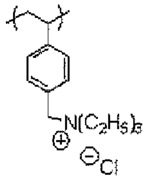

Moreover, as the repeating unit having a hydrophilic group, a repeating unit having a zwitterionic group is also preferred.

The zwitterionic group means a group which has a positive charge and a negative charge and is neutral on the whole. The zwitterionic group preferably includes a group represented by formula (i) or (ii) shown below. From the standpoint of printing durability, the zwitterionic group is more preferably the group represented by formula (i). In formula (i) or (ii), the left side indicates a site connecting to a main chain or side chain of the polymer.

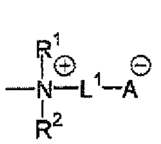 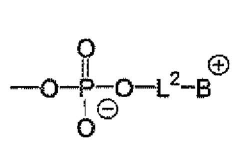

(i) (ii)

In formulae (i) and (ii), $R^1$ and $R^2$ each independently represents a hydrogen atom or a substituent having from 1 to 30 carbon atoms, $L^1$ and $L^2$ each independently represents an organic connecting group, A represents a carboxylate or a sulfonate, and B represents a substituent having a positive charge.

In formula (i), $R^1$ and $R^2$ each independently represents a hydrogen atom or a substituent having from 1 to 30

carbon atoms. The substituent having from 1 to 30 carbon atoms is preferably a substituent having from 1 to 20 carbon atoms, more preferably a substituent having from 1 to 15 carbon atoms, and particularly preferably a substituent having from 1 to 8 carbon atoms. More specifically, $R^1$ and $R^2$ each includes, for example, a straight-chain, branched or cyclic alkyl group, an aryl group or a heterocyclic group. $R^1$ and $R^2$ may be combined with each other to form a cyclic structure.

Examples of the alkyl group include a methyl group, an ethyl group, a propyl group, an octyl group, an isopropyl group, a tert-butyl group, an isopentyl group, a 2-ethylhexyl group, a 2-methylhexyl group and a cyclopentyl group. Examples of the aryl group include a phenyl group, a 1-naphtyl group and a 2-naphthyl group. Examples of the heterocyclic group include a furanyl group, a thiophenyl group and a pyridinyl group.

These groups may have a substituent. Examples of the substituent include a halogen atom (e.g., F, Cl, Br or I), a hydroxy group, a carboxyl group, an amino group, a cyano group, an aryl group, an alkoxy group, an aryloxy group, an acyl group, an alkoxycarbonyl group, an aryloxycarbonyl group, an acyloxy group, a monoalkylamino group, a dialkylamino group, a monoarylamino group and a diarylamino group.

$R^1$ and $R^2$ each particularly preferably represents a hydrogen atom, a methyl group or an ethyl group in view of the effect and ready availability.

$L^1$ and $L^2$ each independently represents an organic connecting group. Specific examples of the organic connecting group include an alkylene group having from 1 to 20 carbon atoms and an arylene group, for example, a phenylene group or a xylylene group. Specifically, the organic connecting groups shown below are exemplified. The organic connecting group may have a substituent, for example, a hydroxy group.

$-CH_2-$

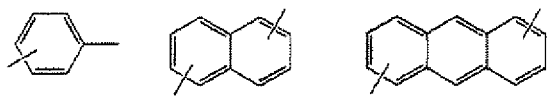

In formula (i), A represents a carboxylate or a sulfonate. Specifically, the anions shown below are exemplified.

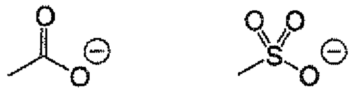

In formula (ii), B represents a substituent having a positive charge, for example, an ammonium, a phosphonium, an iodonium or a sulfonium. The ammonium or phosphonium is preferred and the ammonium is particularly preferred. Examples of the substituent having a positive charge include a trimethylammonio group, a triethylammonio group, a tributylammonio group, a benzyldimethylammonio group, a diethylhexylammonio group, a (2-hydroxyethyl)dimethylammonio group, a pyridinio group, an N-methylimidazolio group, an N-acridinio group, a trimethylphosphonio group, a triethylphosphonio group and a triphenylphosphonio group.

In particular, it is preferred that in the repeating unit a positive charge and a negative charge of the zwitterionic group be present in the position corresponding to a side chain of the polymer.

In the invention, specifically, the repeating unit having a zwitterionic group is preferably represented by formula (A1) shown below.

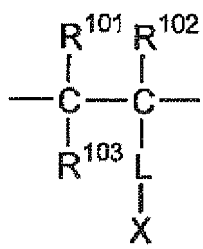

(A1)

In formula (A1), $R^{101}$ to $R^{103}$ each independently represents a hydrogen atom, an alkyl group having from 1 to 6 carbon atoms or a halogen atom. L represents a single bond or a divalent connecting group selected from the group consisting of -CO-, -O-, -NH-, a divalent aliphatic group, a divalent aromatic group and a combination thereof.

Specific examples of the combination of groups represented by L are set forth below. In each of the specific examples shown below, the left side connects to the main chain and the right side connects to X.

L1: -CO-O-divalent aliphatic group-

L2: -CO-O-divalent aromatic group-

L3: -CO-NH-divalent aliphatic group-
L4: -CO-NH-divalent aromatic group-
L5: -CO-divalent aliphatic group-
L6: -CO-divalent aromatic group-
L7: -CO-divalent aliphatic group-CO-O-divalent aliphatic group-
L8: -CO-divalent aliphatic group-O-CO-divalent aliphatic group-
L9: -CO-divalent aromatic group-CO-O-divalent aliphatic group-
L10: -CO-divalent aromatic group-O-CO-divalent aliphatic group-
L11: -CO-divalent aliphatic group-CO-O-divalent aromatic group-
L12: -CO-divalent aliphatic group-O-CO-divalent aromatic group-
L13: -CO-divalent aromatic group-CO-O-divalent aromatic group-
L14: -CO-divalent aromatic group-O-CO-divalent aromatic group-
L15: -CO-O-divalent aromatic group-O-CO-NH-divalent aliphatic group-
L16: -CO-O-divalent aliphatic group-O-CO-NH-divalent aliphatic group-

The divalent aliphatic group includes an alkylene group, a substituted alkylene group, an alkenylene group, a substituted alkenylene group, an alkinylene group, a substituted alkinylene group and a polyalkyleneoxy group. Among them, an alkylene group, a substituted alkylene group, an alkenylene group and a substituted alkenylene group are preferable, and an alkylene group and a substituted alkylene group are more preferred.

Of the divalent aliphatic groups, a chain structure is preferable than a cyclic structure, and further a straight-chain structure is more preferable than a branched structure. A number of carbon atoms included in the divalent aliphatic group is preferably from 1 to 20, more preferably from 1 to 15, still more preferably from 1 to 12, yet still more preferably from 1 to 10, and most preferably from 1 to 8.

Examples of the substituent for the divalent aliphatic group include a halogen atom (e.g., F, Cl, Br or I), a hydroxy group, a carboxyl group, an amino group, a cyano group, an aryl group, an alkoxy group, an aryloxy group, an acyl group, an alkoxycarbonyl group, an aryloxycarbonyl group, an acyloxy group, a monoalkylamino group, a dialkylamino group, a monoarylamino group and a diarylamino group.

The divalent aromatic group includes an arylene group and a substituted arylene group. It preferably includes a phenylene group, a substituted phenylene group, a naphthylene group and a substituted naphthylene group.

Examples of the substituent for the divalent aromatic group include an alkyl group in addition to the substituents described for the divalent aliphatic group described above.

Of L1 to L16 described above, L1 to L4 are preferred.

L is preferably a single bond, -CO-, a divalent aliphatic group, a divalent aromatic group or any one of L1 to L4.

In formula (AI), X represents a zwitterionic group. X is preferably the group represented by formula (i) or (ii) and preferred embodiments thereof are also same as those described in formulae (i) and (ii).

Of the repeating units (d3), in particular, those having as the hydrophilic group, a sulfonic acid group or a salt thereof, a carboxylic acid group or a salt thereof, an amido group, an ammonium group or a zwitterionic group are preferred, and those having a sulfonic acid group or a salt thereof, an amido group or a zwitterionic group are more preferred.

The molar ratio of the repeating unit (d3) in the specific copolymer is ordinarily from 1 to 90% by mole, preferably from 5 to 80% by mole, and more preferably from 10 to 70% by mole.

(d4) Repeating unit having at least one ethylenically unsaturated bond which does not correspond to the repeating unit (d1)

As the repeating unit (hereinafter, also referred to as "repeating unit (d4)") having at least one ethylenically unsaturated bond which does not correspond to the repeating unit (d1) the repeating unit (d1), repeating units represented by formulae (d4a) to (d4c) shown below are preferred.

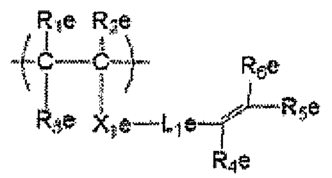
(d4a)

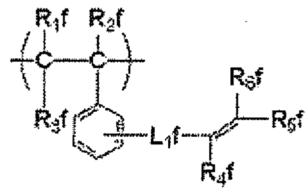
(d4b)

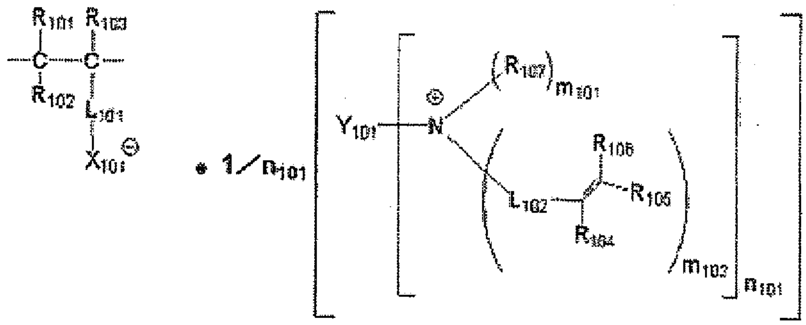

(d4c)

In formulae (d4a) to (d4c), $R_1e$ to $R_3e$ have the same meanings as $R_1a$ to $R_3a$ defined in formula (d2a) respectively. $X_1e$ has the same meaning as $X_1a$ defined in formula (d1a). $L_1e$ has the same meaning as $L_1a$ defined in formula (d2a). $R_4e$ to $R_6e$ each independently represents a hydrogen atom, an alkyl group having from 1 to 6 carbon atoms, a halogen atom, $-CH_2-OH$, $-CH_2-OR_{108}$, $-CH_2-O-CO-R_{108}$, $-CO-R_{108}$, $-O-CO-R_{108}$, $-CO-O-R_{108}$ or $-CO-N(R_{109})-R_{108}$, or $R_4e$ and $R_5e$ or $R_5e$ and $R_6e$ may be combined with each other to form a ring.

$R_1f$ to $R_3f$ have the same meanings as $R_1a$ to $R_3a$ defined in formula (d2a) respectively. $L_1f$ has the same meaning as $L_1a$ defined in formula (d2a). $R_4f$ to $R_6f$ each independently represents a hydrogen atom, an alkyl group having from 1 to 6 carbon atoms, a halogen atom, $-CH_2-OH$, $-CH_2-OR_{108}$, $-CH_2-O-CO-R_{108}$, $-CO-R_{108}$, $-O-CO-R_{108}$, $-CO-O-R_{108}$ or $-CO-N(R_{109})-R_{108}$, or $R_4f$ and $R_5f$ or $R_5f$ and $R_6f$ may be combined with each other to form a ring.

$R_{101}$ to $R_{103}$ each independently represents a hydrogen atom, an alkyl group having from 1 to 6 carbon atoms, $-CH_2-OH$, $-CH_2-OR_{112}$, $-CH_2-O-CO-R_{112}$ or a halogen atom. $R_{104}$ to $R_{106}$ each independently represents a hydrogen atom, an alkyl group having from 1 to 6 carbon atoms, a halogen atom, $-CH_2-OH$, $-CH_2-OR_{108}$, $-CH_2-O-CO-R_{108}$, $-CO-R_{108}$, $-O-CO-R_{108}$, $-CO-O-R_{108}$ of $-CO-N(R_{109})-R_{108}$, or $R_{104}$ and $R_{105}$ or $R_{105}$ and $R_{106}$ may be combined with each other to form a ring. $R_{107}$ represents a hydrogen atom, an alkyl group having from 1 to 10 carbon atoms, an aryl group having from 6 to 10 carbon atoms or an aralkyl group having from 7 to 20 carbon atoms. $R_{108}$ represents an alkyl group having from 1 to 10 carbon atoms or an aryl group having from 6 to 10 carbon atoms. $R_{109}$ represents a hydrogen atom, an alkyl group having from 1 to 10 carbon atoms or an aryl group having from 6 to 10 carbon atoms. $R_{112}$ represents an alkyl group having from 1 to 10 carbon atoms, an aryl group having from 6 to 10 carbon atoms or an aralkyl group having from 7 to 20 carbon atoms. $L_{110}$ represents -CO-, -0-, -S-, $-N(R_{109})-$, $-SO_2-$, a divalent aliphatic group, a divalent aromatic group or a divalent connecting group composed of a combination of these groups. $L_{102}$ represents -CO-, -O-, $-N(R_{109})-$, a divalent aliphatic group, a divalent aromatic group or a divalent connecting group composed of a combination of these groups. $m_{101}$ represents an integer from 0 to 3. $m_{102}$ represents an integer from 1 to 3, provided that $m_{101} + m_{102} = 3$. When $m_{101}$ is 2 or more, plural $R_{107}$ may be the same or different. When $m_{102}$ is 2 or more, plural $R_{104}$ to $R_{106}$ and $L_{102}$ may be the same or different. $X_{101}^-$ represents $-CO_2^-$, $-PO_3H^-$, $-O-PO_3H^-$, $-SO_3^-$ or $-O-SO_3^-$. $Y_{101}$ represents an $n_{101}$ valent connecting group, provided that it may be a hydrogen atom when $n_{101}$ is 1. $n_{101}$ represents an integer from 1 to 10, provided that a value of $m_{102} \times n_{101}$ is not zero.

In formulae (d4a) to (d4c), $R_1e$, $R_2e$, $R_1f$, $R_2f$ each independently represents preferably a hydrogen atom, a methyl group or an ethyl group, and more preferably a hydrogen atom.

$R_3e$ and $R_3f$ each independently represents preferably a hydrogen atom, a methyl group, $-CH_2-OH$ or $-CH_2-O-CO-(C_1-$ to $C_4$-alkyl), and more preferably a hydrogen atom, a methyl group, $-CH_2-OH$ or $-CH_2-O-CO-CH_3$.

$X_1c$ represents preferably -CO-O- or $-CO-NR_{500}-$, and more preferably -CO-O- or -CO-NH-.

$L_1e$ and $L_1f$ each independently represents preferably -O-, -S-, -CO-O-, -O-CO-, $-CO-NR_{500}-$, $-NR_{500}-CO-$, a divalent aliphatic group or a divalent connecting group composed of a combination of these groups, more preferably -CO-O-, -O-CO-, -CO-NH-, -NH-CO-, a divalent aliphatic group or a divalent connecting group composed of a combination of these groups.

$R_4e$ and $R_4f$ each independently represents preferably a hydrogen atom, a methyl group, $-CH_2-OH$, $-CH_2-O-CO-(C_1-$ to $C_4$-alkyl), $-CO-O-(C_1-$ to $C_4$-alkyl) or $-CO-NH-(C_1-$ to $C_4$-alkyl), and more preferably a hydrogen atom, a methyl group, $-CH_2-OH$, $-CH_2-O-CO-CH_3$, $-CO-O-(C_1-$ to $C_2$-alkyl) or $-CO-NH-(C_1-$ to $C_2$-alkyl).

$R_5e$, $R_6e$, $R_5f$ and $R_6f$ each independently represents preferably a hydrogen atom, a methyl group or an ethyl group, and more preferably a hydrogen atom.

$R_{101}$ and $R_{102}$ each independently represents preferably a hydrogen atom, a methyl group or an ethyl group, and more preferably a hydrogen atom.

$R_{103}$ represents preferably a hydrogen atom, a methyl group, $-CH_2-OH$ or $-CH_2-O-CO-(C_1-$ to $C_4$-alkyl), and more preferably a hydrogen atom, a methyl group, $-CH_2-OH$ or $-CH_2-O-CO-CH_3$.

$R_{104}$ represents preferably a hydrogen atom, a methyl group, $-CH_2-OH$, $-CH_2-O-CO-(C_1-$ to $C_4$-alkyl), $-CO-O-(C_1-$ to $C_4$-alkyl) or $-CO-NH-(C_1-$ to $C_4$-alkyl), and more preferably a hydrogen atom, a methyl group, $-CH_2-OH$, $-CH_2-O-$

CO-$CH_3$, -CO-O-($C_1$- to $C_2$-alkyl) or -CO-NH-($C_1$- to $C_2$-alkyl).

$R_{105}$ and $R_{106}$ each independently represents preferably a hydrogen atom, a methyl group or an ethyl group, and more preferably a hydrogen atom.

$R_{107}$ represents preferably a hydrogen atom, a $C_1$- to $C_4$-alkyl group, a benzyl group, a ($C_1$- to $C_4$-alkyl substituted) phenylmethyl group, a ($C_1$- to $C_4$-alkoxy substituted) phenylmethyl group, a ($C_1$-to $C_4$-acyloxy substituted) phenylmethyl group or a ($C_1$- to $C_4$-alkoxycarbonyl substituted) phenylmethyl group, and more preferably a hydrogen atom, a methyl group, an ethyl group or a benzyl group.

$R_{108}$ represents preferably a methyl group, an ethyl group, a n-propyl group, an iso-propyl group, a n-butyl group or a phenyl group, and more preferably a methyl group, an ethyl group or a n-propyl group.

$R_{109}$ represents preferably a hydrogen atom, a methyl group, an ethyl group, a n-propyl group, an iso-propyl group, a n-butyl group or a phenyl group, and more preferably a hydrogen atom, a methyl group, an ethyl group or a n-propyl group.

$L_{101}$ represents preferably -CO-O-L0-, -CO-NH-L0-, -divalent aromatic group- or -divalent aromatic group-L0-, and more preferably -CO-O-L0- or -CO-NH-L0-. L0 represents a divalent aliphatic group, a divalent aromatic group or a combination of these groups.

$L_{102}$ represents preferably any one of La to Lr shown below, and more preferably La, Lb, Lf, Lg, Lh, Li, Lo, Lp or Lr. In La to Lr, L0 has the same meaning as L0 defined above.

La: -L0-O-CO-
Lb: -L0-NH-CO-
Lc: -L0-O-
Ld: -L0-CO-O-
Le: -L0-O-CO-O-
Lf: -L0-O-$CH_2$-
Lg: -L0-CO-O-$CH_2$-
Lh: -L0-O-CO-O-$CH_2$-
Li: -L0-O-CO-NH-L0-O-CO-
Lj: -L0-O-CO-L0-O-CO-
Lk: -L0-O-CO-L0-NH-CO-
Ll: -L0-CO-O-L0-O-CO-
Lm: -L0-CO-O-L0-NH-CO-
Ln: -L0-divalen aromatic group-
Lo: -O-CO-divalent aromatic group-
Lp: -O-CO-L0-divalent aromatic group-
Lq: -CO-O-divalent aromatic group-
Lr: -CO-O-L0-divalent aromatic group-

With respect to $m_{101}$, $m_{102}$ and $n_{101}$, a value of $m_{102}$ x $n_{101}$ is preferably from 1 to 6, and more preferably from 1 to 4.

$X_{101}^-$ represents preferably -$CO_2^-$, -$PO_3H^-$, -O-$PO_3H^-$ or -$SO_3^-$, and more preferably -$CO_2^-$,-O-$PO_3H^-$ or -$SO_3^-$.

$Y_{101}$ ordinarily represents an $n_{101}$ valent hydrocarbon residue, may include any of aliphatic and aromatic structures and may include any of straight-chain, branched and cyclic structures. The cyclic structure may be any of monocyclic and polycyclic structures. The carbon-carbon bond constituting the hydrocarbon residue may be interrupted with -CO-, -O-, -S-, -N($R_{109}$)-, -$SO_2$- or a structure composed of a combination of these groups. However, $Y_{101}$ may be a hydrogen atom, when $n_{101}$ is 1.

Specific examples of the repeating unit represented by any one of formulae (d4a) to (d4c) are set forth below, but the invention should not be construed as being limited thereto.

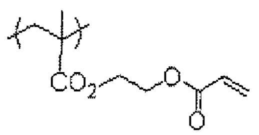
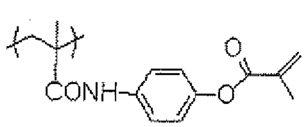
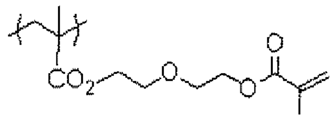
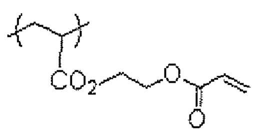
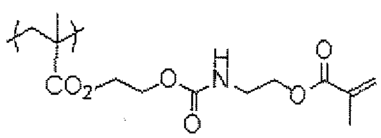
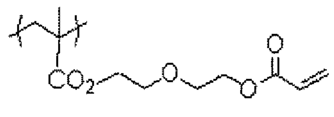

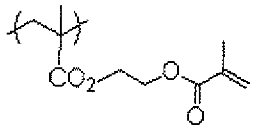

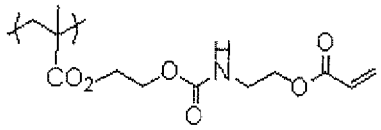

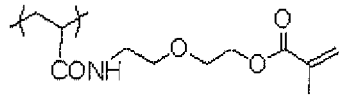

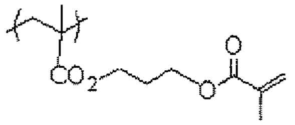

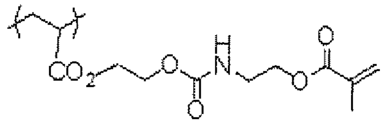

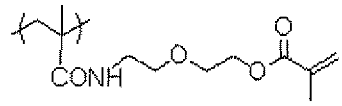

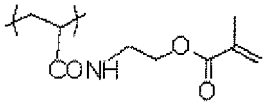

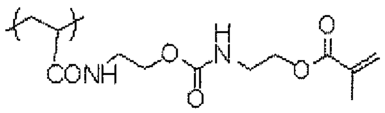

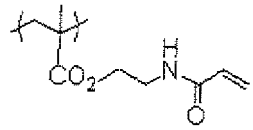

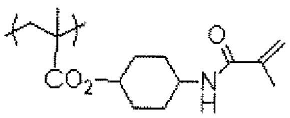

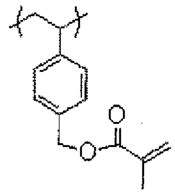

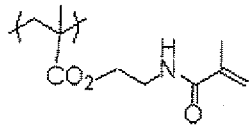

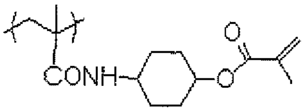

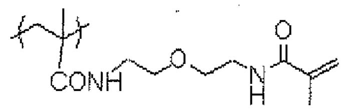

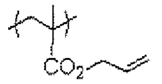
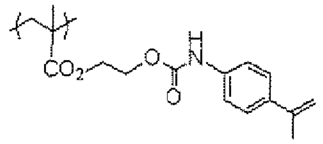
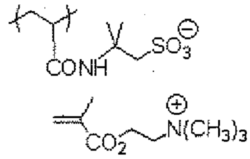
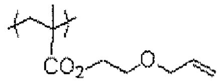
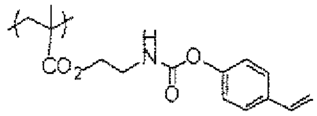
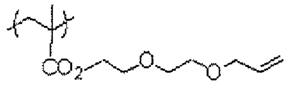
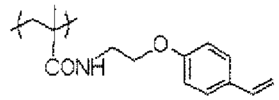
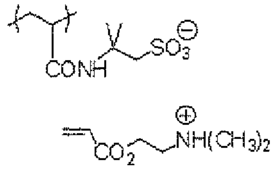
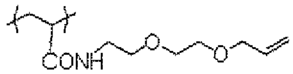
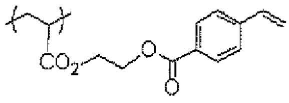
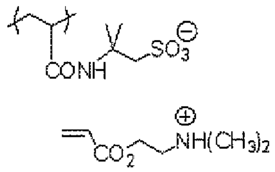
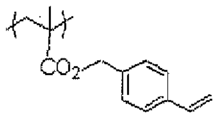
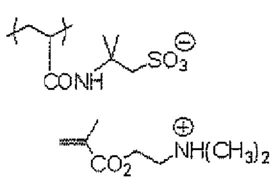
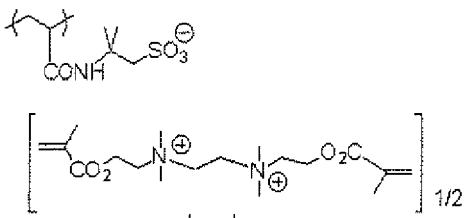
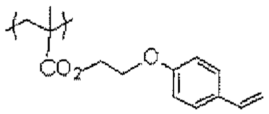
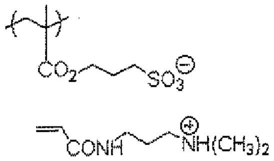
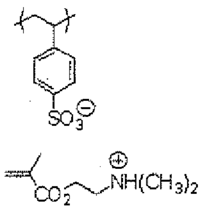
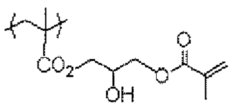
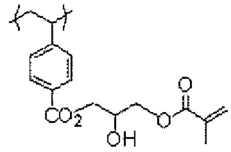
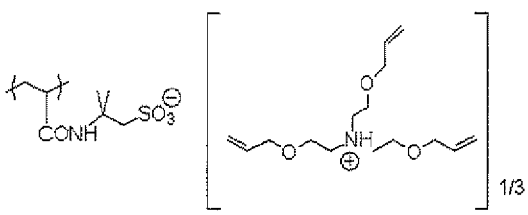
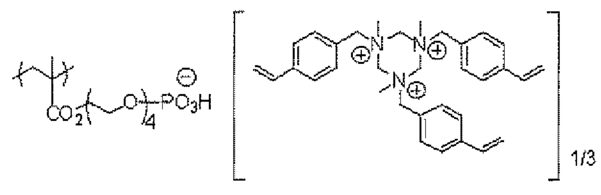

Of the repeating units (d4), in particular, those having as the ethylenically unsaturated group, a (meth)acryloyl group, an aromatic group-substituted vinyl group or an allyl group are preferred, and those having a (meth)acryloyloxy group, a (meth)acryloylamido group or a phenyl group-substituted vinyl group (styryl group) are more preferred.

The molar ratio of the repeating unit (d4) in the specific copolymer is ordinarily from 0.5 to 80% by mole, preferably from 2 to 65% by mole, and more preferably from 5 to 50% by mole.

With respect to the specific copolymer according to the invention, two or more kinds of the copolymers having different structures may be used as a mixture. In the case of using as a mixture, a weight ratio of the specific copolymer which is used in the smallest amount is preferably 1% by weight or more, more preferably 3% by weight or more, particularly preferably 5% by weight or more, based on the total weight of the specific copolymer.

Further, in the intermediate layer, a polymer other than the specific copolymer according to the invention, that is, a polymer which does not contain the repeating unit (d1) may be used as a mixture with the specific copolymer according to the invention. The polymer other than the specific copolymer includes, for example, polymer compounds having a crosslinkable group (preferably, an ethylenically unsaturated bond group), a functional group capable of interacting with a surface of support and a hydrophilic group described in JP-A-2005-125749, JP-A-2006-239867 and JP-A-2006-215263 are exemplified. In such a case, the total weight of the specific copolymer is preferably 3% by weight or

more, more preferably 5% by weight or more, particularly preferably 10% by weight or more, based on the total weight of the components used in the intermediate layer.

A weight average molecular weight of the specific copolymer according to the invention or the polymer other than the specific copolymer used in the intermediate layer is ordinarily from 2,000 to 1,000,000, preferably from 4,000 to 700,000, more preferably from 6,000 to 500,000, and most preferably from 7,000 to 400,000. When the weight average molecular weight thereof is less than 2,000, good printing durability is not obtained. On the other hand, when the weight average molecular weight thereof exceeds 1,000,000, a problem may arise in time-lapse stability, for example, occurrence of deposition or phase separation in a solution of the polymer with a lapse of time, or a problem, for example, degradation of the stain resistance may arise.

Although the specific copolymer according to the invention is able to synthesize by any hitherto known method, a radical polymerization method is preferably used for the synthesis thereof. Ordinary radical polymerization methods are described, for example, in Shin Kobunshi Jikkengaku 3, Kobunshi no Gosei to Hanno 1, (New Polymer Experimentation 3, Synthesis and Reaction of Polymer 1), edited by The Society of Polymer Science, Japan, (Kyoritsu Shuppan Co., Ltd.), Shin Jikken Kagaku Koza 19, Kobunshi Kagaku (I), (New Experimental Chemistry Course 19, Polymer Chemistry (I)), edited by The Chemical Society of Japan, (Maruzen Co., Ltd.) and Busshitsu Kogaku Koza, Kobunshi Gosei Kagaku, (Material Engineering Course, Polymer Synthesis Chemistry), (Tokyo Denki University Press) and these methods can be applied.

A method for introduction of the carbon-carbon unsaturated double bond into the repeating unit (d1) in the specific copolymer according to the invention is not particularly restricted and specifically includes the following three methods: (1) Method where the carbon-carbon unsaturated double bond is introduced into a monomer and the monomer is polymerized to obtain a polymer, (2) Method where the carbon-carbon unsaturated double bond is introduced into a monomer as a precursor structure, the monomer is polymerized to obtain a polymer and then a conversion reaction is performed to generate the carbon-carbon unsaturated double bond, and (3) Method where a reactive functional group, for example, an active hydrogen is introduced into a monomer, the monomer is polymerized to obtain a polymer and then the reactive functional group is reacted with a compound having a functional group capable of forming a bond with the reactive functional group and a carbon-carbon unsaturated double bond to introduce the carbon-carbon unsaturated double bond. The method (1) is particularly effective in the case where polymerizability of the carbon-carbon unsaturated double bond is lower than that of the polymerizable group which reacts in the synthesis of polymer. The conversion reaction in the method (2) includes, for example, a release reaction with a base. The method of introducing the carbon-carbon unsaturated double bond in the method (3) includes, for example, a reaction of the active hydrogen in the polymer with (meth)acryloyl chloride, 2-isocyanatoethyl (meth)acrylate or the like. In the case where the specific copolymer according to the invention is obtained by the method (2) or (3), the by-product salt can be removed by passing through an ion-exchange resin, if desire.

Specific examples of the specific copolymer according to the invention are set forth below, but the invention should not be construed as being limited thereto. In each of the specific examples, the rightmost repeating unit corresponds to the repeating unit (d1) according to the invention.

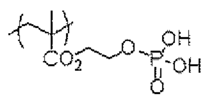 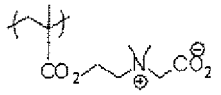 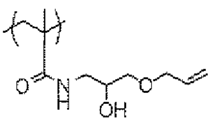 -0.15 D-1 45/50/5 8

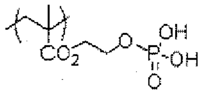 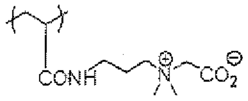 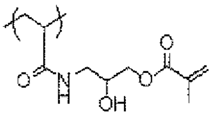 -0.18 D-2 80/15/5 10

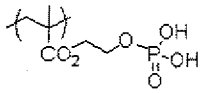 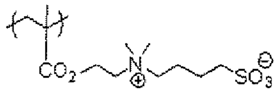 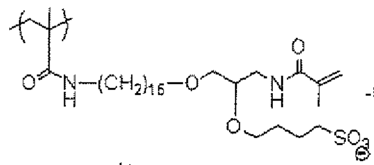 -0.30 D-3 40/50/10 12

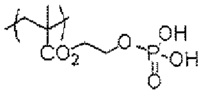 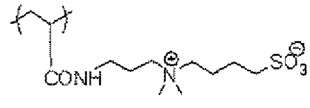 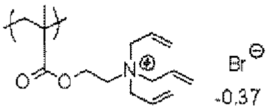 -0.37 D-4 45/45/10 7

| | | | | | | |
|---|---|---|---|---|---|---|
| 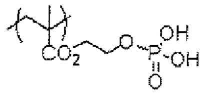 | 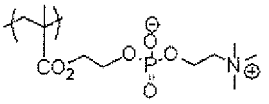 | 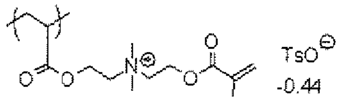 | -0.44 | D-5 | 30/60/10 | 9 |
| 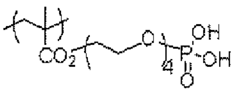 | 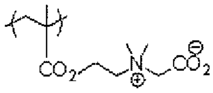 | 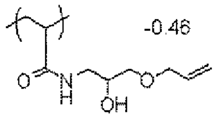 | -0.46 | D-6 | 50/40/10 | 13 |
| 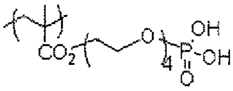 | 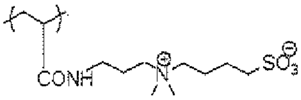 | 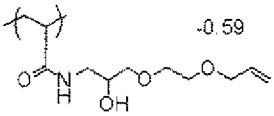 | -0.59 | D-7 | 40/45/15 | 10 |
| 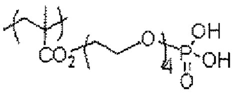 | 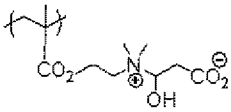 | 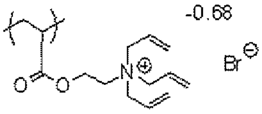 | -0.68 | D-8 | 50/45/5 | 13 |
| 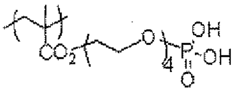 | 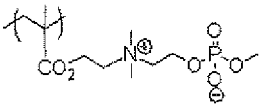 | 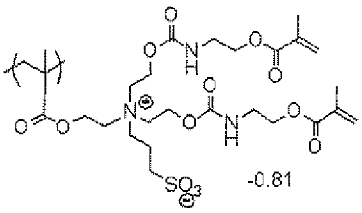 | -0.81 | D-9 | 50/40/10 | 10 |
| 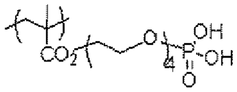 | 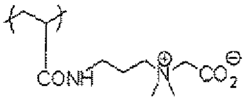 | 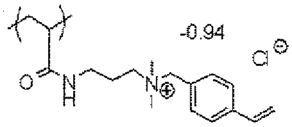 | -0.94 | D-10 | 45/45/10 | 8 |
| 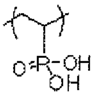 | 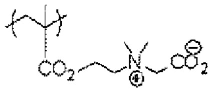 | 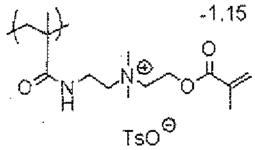 | -1.15 | D-11 | 60/25/15 | 2 |
| 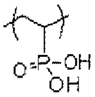 | 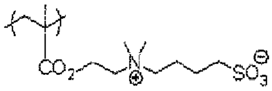 | 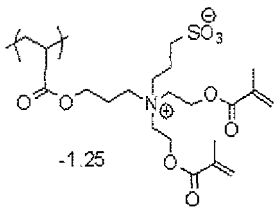 | -1.25 | D-12 | 55/30/15 | 3 |
| 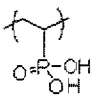 | 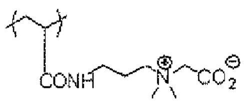 | 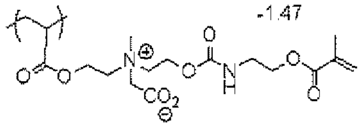 | -1.47 | D-13 | 60/20/20 | 2.5 |

| | | | | | |
|---|---|---|---|---|---|
| 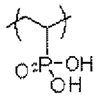 | 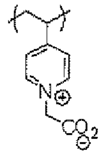 | -1.51 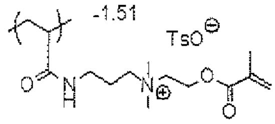 | D-14 | 45/40/15 | 3.5 |
| 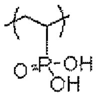 | 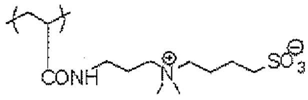 | -1.83 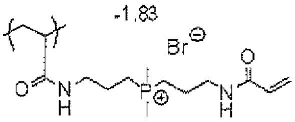 | D-15 | 40/40/20 | 4.5 |
| 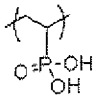 | 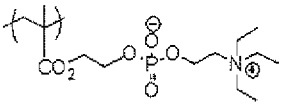 | 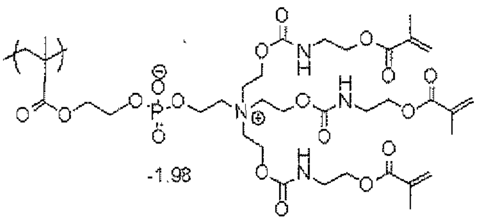 -1.98 | D-16 | 45/35/20 | 5 |
| 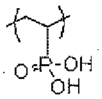 | 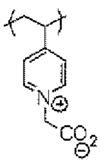 | -2.22 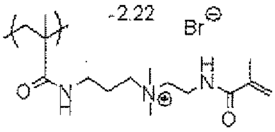 | D-17 | 55/20/25 | 1.5 |
| 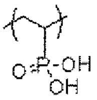 | 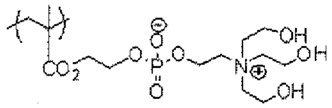 | 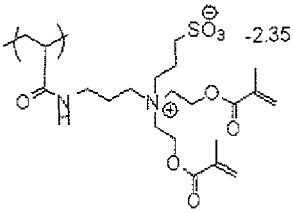 -2.35 | D-18 | 45/30/25 | 2.5 |
| 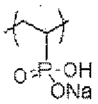 | 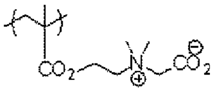 | -2.53 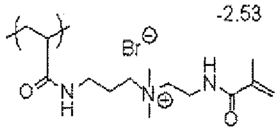 | D-19 | 50/25/25 | 1.5 |
| 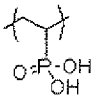 | 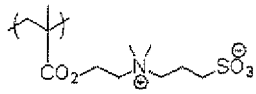 | -2.84 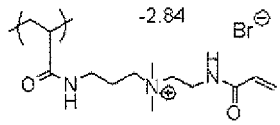 | D-20 | 40/40/20 | 3.5 |
| 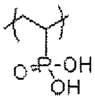 | 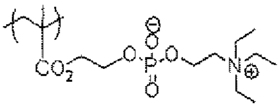 | -2.97 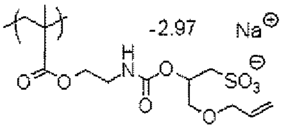 | D-21 | 45/25/30 | 2 |

| | | | | | |
|---|---|---|---|---|---|
| 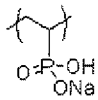 | 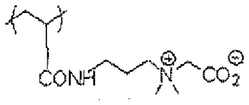 | 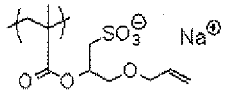 -3.29 | D-22 | 40/35/25 | 2 |
| 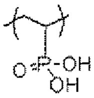 | 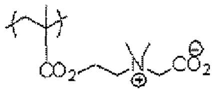 | 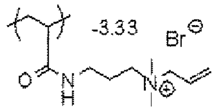 -3.33 | D-23 | 40/35/25 | 2.5 |
| 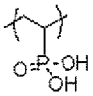 | 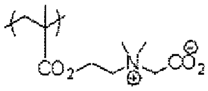 | 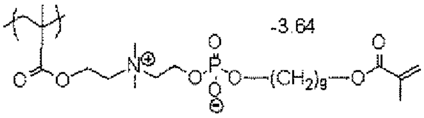 -3.64 | D-24 | 40/25/35 | 3.5 |
| 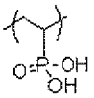 | 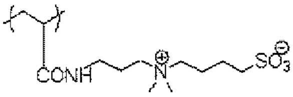 | -3.69 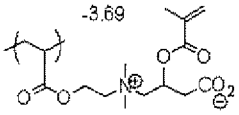 | D-25 | 35/35/30 | 1.5 |
| 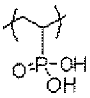 | 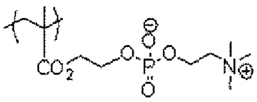 | 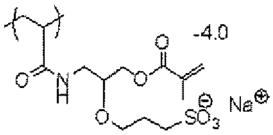 -4.0 | D-26 | 35/30/35 | 2 |
| 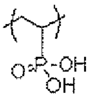 | 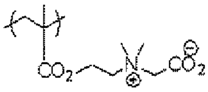 | 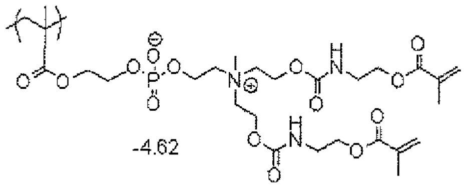 -4.62 | D-27 | 35/30/35 | 1 |
| 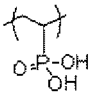 | 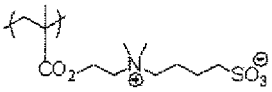 | 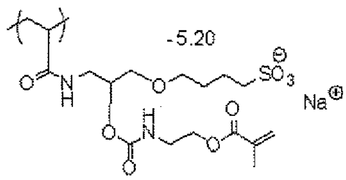 -5.20 | D-28 | 40/25/35 | 2.5 |
| 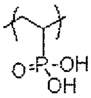 | 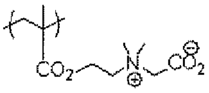 | 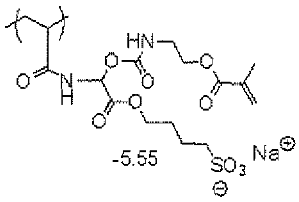 -5.55 | D-29 | 35/30/35 | 1.5 |
| 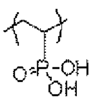 | 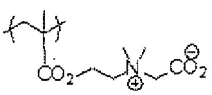 | 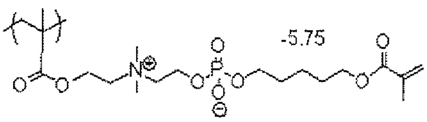 -5.75 | D-30 | 40/30/30 | 2 |

| | | | | | | |
|---|---|---|---|---|---|---|
| 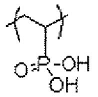 | 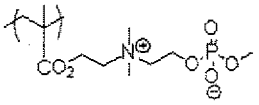 | 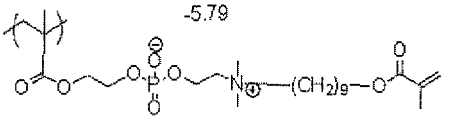 | -5.79 | D-31 | 40/25/35 | **0.8** |
| 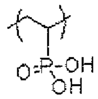 | 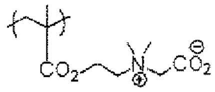 | 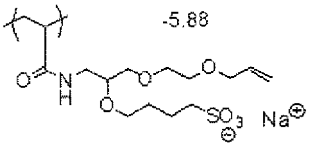 | -5.88 | D-32 | 30/30/40 | **0.6** |
| 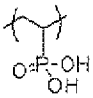 | 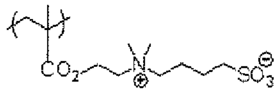 | 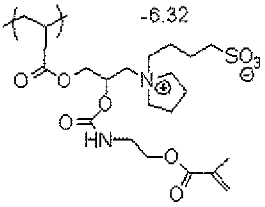 | -6.32 | D-33 | 40/25/35 | **1** |
| 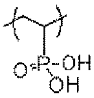 | 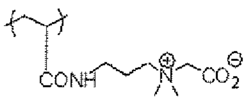 | 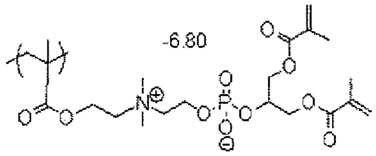 | -6.80 | D-34 | 40/30/30 | **2** |
| 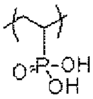 | 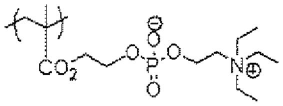 | 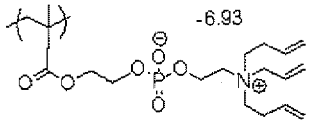 | -6.93 | D-35 | 50/15/35 | **2.5** |
| 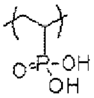 | 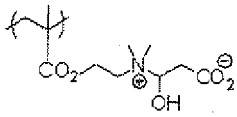 | 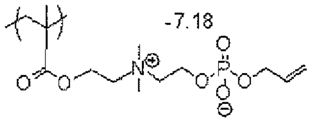 | -7.18 | D-36 | 45/25/30 | 2 |
| 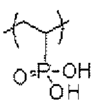 | 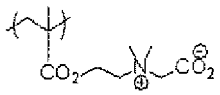 | 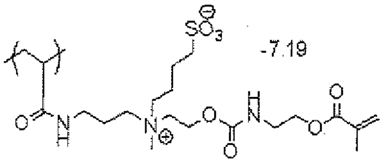 | -7.19 | D-37 | 45/15/40 | 3.5 |
| 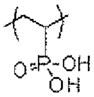 | 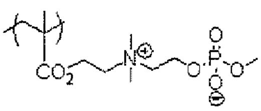 | 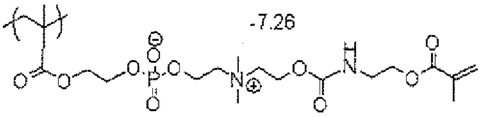 | -7.26 | D-38 | 45/20/35 | 2 |
| 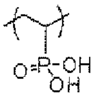 | 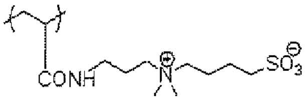 | 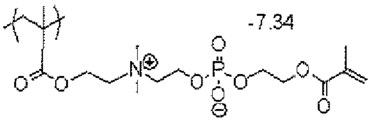 | -7.34 | D-39 | 50/20/30 | 1.5 |

| | | | | | | |
|---|---|---|---|---|---|---|
| 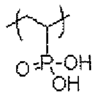 | 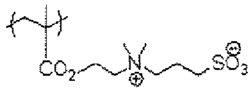 | 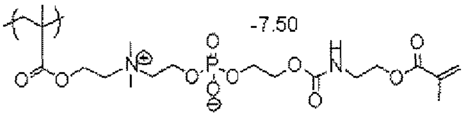 | -7.50 | D-40 | 40/15/45 | 3.5 |
| 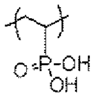 | 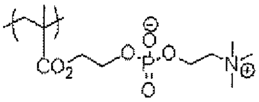 | 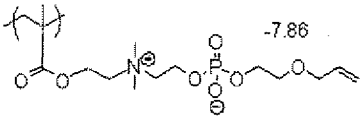 | -7.86 | D-41 | 50/15/35 | 4.5 |
| 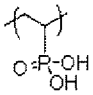 | 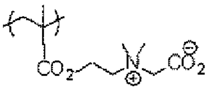 | 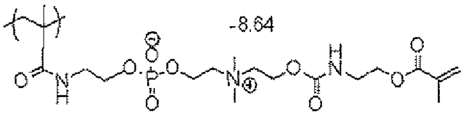 | -8.64 | D-42 | 45/15/40 | 5 |
| 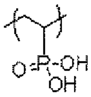 | 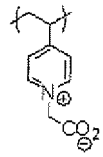 | 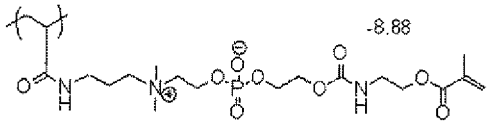 | -8.88 | D-43 | 45/15/40 | 3 |
| 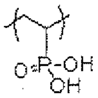 | 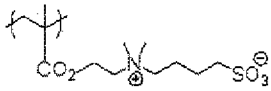 | 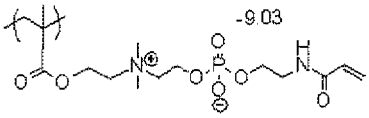 | -9.03 | D-44 | 40/15/45 | 3 |
| 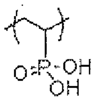 | 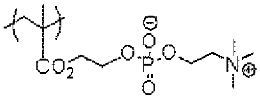 | 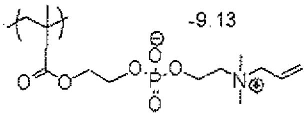 | -9.13 | D-45 | 30/25/45 | 5.5 |
| 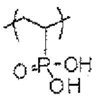 | 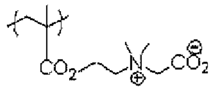 | 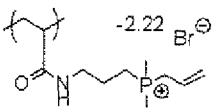 | -2.22 | D-46 | 45/35/20 | 5.5 |
| 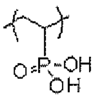 | 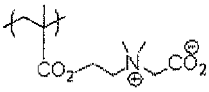 | 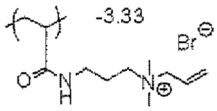 | -3.33 | D-47 | 45/35/20 | 5 |
| 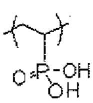 | 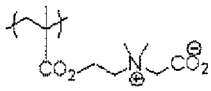 | 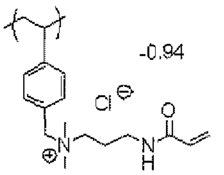 | -0.94 | D-48 | 55/35/10 | 2.5 |
| 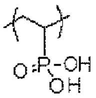 | 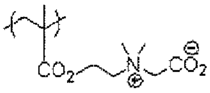 | 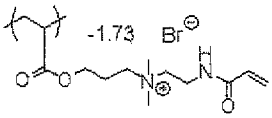 | -1.73 | D-49 | 55/35/10 | 2.5 |

| | | | | | | |
|---|---|---|---|---|---|---|
| 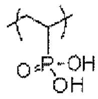 | 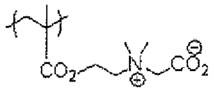 | 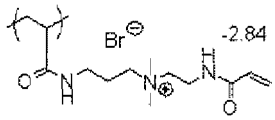 | -2.84 | D-50 | 55/35/10 | 3 |
| 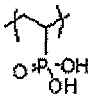 | 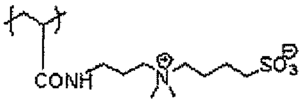 | 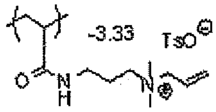 | -3.33 | D-51 | 55/25/20 | 1 |
| 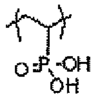 | 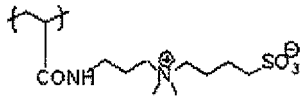 | 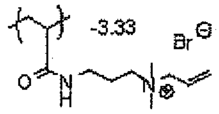 | -3.33 | D-52 | 55/25/20 | 1 |
| 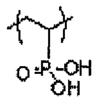 | 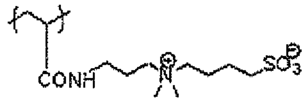 | 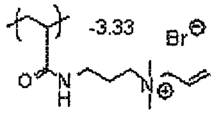 | -3.33 | D-53 | 50/20/30 | 2.5 |
| 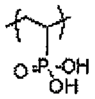 | 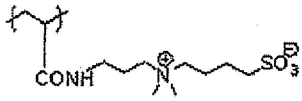 | 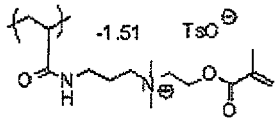 | -1.51 | D-54 | 50/20/30 | 2.5 |
| 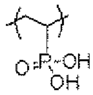 | 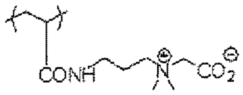 | 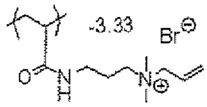 | -3.33 | D-55 | 50/25/25 | 5.5 |
| 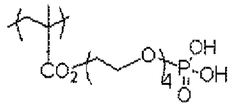 | 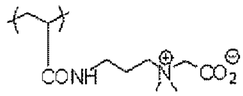 | 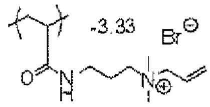 | -3.33 | D-56 | 50/25/25 | 6 |
| 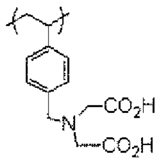 | 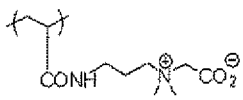 | 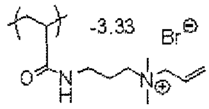 | -3.33 | D-57 | 50/25/25 | 6.5 |
| 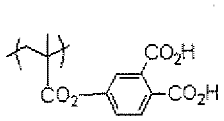 | 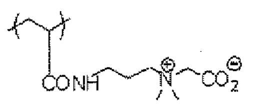 | 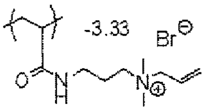 | -3.33 | D-58 | 50/25/25 | 6 |
| 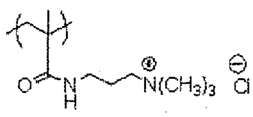 | 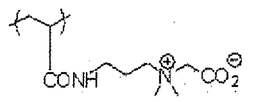 | 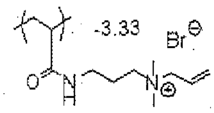 | -3.33 | D-59 | 50/25/25 | 4.5 |

| | | | | | |
|---|---|---|---|---|---|
| 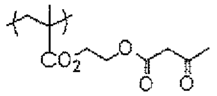 | 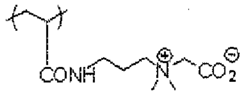 | 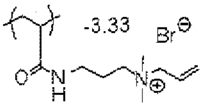 -3.33 | D-60 | 50/25/25 | 5.5 |
| 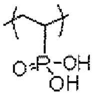 | 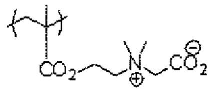 | 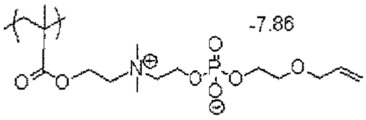 -7.86 | D-61 | 40/20/40 | 1.5 |
| 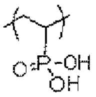 | 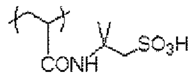 | 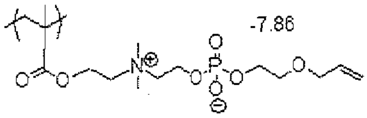 -7.86 | D-62 | 40/20/40 | 2 |
| 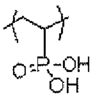 | 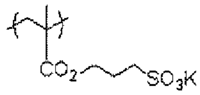 | 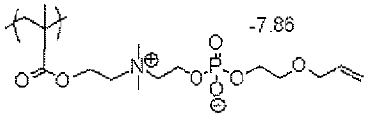 -7.86 | D-63 | 40/20/40 | 2.5 |
| 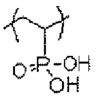 | 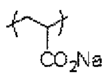 | 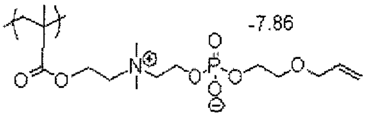 -7.86 | D-64 | 40/20/40 | 2 |
| 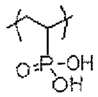 | 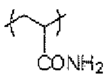 | 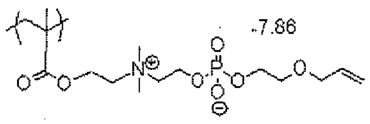 -7.86 | D-65 | 40/20/40 | 1.5 |
| 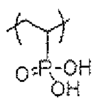 | 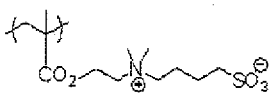 | 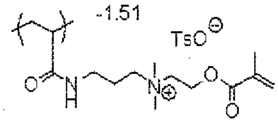 -1.51 | D-66 | 50/25/25 | **0.35** |
| 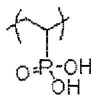 | 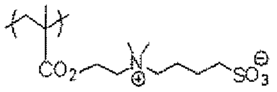 | 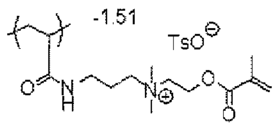 -1.51 | D-67 | 50/25/25 | **0.65** |
| 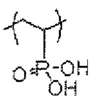 | 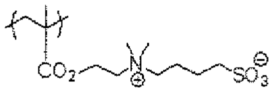 | 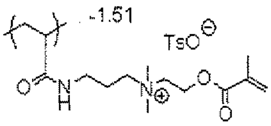 -1.51 | D-68 | 50/25/25 | **4** |
| 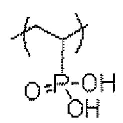 | 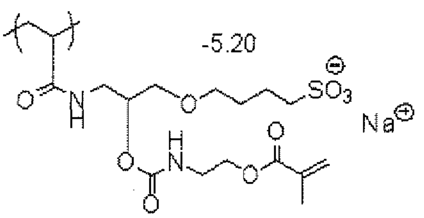 -5.20 | | D-69 | 60/40 | 2.5 |

| | | | | |
|---|---|---|---|---|
| -8.64 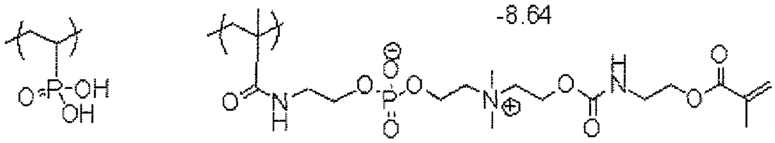 | | D-70 | 55/45 | 1.5 |
| 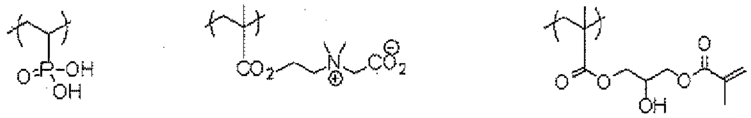 | 1.15 | D-71* | 75/25/10 | **2** |
| 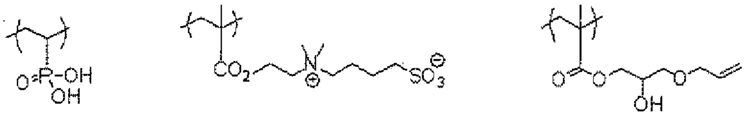 | 0.89 | D-72* | 60/30/10 | **3** |
| 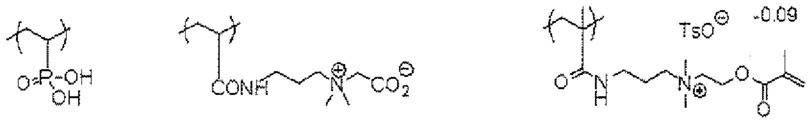 | -0.09 | D-73* | 75/25/10 | **2.5** |
| 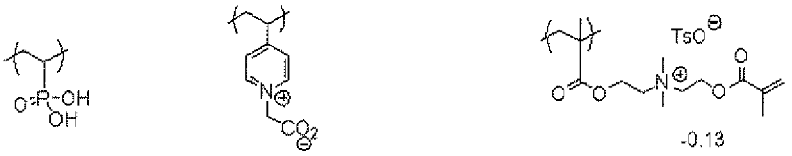 | -0.13 | D-74 | 60/30/10 | **3.5** |

Examples of specific copolymers marked with an asterix (*) are mentioned for reference only.

The intermediate layer may further contain a silane coupling agent having an addition polymerizable ethylenically unsaturated bond group described in JP-A-10-282679, a phosphorus compound having an ethylenically unsaturated bond group described in JP-A-2-304441, a compound having an ethylenically unsaturated bond group and a support adsorbing group described in JP-A-2005-238816 or the like. Moreover, if desired, the intermediate layer may contain the surfactant described hereinafter with respect to the image-forming layer.

In order to form the intermediate layer on a support, a coating solution prepared by dissolving the component for the intermediate layer in a solvent is used. As the solvent, water and an organic solvent, for example, methanol, ethanol, propanol, isopropanol, ethylene glycol, hexylene glycol, tetrahydrofuran, dimethylformamide, 1-methyoxy-2-propanol, dimethylacetamide, dimethylsulfoxide, N-methylpyrrolidone or N-ethylpyrrolidone are exemplified and water and an alcohol are particularly preferred. The solvents may be used as a mixture.

The concentration of the coating solution for intermediate layer is preferably from 0.001 to 10% by weight, more preferably from 0.01 to 5% by weight, and still more preferably from 0.05 to 1% by weight. In order to coat the coating solution for intermediate layer on a support, known various methods can be used. For example, bar coater coating, spin coating, spray coating, curtain coating, dip coating, air knife coating, blade coating and roll coating are exemplified.

The coating amount (solid content) of the intermediate layer is preferably from 0.1 to 100 mg/m$^2$, and more preferably from 1 to 30 mg/m$^2$.

[Image-forming layer]

The image-forming layer (hereinafter, also referred to as a photosensitive layer) of the lithographic printing plate precursor according to the invention contains (A) a polymerization initiator, (B) a polymerizable compound and (C) a binder polymer.

(A) Polymerization initiator

The photosensitive layer according to the invention contains a polymerization initiator (hereinafter, also referred to as an initiator compound). In the invention, a radical polymerization initiator is preferably used.

As the initiator compound, initiator compounds known to those skilled in the art can be used without limitation. Specifically, the initiator compound includes, for example, a trihalomethyl compound, a carbonyl compound, an organic peroxide, an azo compound, an azide compound, a metallocene compound, a hexaarylbiimidazole compound, an organic

boron compound, a disulfone compound, an oxime ester compound, an onium salt and a iron arene complex. Among them, at least one compound selected from the hexaarylbiimidazole compound, onium salt, trihalomethyl compound and metallocene compound is preferred, and the hexaarylbiimidazole compound is particularly preferred.

The hexaarylbiimidazole compound includes, for example, lophine dimers described in JP-B-45-37377 (the term "JP-B" as used herein means an "examined Japanese patent publication") and JP-B-44-86516, specifically,
2,2'-bis(o-chlorophenyl)-4,4',5,5'-tetraphenylbiimidazole,
2,2'-bis(o-bromophenyl)-4,4',5,5'-tetraphenylbiimidazole.
2,2'-bis(o,p-dichlorophenyl)-4,4',5,5'-tetraphenylbiimidazole,
2,2'-bis(o-chlorophenyl)-4,4',5,5'-tetra(m-methoxyphenyl)biimidazole,
2,2'-bis(o,o'-dichlorophenyl)-4,4',5,5'-tetraphenylbiimidazole,
2,2'-bis(o-nitrophenyl)-4,4',5,5'-tetraphenylbiimidazole,
2,2'-bis(o-methylphenyl)-4,4',5,5'-tetraphenylbiimidazole and
2,2'-bis(o-trifluoromethylphenyl)-4,4',5,5'-tetraphenylbiimidazole.

The hexaarylbiimidazole compound is particularly preferably used together with a sensitizing dye having an absorption maximum in a wavelength range from 300 to 450 nm.

The onium salt preferably used in the invention includes a sulfonium salt, an iodonium salt and a diazonium salt. Particularly, a diaryliodonium salt and a triarylsulfonium salt are preferably used. The onium salt is particularly preferably used together with an infrared absorbing agent having an absorption maximum in a wavelength range from 750 to 1,400 nm.

In addition, polymerization initiators described in Paragraph Nos. [0071] to [0129] of JP-A-2007-206217 are preferably used.

The polymerization initiators are preferably used individually or in combination of two or more thereof according to the invention.

The amount of the polymerization initiator used in the photosensitive layer according to the invention is preferably from 0.01 to 20% by weight, more preferably from 0.1 to 15% by weight, still more preferably from 1.0 to 10% by weight, based on the total solid content of the photosensitive layer. (B) Polymerizable compound

The polymerizable compound for use in the photosensitive layer according to the invention is an addition-polymerizable compound having at least one ethylenically unsaturated double bond and it is selected from compounds having at least one, preferably two or more, terminal ethylenically unsaturated double bonds. The polymerizable compound has a chemical form, for example, a monomer, a prepolymer, specifically, a dimer, a trimer or an oligomer, or a mixture thereof. Examples of the monomer include unsaturated carboxylic acids (for example, acrylic acid, methacrylic acid, itaconic acid, crotonic acid, isocrotonic acid or maleic acid) and esters or amides thereof. Preferably, esters of an unsaturated carboxylic acid with a polyhydric alcohol compound and amides of an unsaturated carboxylic acid with a polyvalent amine compound are used. An addition reaction product of an unsaturated carboxylic acid ester or amide having a nucleophilic substituent, for example, a hydroxy group, an amno group or a mercapto group, with a monofunctional or polyfunctional isocyanate or epoxy compound, or a dehydration condensation reaction product of the unsaturated carboxylic acid ester or amide with a monofunctional or polyfunctional carboxylic acid is also preferably used. Moreover, an addition reaction product of an unsaturated carboxylic acid ester or amide having an electrophilic substituent, for example, an isocyanate group or an epoxy group with a monofunctional or polyfunctional alcohol, amine or thiol, or a substitution reaction product of an unsaturated carboxylic acid ester or amide having a releasable substituent, for example, a halogen atom or a tosyloxy group with a monofunctional or polyfunctional alcohol, amine or thiol is also preferably used. In addition, compounds in which the unsaturated carboxylic acid described above is replaced by an unsaturated phosphonic acid, styrene, vinyl ether or the like can also be used.

Specific examples of the monomer, which is an ester of a polyhydric alcohol compound with an unsaturated carboxylic acid, include, as an acrylic acid ester, for example, ethylene glycol diacrylate, 1,3-butanediol diacrylate, tetramethylene glycol diacrylate, propylene glycol diacrylate, trimethylolpropane triacrylate, hexanediol diacrylate, tetraethylene glycol diacrylate, pentaerythritol tetraacrylate, sorbitol triacrylate, isocyanuric acid ethylene oxide (EO) modified triacrylate and polyester acrylate oligomer. As a methacrylic acid ester, for example, tetramethylene glycol dimethacrylate, neopentyl glycol dimethacrylate, trimethylolpropane trimethacrylate, ethylene glycol dimethacrylate, pentaerythritol trimethacrylate, bis[p-(3-methaeryloxy-2-hydroxypropoxy)phenyl]dimethylmethane and bis[p-(methacryloxyethoxy)-phenyl]dimethylmethane are exemplified. Specific examples of the monomer, which is an amide of a polyvalent amine compound with an unsaturated carboxylic acid, include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide and xylylene bismethacrylamide.

Urethane type addition-polymerizable compounds produced using an addition reaction between an isocyanate and a hydroxy group are also preferably used and specific examples thereof include vinylurethane compounds having two or more polymerizable vinyl groups per molecule obtained by adding a vinyl monomer containing a hydroxy group represented by formula (A) shown below to a polyisocyanate compound having two or more isocyanate groups per

molecule, described in JP-B-48-41708.

$$CH_2\text{-}C(R_4)COOCH_2CH(R_5)OH \qquad (A)$$

wherein $R_4$ and $R_5$ each independently represents H or $CH_3$.

Also, urethane acrylates described in JP-A-51-37193, JP-B-2-32293 and JP-B-2-16765, and urethane compounds having an ethylene oxide skeleton described in JP-B-58-49860, JP-B-56-17654, JP-B-62-39417 and JP-B-62-39418 are preferably used.

Details of the method of using the polymerizable compound, for example, selection of the structure, individual or combination use or an amount added, can be appropriately determined in accordance with the characteristic design of the final lithographic printing plate precursor. The polymerizable compound is used preferably in a range from 5 to 75% by weight, more preferably in a range from 25 to 70% by weight, particularly preferably in a range from 30 to 60% by weight, based on the total solid content of the photosensitive layer.

(C) Binder polymer

The photosensitive layer according to the invention contains a binder polymer. As the binder polymer, a polymer capable of holding the components of photosensitive layer on a support and capable of being removed by a developer is used. The binder polymer used includes, for example, a (meth)acrylic polymer, a polyurethane resin, a polyvinyl alcohol resin, a polyvinyl butyral resin, a polyvinyl formal resin, a polyamide resin, a polyester resin and an epoxy resin. In particular, a (meth)acrylic polymer, a polyurethane resin and a polyvinyl butyral resin are preferably used.

The term "(meth)acrylic polymer" as used herein means a copolymer containing as a polymerization component, (meth)acrylic acid or a (meth)acrylic acid derivative, for example, a (meth)acrylate (including, for example, an alkyl ester, aryl ester and allyl ester), (meth)acrylamide or a (meth)acrylamide derivative. The term "polyurethane resin" as used herein means a polymer formed by a condensation reaction of a compound having two or more isocyanate groups and a compound having two or more hydroxy groups. The term "polyvinyl butyral resin" as used herein means a polymer synthesized by a reaction (acetalization reaction) of polyvinyl alcohol obtained by partial or full saponification of polyvinyl acetate with butylaldehyde under an acidic condition and includes a polymer wherein an acid group or the like is introduced by a method of reacting the remaining hydroxy group in the polymer with a compound having the acid group or the like.

One preferred example of the binder polymer according to the invention is a copolymer containing a repeating unit having an acid group. Examples of the acid group include a carboxylic acid group, a sulfonic acid group, a phosphonic acid group, a phosphoric acid group and a sulfonamido group. Particularly, a carboxylic acid group is preferred. As the repeating unit having an acid group, a repeating unit derived from (meth)acrylic acid or a repeating unit represented by formula (I) shown below is preferably used.

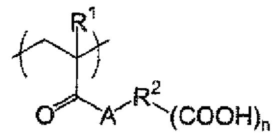

(I)

In formula (I), $R^1$ represents a hydrogen atom or a methyl group, $R^2$ represents a single bond or an n+1 valent connecting group, A represents an oxygen atom or $-NR^3-$, wherein $R^3$ represents a hydrogen atom or a monovalent hydrocarbon group having from 1 to 10 carbon atoms, and n represents an integer from 1 to 5.

The connecting group represented by $R^2$ in formula (I) is constructed from a hydrogen atom, a carbon atom, an oxygen atom, a nitrogen atom, a sulfur atom and a halogen atom and preferably contains from 1 to 80 atoms. Specific examples of the connecting group include an alkylene group, a substituted alkylene group, an arylene group and a substituted arylene group, The connecting group may have a structure wherein a plurality of such divalent groups is connected to each other via any of an amido bond, an ether bond, a urethane bond, a urea bond and an ester bond. $R^2$ is preferably a single bond, an alkylene group, a substituted alkylene group or a group having a structure wherein a plurality of alkylene groups and/or substituted alkylene groups is connected to each other via any of an amido bond, an ether bond, a urethane bond, a urea bond and an ester bond, particularly preferably a single bond, an alkylene group having from 1 to 5 carbon atoms, a substituted alkylene group having from 1 to 5 carbon atoms or a group having a structure wherein a plurality of alkylene groups each having from 1 to 5 carbon atoms and/or substituted alkylene groups each having from 1 to 5 carbon atoms is connected to each other via any of an amido bond, an ether bond, a urethane bond, a urea bond and an ester bond, and most preferably a single bond, an alkylene group having from 1 to 3 carbon atoms, a substituted alkylene group having from 1 to 3 carbon atoms or a group having a structure wherein a plurality of alkylene groups each having from 1 to 3 carbon atoms and/or substituted alkylene groups each having from 1 to 3

carbon atoms is connected to each other via any of an amido bond, an ether bond, a urethane bond, a urea bond and an ester bond.

Examples of the substituent include a monovalent non-metallic atomic group exclusive of a hydrogen atom, for example, a halogen atom (e.g., -F, -Br, -Cl or -I), a hydroxy group, an alkoxy group, an aryloxy group, a mercapto group, an acyl group, a carboxyl group and a conjugate base group thereof, an alkoxycarbonyl group, an aryloxycarbonyl group, a carbamoyl group, an aryl group, an alkenyl group and an alkynyl group.

$R^3$ is preferably a hydrogen atom or a hydrocarbon group having from 1 to 5 carbon atoms, more preferably a hydrogen atom or a hydrocarbon group having from 1 to 3 carbon atoms, and particularly preferably a hydrogen atom or a methyl group. n is preferably from 1 to 3, more preferably 1 or 2, and particularly preferably 1.

A ratio (% by mole) of the copolymerization component having a carboxylic acid group in the total copolymerization components of the binder polymer is preferably from 1 to 70% in view of developing property. Considering good compatibility between the developing property and printing durability, it is more preferably from 1 to 50%, and particularly preferably from 1 to 30%.

It is preferred that the binder polymer for use in the invention further contain a crosslinkable group. The term "crosslinkable group" as used herein means a group capable of crosslinking the binder polymer in the process of a radical polymerization reaction which is caused in the photosensitive layer, when the lithographic printing plate precursor is exposed to light. The crosslinkable group is not particularly restricted as long as it has such a function and includes, for example, an ethylenically unsaturated bonding group, an amino group or an epoxy group as a functional group capable of undergoing an addition polymerization reaction. Also, a functional group capable of forming a radical upon irradiation with light may be used and such a crosslinkable group includes, for example, a thiol group and a halogen atom. Among them, the ethylenically unsaturated bonding group is preferred. The ethylenically unsaturated bonding group preferably includes a styryl group, a (meth)acryloyl group and an allyl group.

In the binder polymer, for example, a free radical (a polymerization initiating radical or a propagating radical in the process of polymerization of the polymerizable compound) is added to the crosslinkable functional group to cause an addition-polymerization between the polymers directly or through a polymerization chain of the polymerizable compound, as a result, crosslinking is formed between the polymer molecules to effect curing. Alternatively, an atom (for example, a hydrogen atom on the carbon atom adjacent to the functional crosslinkable group) in the polymer is withdrawn by a free radical to produce a polymer radical and the polymer radicals combine with each other to form crosslinking between the polymer molecules to effect curing.

The content of the crosslinkable group (content of radical-polymerizable unsaturated double bond determined by iodine titration) in the binder polymer is preferably from 0.01 to 10.0 mmol, more preferably from 0.05 to 5.0 mmol, and particularly preferably from 0.1 to 2.0 mmol, per g of the binder polymer.

The binder polymer for use in the invention may contain a polymerization unit of an alkyl (meth)acrylate or aralkyl (meth)acrylate, a polymerization unit of (meth)acrylamide or a derivative thereof, a polymerization unit of an α-hydroxymethylacrylate or a polymerization unit of a styrene derivative, in addition to the polymerization unit having an acid group and the polymerization unit having a crosslinkable group described above. The alkyl group in the alkyl (meth)acrylate is preferably an alkyl group having from 1 to 5 carbon atoms and more preferably a methyl group. The aralkyl (meth)acrylate includes, for example, benzyl (meth)acrylate. The (meth)acrylamide derivative includes, for example, N-isopropylacrylamide, N-phertylmethaerylamide, N-(4-methoxycarbonylphenyl)methacrylamide, N,N-dimethylacrylamide and morpholinoacrylamide. The α-hydroxymethylacrylate includes, for example, ethyl α-hydroxymethylacrylate and cyclohexyl α-hydroxymethylacrylate. The styrene derivative includes, for example, styrene and 4-tert-butylstyrene.

Preferable examples of the polyurethane resin according to the invention include polyurethane resins described in Paragraph Nos. [0099] to [0210] of JP-A-2007-187836, Paragraph Nos. [0019] to [0100] of JP-A-2008-276155, Paragraph Nos. [0018] to [0107] of JP-A-2005-250438, Paragraph Nos. [0021] to [0083] of JP-A-2005-250158.

Preferable examples of the polyvinyl butyral resin according to the invention include polyvinyl butyral resins described in Paragraph Nos. [0006] to [0013] of JP-A-2001-75279.

A part of the acidic groups in the binder polymer may be neutralized with a basic compound. The basic compound includes, for example, a basic nitrogen-containing compound, an alkali metal hydroxide or a quaternary ammonium hydroxide.

The binder polymer preferably has a weight average molecular weight of 5,000 or more, more preferably from 10,000 to 300,000, and a number average molecular weight of 1,000 or more, more preferably from 2,000 to 250,000. The polydispersity (weight average molecular weight/number average molecular weight) is preferably from 1.1 to 10.

The binder polymers may be used individually or in combination of two or more thereof. The content of the binder polymer is preferably from 5 to 75% by weight, more preferably from 10 to 70% by weight, still more preferably From 10 to 60% by weight, based on the total solid content of the photosensitive layer, from the standpoint of good strength of the image area and good image-forming property.

The total content of the polymerizable compound and the binder polymer is preferably 80% by weight or less

based on the total solid content of the photosensitive layer. When it exceeds 80% by weight, decrease in the sensitivity and deterioration in the developing property may be caused sometimes. The total content thereof is more preferably from 35 to 75% by weight.

(Other components of photosensitive layer)

It is preferred that the photosensitive layer according to the invention contain a sensitizing dye. The sensitizing dye can be used without particular limitation as far as it absorbs light at the image exposure to form the excited state and provides energy to the polymerization initiator described hereinbefore with electron transfer, energy transfer or heat generation thereby increasing the polymerization initiation function. In particular, a sensitizing dye having an absorption maximum in a wavelength range from 300 to 450 nm or from 750 to 1,400 nm is preferably used.

Examples of the sensitizing dye having an absorption maximum in a wavelength range from 300 to 450 nm include merocyanine dyes, benzopyranes, coumarins, aromatic ketones and anthracenes.

Of the sensitizing dyes having an absorption maximum in a wavelength range from 300 to 450 nm, a dye represented by formula (IX) shown below is more preferred in view of high sensitivity.

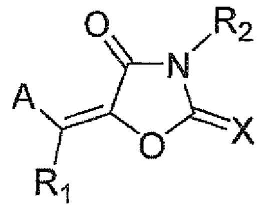

(IX)

In formula (IX), A represents an aromatic cyclic group which may have a substituent or a heterocyclic group which may have a substituent, X represents an oxygen atom, a sulfur atom or $=N(R_3)$, and $R_1$, $R^2$ and $R_3$ each independently represents a monovalent non-metallic atomic group, or A and $R_1$ or $R^2$ and $R_3$ may be combined with each other to form an aliphatic or aromatic ring.

The monovalent non-metallic atomic group represented by any one of $R_1$, $R^2$ and $R_3$ in formula (IX) preferably includes a hydrogen atom, a substituted or unsubstituted alkyl group, a substituted or unsubstituted alkenyl group, a substituted or unsubstituted aryl group, a substituted or unsubstituted aromatic heterocyclic residue, a substituted or unsubstituted alkoxy group, a substituted or unsubstituted alkylthio group, a hydroxy group and a halogen atom.

The aromatic cyclic group which may have a substituent and heterocyclic group which may have a substituent represented by A in formula (IX) are same as the substituted or unsubstituted aryl group and substituted or unsubstituted aromatic heterocyclic residue described for any one of $R_1$, $R^2$ and $R_3$, respectively.

As specific examples of the sensitizing dye, compounds described in Paragraph Nos. [0047] to [0053] of JP-A-2007-58170, Paragraph Nos. [0036] to [0037] of JP-A-2007-93866 and Paragraph Nos. [0042] to [0047] of JP-A-2007-72816 are preferably used.

Further, sensitizing dyes described in JP-A-2007-171406, JP-A-2007-206216, JP-A-2007-206217, JP-A-2007-225701, JP-A-2007-225702, JP-A-2007-316582 and JP-A-2007-328243 are also preferably used.

The sensitizing dye having an absorption maximum in a wavelength range from 750 to 1,400 (hereinafter, also referred to as an "infrared absorbing agent") is described below. The infrared absorbing agent used is preferably a dye or pigment.

As the dye, commercially available dyes and known dyes described in literatures, for example, Senryo Binran (Dye Handbook) compiled by The Society of Synthetic Organic Chemistry, Japan (1970) can be used. Specifically, the dyes includes azo dyes, metal complex azo dyes, pyrazolone azo dyes, naphthoquinone dyes, anthraquinone dyes, phthalocyanine dyes, carbonium dyes, quinoneimine dyes, methine dyes, cyanine dyes, squarylium dyes, pyrylium salts and metal thiolate complexes.

Of the dyes, cyanine dyes, squarylium dyes, pyrylium dyes, nickel thiolate complexes and indolenine cyanine dyes are particularly preferred. Further, cyanine dyes and indolenine cyanine dyes are more preferred. As particularly preferable examples of the dye, cyanine dyes represented by formula (a) shown below are exemplified.

Formula (a):

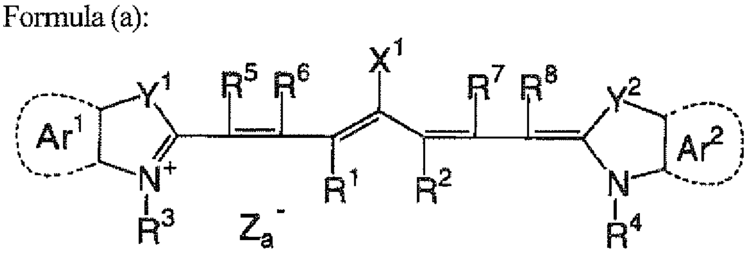

In formula (a), $X^1$ represents a hydrogen atom, a halogen atom, $-NPh_2$, $X^2$-$L^1$ or a group shown below. $X^2$ represents an oxygen atom, a nitrogen atom or a sulfur atom, $L^1$ represents a hydrocarbon group having from 1 to 12 carbon atoms, an aromatic cyclic group containing a hetero atom (a nitrogen atom, a sulfur atom, an oxygen atom, a halogen atom or a selenium atom) or a hydrocarbon group having from 1 to 12 carbon atoms and containing a hetero atom. $Xa^-$ has the same meaning as $Za^-$ defined hereinafter. $R^a$ represents a hydrogen atom or a substituent selected from an alkyl group, an aryl group, a substituted or unsubstituted amino group and a halogen atom.

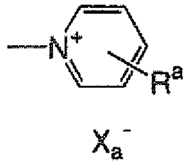

$R^1$ and $R^2$ each independently represents a hydrocarbon group having from 1 to 12 carbon atoms. In view of the preservation stability of a coating solution for photosensitive layer, it is preferred that $R^1$ and $R^2$ each represent a hydrocarbon group having two or more carbon atoms. It is also preferred that $R^1$ and $R^2$ be combined with each other to form a ring. When the ring is formed, a 5-membered or 6-membered ring is particularly preferred.

$Ar^1$ and $Ar^2$, which may be the same or different, each represents an aromatic hydrocarbon group which may have a substituent. Preferable examples of the aromatic hydrocarbon group include groups derived from a benzene ring and a naphthalene ring. Preferable examples of the substituent include a hydrocarbon group having 12 or less carbon atoms, a halogen atom and an alkoxy group having 12 or less carbon atoms. $Y^1$ and $Y^2$, which may be the same or different, each represents a sulfur atom or a dialkylmethylene group having 12 or less carbon atoms. $R^3$ and $R^4$, which may be the same or different, each represents a hydrocarbon group having 20 or less carbon atoms, which may have a substituent. Preferable examples of the substituent include an alkoxy group having 12 or less carbon atoms, a carboxyl group and a sulfo group. $R^5$, $R^6$, $R^7$ and $R^8$, which may be the same or different, each represents a hydrogen atom or a hydrocarbon group having 12 or less carbon atoms. In view of the availability of raw materials, a hydrogen atom is preferred. $Za^-$ represents a counter anion. However, $Za^-$ is not necessary when the cyanine dye represented by formula (a) has an anionic substituent in the structure thereof and neutralization of charge is not needed. Preferable examples of the counter ion for $Za^-$ include a halide ion, a perchlorate ion, a tetrafluoroborate ion, a hexafluorophosphate ion and a sulfonate ion, and particularly preferable examples thereof include a perchlorate ion, a hexafluorophosphate ion and an arylsulfonate ion in view of the preservation stability of a coating solution for photosensitive layer.

Specific examples of the cyanine dye represented by formula (a), which can be suitably used in the invention, include compounds described in Paragraph Nos. [0017] to [0019] of JP-A-2001-133969, Paragraph Nos. [0016] to [0021] of JP-A-2002-23360 and Paragraph Nos. [0012] to [0037] of JP-A-2002-40638. Preferably, compounds described in Paragraph Nos. [0034] to [0041] of JP-A-2002-278057 and Paragraph Nos. [0080] to [0086] of JP-A-2008-195018 are exemplified. Particularly preferably, compounds described in Paragraph Nos. [0035] to [0043] of JP-A-2007-90850 are exemplified.

Further, compounds described in Paragraph Nos. [0008] to [0009] of JP-A-5-5005 and Paragraph Nos. [0022] to [0025] of JP-A-2001-222101 are also preferably used.

The infrared absorbing dyes may be used only one kind or two or more kinds in combination. Also, the infrared absorbing dye may be used together with an infrared absorbing agent other than the infrared absorbing dye, for example, a pigment. As the pigment, compounds described in Paragraph Nos. [0072] to [0076] of JP-A-2008-195018 are preferably used.

Examples of the pigment for use in the invention include commercially available pigments and pigments described in Colour Index (C.I.), Saishin Ganryo Binran (Handbook of the Newest Pigments) compiled by Pigment Technology Society of Japan (1977), Saishin Ganryo Oyou Gijutsu (Newest Application on Technologies for Pigment), CMC Publishing Co., Ltd. (1986) and Insatsu Ink Gijutsu (Printing Ink Technology), CMC Publishing Co., Ltd. (1984).

The amount of the sensitizing dye added is preferably from 0.05 to 30 parts by weight, more preferably from 0.1 to 20 parts by weight, particularly preferably from 0.2 to 10 parts by weight, per 100 parts by weight of the total solid content of the photosensitive layer.

The photosensitive layer preferably contains a chain transfer agent. The chain transfer agent is defined, for example, in Kobunshi Jiten (Polymer Dictionary), Third Edition, pages 683 to 684, edited by The Society of Polymer Science, Japan (2005). As the chain transfer agent, for example, compounds having SH, PH, SiH or GeH in their molecules are used. The compound donates a hydrogen to a low active radical species to generate a radical or is oxidized and then deprotonized to generate a radical. In the photosensitive layer according to the invention, a thiol compound (for example, a 2-mercaptobenzimidazole, a 2-mercaptobenzothiazole, a 2-mercaptobenzoxazole, a 3-mercaptotriazole or a 5-mercaptotetrazole) is preferably used.

The amount of the chain transfer agent added is preferably from 0.01 to 20 parts by weight, more preferably from 1 to 10 parts by weight, particularly preferably from 1 to 5 parts by weight, per 100 parts by weight of the total solid content of the photosensitive layer.

Into the photosensitive layer, various additives can be further incorporated, if desired. Examples of the additive include a surfactant for progressing the developing property and improving the surface state of coated layer, a microcapsule for providing good compatibility between developing property and printing durability, a hydrophilic polymer for improving the developing property and dispersion stability of microcapsule, a coloring agent or print-out agent for visually distinguishing the image area from the non-image area, a polymerization inhibitor for preventing undesirable thermal polymerization of the polymerizable compound during the production and preservation of the photosensitive layer, a higher fatty acid derivative for avoiding polymerization inhibition due to oxygen, a fine inorganic particle for increasing strength of the cured layer in the image area, a hydrophilic low molecular weight compound for improving the developing property, a co-sensitizer for increasing sensitivity, and a plasticizer for improving plasticity. As the additives, known compounds, for example, compounds described in Paragraph Nos. [0161] to [0215] of JP-A-2007-206217 are used.

Further, compounds, for example, microcapsules or microgels described in Paragraph Nos. [0196] to [0275] of JP-A-2009-29124 may be used.

<Formation of photosensitive layer>

The photosensitive layer according to the invention is formed by dispersing or dissolving each of the necessary constituting components described above in a solvent to prepare a coating solution and coating the solution. The solvent used include, for example, methyl ethyl ketone, ethylene glycol monomethyl ether, 1-methoxy-2-propanol, 2-methoxyethyl acetate, 1-methoxy-2-propyl acetate and γ-butyrolactone, but the invention should not be construed as being limited thereto. The solvents may be used individually or as a mixture. The solid content concentration of the coating solution is preferably from 1 to 50% by weight.

The coating amount (solid content) of the photosensitive layer after the coating and drying is preferably from 0.3 to 3.0 g/m$^2$. Various methods can be used for the coating. Examples of the method include bar coater coating, spin coating, spray coating, curtain coating, dip coating, air knife coating, blade coating and roll coating.

[Protective layer]

In the lithographic printing plate precursor according to the invention, a protective layer (oxygen-blocking layer) is preferably provided on the photosensitive layer in order to prevent diffusion and penetration of oxygen which inhibits the polymerization reaction at the time of exposure. As a material for use in the protective layer, any water-soluble polymer and water-insoluble polymer can be appropriately selected to use. The polymers may be used in combination of two or more thereof, if desired. Specifically, for example, polyvinyl alcohol, a modified polyvinyl alcohol, polyvinyl pyrrolidone, a water-soluble cellulose derivative and poly(meth)acrylonitrile are exemplified. Among them, a water-soluble polymer compound relatively excellent in crystallizability is preferably used. Specifically, when polyvinyl alcohol is used as a main component, the particularly preferred results can be obtained in the fundamental characteristics, for example, oxygen-blocking property and removability by development.

Polyvinyl alcohol for use in the protective layer may be partially substituted with ester, ether or acetal as long as it contains unsubstituted vinyl alcohol units for achieving the necessary oxygen-blocking property and water solubility. Also, polyvinyl alcohol may partly have other copolymer component. Polyvinyl alcohol is obtained by hydrolysis of polyvinyl acetate. As the polyvinyl alcohol, those having a hydrolysis degree of 69.0 to 100% by mole and a polymerization repeating unit number of 300 to 2,400 are exemplified. Specific examples thereof include PVA-102, PVA-103, PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-235, PVA-217EE, PVA-217E, PVA-220E, PVA-224E, PVA-403, PVA-405, PVA-420, PVA-424H, PVA-505, PVA-617, PVA-613, PVA-706 and L-8 (produced by Kuraray Co., Ltd.). The polyvinyl alcohols can be used individually or as a mixture. The content of polyvinyl alcohol in the protective layer

is preferably from 20 to 95% by weight, and more preferably from 30 to 90% by weight.

Also, known modified polyvinyl alcohol can be preferably used. Particularly, an acid-modified polyvinyl alcohol having a carboxylic acid group or a sulfinic acid group is preferably used. Specifically, modified polyvinyl alcohols described in JP-A-2005-250216 and JP-A-2006-25913 are preferably exemplified.

When the polyvinyl alcohol is used as a mixture with other material, as the other material mixed, a modified polyvinyl alcohol, polyvinyl pyrrolidone or a modified product thereof is preferred from the viewpoint of the oxygen-blocking property and removability by development. The content thereof in the protective layer is ordinarily from 3.5 to 80% by weight, preferably from 10 to 60% by weight, and more preferably from 15 to 30% by weight.

As other component of the protective layer, glycerin, dipropylene glycol or the like can be added in an amount of several % by weight based on the water-soluble polymer compound to provide flexibility. Further, an anionic surfactant, for example, sodium alkylsulfate or sodium alkylsulfonate, an amphoteric surfactant, for example, alkylaminocarboxylate and alkylaminodicarboxylate, or a nonionic surfactant, for example, polyoxyethylene alkyl phenyl ether can be added in an amount of several % by weight based on the water-soluble polymer compound.

Further, it is also preferred to incorporate an inorganic stratiform compound into the protective layer for the purpose of improving the oxygen-blocking property and property for protecting the surface of photosensitive layer. Of the inorganic stratiform compounds, fluorine based swellable synthetic mica, which is a synthetic inorganic stratiform compound, is particularly useful.

The coating amount of the protective layer is preferably in a range from 0.05 to 10 $g/m^2$ in terms of the coating amount after drying. When the protective layer contains the inorganic stratiform compound, it is more preferably in a range from 0.1 to 5 $g/m^2$, and when the protective layer does not contain the inorganic stratiform compound, it is more preferably in a range from 0.5 to 5 $g/m^2$.

[Support]

The support for use in the lithographic printing plate precursor according to the invention is not particularly restricted as long as it is a dimensionally stable plate-like hydrophilic support. Particularly, an aluminum plate is preferred. In advance of the use of an aluminum plate, the aluminum plate is preferably subjected to a surface treatment, for example, roughening treatment or anodizing treatment. The roughening treatment of the surface of the aluminum plate is conducted by various methods and includes, for example, mechanical roughening treatment, electrochemical roughening treatment (roughening treatment of electrochemically dissolving the surface) and chemical roughening treatment (roughening treatment of chemically dissolving the surface selectively). With respect to the treatments, methods described in Paragraph Nos. [0241] to [0245] of JP-2007-206217 are preferably used.

The center line average roughness of the support is preferably from 0.10 to 1.2 $\mu$m. In the range described above, good adhesion property to a layer provided on the support, good printing durability and good satin resistance are achieved.

The color density of the support is preferably from 0.15 to 0.65 in terms of the reflection density value. In the range described above, good image-forming property by preventing halation at the image exposure and good aptitude for plate inspection after development are achieved.

The thickness of the support is preferably from 0.1 to 0.6 mm, more preferably from 0.1 to 0.4 mm, and still more preferably from 0.2 to 0.3 mm.

[Hydrophilizing treatment of support]

As for the lithographic printing plate precursor according to the invention, in order to increase hydrophilicity of the non-image area and to prevent printing stain, it is preferred to conduct hydrophilizing treatment of the surface of support.

The hydrophilizing treatment of the surface of support includes an alkali metal silicate treatment wherein the support is subjected to an immersion treatment or an electrolytic treatment in an aqueous solution, for example, of sodium silicate, a method of treating with potassium fluorozirconate and a method of treating with polyvinylphosphonic acid. An immersion treatment in an aqueous polyvinylphosphonic acid solution is preferably used.

[Backcoat layer]

A backcoat layer can be provided on the back surface of the support, if desired. The backcoat layer preferably includes, for example, a coating layer comprising an organic polymer compound described in JP-A-5-45885 and a coating layer comprising a metal oxide obtained by hydrolysis and polycondensation of an organic metal compound or an inorganic metal compound described in JP-A-6-35174. Among them, use of an alkoxy compound of silicon, for example, $Si(OCH_3)_4$, $Si(OC_2H_5)_4$, $Si(OC_3H_7)_4$ or $Si(OC_4H_9)_4$ is preferred since the starting material is inexpensive and easily

available.

[Method of preparing lithographic printing plate]

The lithographic printing plate precursor according to the invention is exposed imagewise and then subjected to development processing to prepare a lithographic printing plate.

<Image exposure>

The lithographic printing plate precursor is imagewise exposed with laser through a transparent original having a line image, a halftone dot image or the like, or imagewise exposed, for example, by scanning of laser beam based on digital data.

The wavelength of the exposure light source is preferably from 300 to 450 nm or from 750 to 1,400 nm. In case of exposing with light of 300 to 450 nm, the lithographic printing plate precursor having a photosensitive layer containing a sensitizing dye having an absorption maximum in the wavelength range is used. In case of exposing with light of 750 to 1,400 nm, the lithographic printing plate precursor containing an infrared absorbing agent which is a sensitizing dye having an absorption maximum in the wavelength range is used. As the light source of 300 to 450 nm, a semiconductor laser is preferably used. As the light source of 750 to 1,400 nm, a solid laser or semiconductor laser emitting an infrared ray is preferably used. The exposure mechanism may be any of an internal drum system, an external drum system and a flat bed system.

<Development processing>

In the method of preparing a lithographic printing plate according to the invention, the development processing is performed by processing with an aqueous solution (hereinafter, also referred to as a developer) having a buffer function.

According to a conventional developing process using the alkali developer, it is necessary that a protective layer is removed in a pre-water washing step, the alkali development is conducted, the alkali is removed by washing with water in a post-water washing step, gum solution treatment is conducted and drying is conducted in a drying step. On the contrary, in the development processing method according to the invention, it is possible to conduct the development and gum solution treatment at the same time by incorporating a surfactant or a water-soluble polymer compound into the aqueous solution having a buffer function. Thus, the post-water washing step is not particularly necessary, and after conducting the development and gum solution treatment with one solution, the drying step can be performed. Moreover, the pre-water washing step is also not particularly necessary and the removal of protective layer can also be conducted simultaneously with the development and gum solution treatment It is preferred that after the development and gum solution treatment, the excess developer be removed using a squeeze roller, followed by conducting drying.

A preferred embodiment of the method of preparing a lithographic printing plate according to the invention includes a method of preparing a lithographic printing plate comprising: a step of imagewise exposing a lithographic printing plate precursor comprising, in the following order, a support, an intermediate layer containing a copolymer containing a repeating unit derived from a monomer having a C log P value of 1.4 or less and containing a carbon-carbon unsaturated double bond through a covalent bond, an image-forming layer containing (A) a polymerization initiator, (B) a polymerizable compound and (C) a binder polymer and a protective layer; and a step of removing the protective layer and an unexposed area of the image-forming layer by processing the exposed lithographic printing plate precursor with an aqueous solution having a buffer function and not containing a water washing step.

In the above embodiment, the term "not containing a water washing step" means that any water washing step is not contained between the imagewise exposure step and the completion of the preparation of a lithographic printing plate through the development processing step. Specifically, according to the embodiment, a lithographic printing plate is prepared without undergoing a water washing step not only between the imagewise exposure step and the development processing step but also after the development processing step. The lithographic printing plate prepared is used for printing as it is.

The development processing of a lithographic printing plate precursor with the developer according to the invention is performed at temperature from 0 to 60°C, preferably from about 15 to about 40°C in a conventional manner, for example, by a method wherein the imagewise exposed lithographic printing plate precursor is immersed in the developer and rubbed with a brush or a method wherein the developer is sprayed to the imagewise exposed lithographic printing plate precursor and the lithographic printing plate precursor is rubbed with a brush.

The development processing according to the invention is preferably performed by an automatic development processor equipped with a supplying means for the developer and a rubbing member. An automatic development processor using a rotating brush roller as the rubbing member is particularly preferred. The number of the rotating brush rollers is preferably two or more. Further, the automatic development processor is preferably provided with a means for

removing the excess developer, for example, a squeeze roller, or a drying means, for example, a hot air apparatus, subsequently to the development processing means. Further, the automatic development processor may be provided with a pre-heating means for conducting pre-heating treatment of the lithographic printing plate precursor after image exposure prior to the development processing means.

The aqueous solution having a buffer function used in the invention includes an aqueous solution containing a pH buffer agent.

The pH buffer agent for use in the invention is not particularly limited as long as it exhibits the buffering action. In the invention, an alkaline buffer agent is preferably used. For example, (a) a carbonate ion and a hydrogen carbonate ion, (b) a borate ion, (c) a water-soluble amine compound and an ion of the amine compound, and combinations thereof are illustrated. Using the buffer agent, the developer exhibits a pH buffering action and is prevented from fluctuation of the pH even when it is used for a long period of time. As a result, the deterioration of developing property resulting from the fluctuation of pH, the occurrence of development scum and the like are restrained. The combination of a carbonate ion and a hydrogen carbonate ion is particularly preferred.

In order for a carbonate ion and a hydrogen carbonate ion to be present in the developer, a carbonate and a hydrogen carbonate may be added to the developer or a carbonate ion and a hydrogen carbonate ion may be generated by adding a carbonate or a hydrogen carbonate to the developer and then adjusting the pH. The carbonate or hydrogen carbonate used is not particularly restricted and it is preferably an alkali metal salt thereof Examples of the alkali metal include lithium, sodium and potassium and sodium is particularly preferred. The alkali metals may be used individually or in combination of two or more thereof.

In order for a borate ion to be present in the developer, a boric acid or a borate is added to the developer and then pH of the developer is adjusted using an alkali or using an alkali and an acid to generate an appropriate amount of the borate ion.

The boric acid or borate used is not particularly restricted. The boric acid includes, for example, ortho boric acid, metha boric acid or tetra boric acid, and preferably ortho boric acid and tetra boric acid. The borate includes an alkali metal salt thereof and an alkaline earth metal salt thereof, specifically, an orthobarate, a diborate, a methaborate, a tetraborate, a pentaborate and an octaborate, preferably an orthoborate and a tetraborate, and particularly preferably an alkali metal salt of tetraborate. The alkali metal salt of tetraborate includes, for example, sodium tetraborate, potassium tetraborate and lithium tetraborate, and particularly preferably sodium tetraborate. The borates may be used in combination of two or more thereof.

As the boric acid and borate for use in the invention, ortho boric acid, tetra boric acid and sodium tetraborate are particularly preferred. The boric acid and borate may be used in combination in the developer.

The ion of a water-soluble amine compound may be generated in an aqueous solution of the water-soluble amine compound. To the aqueous solution of water-soluble amine compound may be added an alkali or an acid. Alternatively, the ion of a water-soluble amine compound may be contained in an aqueous solution by adding a compound which is a salt of amine compound per se.

The water-soluble amine compound is not particularly restricted and preferably a water-soluble amine compound having a group capable of facilitating water solubility. The group capable of facilitating water solubility includes, for example, a carboxylic acid group, a sulfonic acid group, a sulfinic acid group, a phosphonic acid group and a hydroxy group. The water-soluble amine compound may have two or more groups capable of facilitating water solubility.

In case where the water solubility of the water-soluble amine compound is facilitated with a carboxylic acid group, a sulfonic acid group, a sulfinic acid group or a phosphonic acid group, the water-soluble amine compound corresponds to an amino acid. The amino acid is held in equilibrium in an aqueous solution and, for example, when the acid group is a carboxylic acid group, the equilibrium state is indicated as below. In the invention, the amino acid means State B shown below and an amino acid ion means State C shown below. A counter ion in State C is preferably a sodium ion or a potassium ion.

Equilibrium state of amino acid (case wherein acid group is carboxylic acid group)

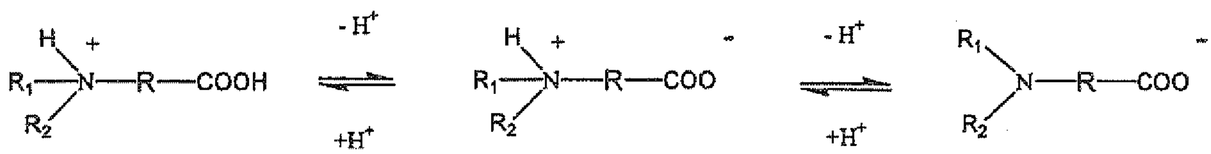

State A State B State C

wherein, for example, $R_1$ and $R_2$ each independently represents a hydrogen atom, an alkyl group, an aryl group or the like, and R represents a connecting group.

Specific examples of the water-soluble amine compound having a carboxylic acid group, a sulfonic acid group or a sulfinic acid group include an amino acid, for example, glycine, iminodiacatic acid, lysine, threonine, serine, asparaginic acid, parahydroxyphenyl glycine, dihydroxyethyl glycine, alanine, anthranilic acid or tryptophan, sulfamic acid, cyclohexylsulfamic acid, an aliphatic amine sulfonic acid, for example, taurine, and an aliphatic amine sulfinic acid, for example, aminoethanesulfinic acid. Among them, glycine and iminodiacetic acid are preferred.

Specific examples of the water-soluble amine compound having a phosphonic acid group (including a phosphinic acid group) include 2-aminoethylphosphonic acid, 1-aminoethane-1,1-diphosphonic acid, 1-amino-1-phenylinethane-1,1-diphosphonic acid, 1-dimethylaminoethane-1,1-diphosphonic acid and ethylenediaminopentamethylenephosphonic acid. Particularly, 2-aminoethylphosphonic acid is preferred.

The water-soluble amine compound having a hydroxy group as the group capable of facilitating water solubility means an alkylamine (State B shown below) having a hydroxy group in its alkyl group and its ion means an ammonium ion (State A shown below) of the amino group.

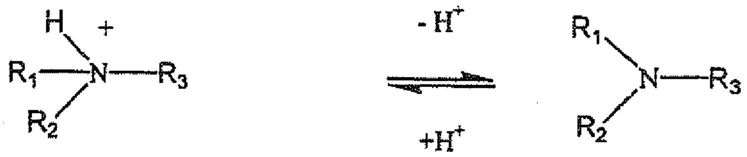

State A State B

wherein, for example, $R_1$, $R_2$ and $R_3$ each independently represents a hydrogen atom, an alkyl group, an aryl group or the like, provided that at least one of $R_1$, $R_2$ and $R_3$ represents an alkyl group having a hydroxy group.

Specific examples of the water-soluble amine compound having a hydroxy group include monoethanol amine, diethanol amine, trimethanol amine, triethanol amine, tripropanol amine and triisopropanol amine. Among them, triethanol amine and diethanol amine are preferable. A counter ion of the ammonium ion is preferably a chloride ion.

The alkali for use in the adjustment of pH described above includes, for example, sodium hydroxide, potassium hydroxide, lithium hydroxide, sodium carbonate, potassium carbonate, ammonium carbonate, sodium hydrogen carbonate, potassium hydrogen carbonate, ammonium hydrogen carbonate, an organic alkali agent and combinations thereof. The acid for use in the adjustment of pH includes, for example, an inorganic acid, for example, hydrochloric acid, sulfuric acid or a nitric acid. By adding such an alkali or acid, the pH can be finely adjusted.

When the combination of a carbonate ion and a hydrogen carbonate ion is adopted as the pH buffer agent, the total amount of the carbonate ion and hydrogen carbonate ion is preferably from 0.05 to 5 mole/l, more preferably from 0.1 to 2 mole/l, particularly preferably from 0.2 to 1 mole/l, based on the total amount of the aqueous solution. When the total amount is 0.05 mole/l or more, developing property and processing ability are not degraded. When the total amount is 5 mole/l or less, precipitates and crystals hardly generate and since gelation at neutralization of waste liquid of the developer hardly occur, treatment of the waste liquid can be carried out without trouble.

For the purpose of finely adjusting the alkali concentration or aiding dissolution of the photosensitive layer in the non-image area, an alkali agent, for example, an organic alkali agent may be supplementally used together. Examples of the organic alkali agent include monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, pyridine and tetramethylammonium hydroxide. The supplementary alkali agents may be used individually or in combination of two or more thereof.

When the borate ion is adopted as the pH buffer agent, the total amount of the borate ion is preferably from 0.05 to 5 mole/l, more preferably from 0.1 to 2 mole/l, particularly preferably from 0.2 to 1 mole/l, based on the total amount of the aqueous solution. When the total amount of borate ion is 0.05 mole/l or more, developing property and processing ability are not degraded. On the other hand, when the total amount of borate ion is 5 mole/l or less, precipitates and crystals hardly generate and since gelation at neutralization of the waste liquid hardly occur, treatment of the waste liquid can be carried out without trouble.

When the water-soluble amine compound and an ion of the amine compound are adopted as the pH buffer agent, the total amount of the water-soluble amine compound and ion of the amine compound is preferably from 0.01 to 1 mole/l, more preferably from 0.03 to 0.7 mole/l, particularly preferably from 0.05 to 0.5 mole/l, based on the total amount of the aqueous solution. When the total amount of water-soluble amine compound and ion of the amine compound is in the range described above, developing property and processing ability are not degraded and treatment of the waste liquid can be easily carried out.

Specific examples of the aqueous solution having a buffer function are set for the below, but the invention should not be construed as being limited thereto. Specifically, maleic acid/Tris/sodium hydroxide buffer solution, hydrogen disodium phosphate/dihydrogen sodium phosphate buffer solution, dihydrogen potassium phosphate/sodium hydroxide buffer solution, 2,4,6-trimethylpyridine/hydrochloric acid buffer solution, triethanolamine hydrochloride/sodium hydroxide buffer solution, sodium 5,5-diethylbarbiturate/hydrochloric acid buffer solution, N-ethylmorpholinelhydrochloric acid buffer solution, sodium pyrrophosphate/hydrochloric acid buffer solution, Tris/hydrochloric acid buffer solution, Bicine/sodium hydroxide buffer solution, 2-amino-2-methylpropane-1,3-diol/hydrochloric acid buffer solution, diethanolamine/hydrochloric acid buffer solution, potassium p-phenolsulfonate/sodium hydroxide buffer solution, boric acid/sodium hydroxide buffer solution, sodium borate/hydrochloric acid buffer solution, ammonia/ammonium chloride buffer solution, glycine/sodium hydroxide buffer solution, sodium carbonate/sodium hydrogen carbonate buffer solution, sodium borate/sodium hydroxide buffer solution, sodium hydrogen carbonate/sodium hydroxide buffer solution, disodium hydrogen phosphate/sodium hydroxide buffer solution, sodium hydroxide/potassium chloride buffer solution, citric acid/disodium hydrogen phosphate buffer solution, piperazine dihydrochloride/glycylglycine/sodium hydroxide buffer solution, citric acid monohydrate/potassium dihydrogen phosphate/boric acid/diethylbarbituric acid/sodium hydroxide buffer solution and boric acid/citric acid/sodium phosphate dodecahydrate buffer solution are exemplified.

From the standpoint of developing property, sodium 5,5-diethylbarbiturate/hydrochloric acid buffer solution, Tris/hydrochloric acid buffer solution, 2-amino-2-methylpropane-1,3-diol/hydrochloric acid buffer solution, diethanolamine/hydrochloric acid buffer solution, potassium p-phenolsulfonate/sodium hydroxide bluffer solution, boric acid/sodium hydroxide buffer solution, sodium borate/hydrochloric acid buffer solution, ammonia/ammonium chloride buffer solution, glycine/sodium hydroxide buffer solution, sodium carbonate/sodium hydrogen carbonate buffer solution, sodium borate/sodium hydroxide buffer solution, sodium hydrogen carbonate/sodium hydroxide buffer solution, disodium hydrogen phosphate/sodium hydroxide buffer solution, sodium hydroxide/potassium chloride buffer solution, piperazine dihydrochloride/glycylglycine/sodium hydroxide buffer solution, citric acid monohydrate/potassium dihydrogen phosphate/boric acid/diethylbarbituric acid/sodium hydroxide buffer solution and boric acid/citric acid/sodium phosphate dodecahydrate buffer solution are preferred, and potassium p-phenolsulfonate/sodium hydroxide buffer solution, boric acid/sodium hydroxide buffer solution, ammonia/ammonium chloride buffer solution, glycine/sodium hydroxide buffer solution, sodium carbonate/sodium hydrogen carbonate buffer solution, sodium borate/sodium hydroxide buffer solution, sodium hydrogen carbonate/sodium hydroxide buffer solution, disodium hydrogen phosphate/sodium hydroxide buffer solution, sodium hydroxide/potassium chloride buffer solution, piperazine dihydrochloride/glycylglycine/sodium hydroxide buffer solution, citric acid monohydrate/potassium dihydrogen phosphate/boric acid/diethylbarbituric acid/sodium hydroxide buffer solution and boric acid/citric acid/sodium phosphate dodecahydrate buffer solution are more preferred.

The developer for use in the development processing is preferably an aqueous solution containing mainly water (containing 60% by weight or more of water) as the medium. Further, an aqueous solution containing a surfactant (for example, an anionic, nonionic, cationic or amphoteric surfactant) or an aqueous solution containing a water-soluble polymer compound is preferred. An aqueous solution containing both the surfactant and the water-soluble polymer compound is also preferred. The pH of the developer is preferably from 6 to 11, more preferably from 6 to 10.5, and particularly preferably from 7.5 to 10.3.

The anionic surfactant for use in the developer is not particularly limited and includes, for example, fatty acid salts, abietic acid salts, hydroxyalkanesulfonic acid salts, alkanesulfonic acid salts, dialkylsulfosuccinic acid salts, straight-chain alkylbenzenesulfonic acid salts, branched alkylbenzenesulfonic acid salts, alkylnaphthalenesulfonic acid salts, alkyldiphenylether (di)sulfonic acid salts, alkylphenoxy polyoxyethylene alk-ylsulfonic acid salts, polyoxyethylene alkylsulfophenyl ether salts, N-alkyl-N-oleyltaurine sodium salt, N-alkylsulfosuccinic acid monoamide disodium salts, petroleum sulfonic acid salts, sulfated castor oil, sulfated beef tallow oil, sulfate ester slats of fatty acid alkyl ester, alkyl sulfate ester salts, polyoxyethylene alkyl ether sulfate ester salts, fatty acid monoglyceride sulfate ester salts, polyoxyethylene alkyl phenyl ether sulfate ester salts, polyoxyethylene styryl phenyl ether sulfate ester salts, alkyl phosphate ester salts, polyoxyethylene alkyl ether phosphate ester salts, polyoxyethylene alkyl phenyl ether phosphate ester salts, partially saponified products of styrene-maleic anhydride copolymer, partially saponified products of olefin-maleic anhydride copolymer and naphthalene sulfonate formalin condensates. Of the compounds, alkylbenzenesulfonic acid salts, alkylnaphthalenesulfonic acid salts and alkyldiphenylether (di)sulfonic acid salts are particularly preferably used.

The cationic surfactant for use in the developer is not particularly limited and conventionally known cationic surfactants can be used. Examples of the cationic surfactant include alkylamine salts, alkylimidazolinium salts, quaternary ammonium salts, polyoxyethylene alkyl amine salts and polyethylene polyamine derivatives.

The nonionic surfactant for use in the developer is not particularly limited and includes, for example, polyethylene glycol type higher alcohol ethylene oxide adducts, alkylphenol ethylene oxide adducts, alkylnaphthol ethylene oxide adducts, phenol ethylene oxide adducts, naphthol ethylene oxide adducts, fatty acid ethylene oxide adducts, polyhydric alcohol fatty acid ester ethylene oxide adducts, higher alkylamine ethylene oxide adducts, fatty acid amide ethylene oxide adducts, ethylene oxide addacts of fat, polypropylene glycol ethylene oxide adducts, dimethylsiloxane-ethylene oxide block copolymers, dimethylsiloxane-(propylene oxide-ethylene oxide) block copolymers, fatty acid esters of polyhydric alcohol type glycerol, fatty acid esters of pentaerythritol, fatty acid esters of sorbitol and sorbitan, fatty acid esters of sucrose, alkyl ethers of polyhydric alcohols and fatty acid amides of alkanolamines. Of the compounds, those having an aromatic ring and an ethylene oxide chain are preferred and alkyl-substituted or unsubstituted phenol ethylene oxide adducts and alkyl-substituted or unsubstituted naphthol ethylene oxide adducts are more preferred.

The amphoteric surfactant for use in the developer is not particularly limited and includes, for example, amine oxide type, for example, alkyldimethylamine oxide, betaine type, for example, alkyl betaine, and amino acid type, for example, sodium salt of alkylamino fatty acid. In particular, alkyldimethylamine oxide which may have a substituent, alkyl carboxy betaine which may have a substituent and alkyl sulfo betaine which may have a substituent are preferably used. Specific examples of the amphoteric surfactant include compounds represented by formula (2) in Paragraph No. [0256] of JP-A-2008-203359, compounds represented by formulae (I), (II) and (VI) in Paragraph Nos. [0028] to [0030] of JP-A-2008-276166 and compounds described in Paragraph Nos. [0022] to [0029] of JP-A-2009-47927.

Two or more of the surfactants may be used in combination. The content of the surfactant in the developer is preferably from 0.01 to 20% by weight, and more preferably from 0.1 to 10% by weight.

The water-soluble polymer compound for use in the developer includes, for example, soybean polysaccharide, modified starch, gum arabic, dextrin, a cellulose derivative (for example, carboxymethyl cellulose, carboxyethyl cellulose or methyl cellulose) or a modified product thereof, pllulan, polyvinyl alcohol or a derivative thereof, polyvinyl pyrrolidone, polyvinylsulfonic acid or a salt thereof, polystyrenesulfonic acid or a salt thereof, polyacrylamide, an acrylamide copolymer, a vinyl methyl ether/maleic anhydride copolymer, a vinyl acetate/maleic anhydride copolymer and a styrene/maleic anhydride copolymer.

As the soybean polysaccharide, known soybean polysaccharide can be used. For example, as a commercial product, SOYAFIVE (produced by Fuji Oil Co., Ltd.) is available and various grade products can be used. The soybean polysaccharide preferably used is that having viscosity in a range from 10 to 100 mPa/sec in the 10% by weight aqueous solution thereof.

As the modified starch, known modified starch can be used. The modified starch can be prepared, for example, by a method wherein starch, for example, of corn, potato, tapioca, rice or wheat is decomposed, for example, with an acid or an enzyme to an extent that the number of glucose residue per molecule is from 5 to 30 and then oxypropylene is added thereto in an alkali.

Two or more of the water-soluble polymer compounds may be used in combination. The content of the water-soluble polymer compound in the developer is preferably from 0.1 to 20% by weight, and more preferably from 0.5 to 10% by weight.

The developer may contain an organic solvent. As the organic solvent, for example, an aliphatic hydrocarbon (e.g., hexane, heptane, Isopar E, Isopar H, Isopar G (produced by Esso Chemical Co., Ltd.)), an aromatic hydrocarbon (e.g., toluene or xylene), a halogenated hydrocarbon (methylene dichloride, ethylene dichloride, trichlene or monochlorobenzene) or a polar solvent is exemplified. Examples of the polar solvent include an alcohol (e.g., methanol, ethanol, propanol, isopropanol, 1-butanol, 1-pentanol, 1-hexanol, 1-heptanol, 1-octanol, 2-octanol, 2-ethyl-1-hexanol, 1-nonanol, 1-decanol, benzyl alcohol, ethylene glycol monomethyl ether, 2-ethyoxyethanol, diethylene glycol monoethyl ether, diethylene glycol monohexyl ether, triethylene glycol monomethyl ether, propylene glycol monomethyl ether, propylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, propylene glycol monophenyl ether, methyl phenyl carbinol, n-amyl alcohol or methylamyl alcohol), a ketone (e.g., acetone, methyl ethyl ketone, ethyl butyl ketone, methyl isobutyl ketone or cyclohexanone), an ester (e.g., ethyl acetate, propyl acetate, butyl acetate, amyl acetate, benzyl acetate, methyl lactate, butyl lactate, ethylene glycol monobutyl acetate, polyethylene glycol monomethyl ether acetate, diethylene glycol acetate, diethyl phthalate or butyl levulinate) and others (e.g., triethyl phosphate, tricresyl phosphate, N-phenylethanolamine, N-phenyldiethanolamine, N-methyldiethanolamine, N-ethyldiethanolamine, 4-(2-hydroxyethyl)morpholine, N,N-dimethylacetamide or N-methylpyrrolidone). Two or more organic solvents may be used in combination in the developer

When the organic solvent is insoluble in water, it may be employed by being solubilized in water using a surfactant or the like. In the case where the developer contains an organic solvent, the concentration of the organic solvent is desirably less than 40% by weight in view of safety and inflammability.

The developer may contain a preservative, a chelating agent, a defoaming agent, an organic acid, an inorganic acid, an inorganic salt or the like in addition the components described above. Specifically, compounds described in Paragraph Nos. [0266] to [0270] of JP-A-2007-206217 are preferably used.

The developer can be used as a developer and a development replenisher for the exposed lithographic printing plate precursor. It is preferably applied to the automatic development processor as described above. In the case of conducting the development processing using an automatic development processor, the developer becomes fatigued in accordance with the processing amount, and hence the processing ability may be restored using a replenisher or a fresh developer.

In the method of preparing a lithographic printing plate according to the invention, the lithographic printing plate

precursor may be heated its entire surface before the exposure, during the exposure or between the exposure and the development, if desired. By the heating, the image-forming reaction in the photosensitive layer is accelerated and advantages, for example, improvement in the sensitivity and printing durability and stabilization of the sensitivity are achieved. For the purpose of increasing the image strength and printing durability, it is also effective to perform entire surface after-heating or entire surface exposure to the image after the development. Ordinarily, the heating before the development is preferably performed under a mild condition of 150°C or lower. When the temperature is too high, a problem may arise sometimes in that the unexposed area is also cured. On the other hand, the heating after the development can be performed using very strong conditions and is ordinarily carried out in a temperature range from 100 to 500°C. When the temperature is too low, a sufficient effect of strengthening the image may not be obtained, whereas when it is excessively high, problems of deterioration of the support and thermal decomposition of the image area may occur sometimes.

EXAMPLES

The present invention will be described in more detail with reference to the following examples, but the invention should not be construed as being limited thereto.

Examples 1 to 50 and Comparative Examples 1 to 3

[Preparation of Lithographic printing plate precursor 1]

(Preparation of Support 1)

An aluminum plate (material: J1S A 1050) having a thickness of 0.3 mm was subjected to a degreasing treatment at 50°C for 30 seconds using a 10% by weight aqueous sodium aluminate solution in order to remove rolling oil on the surface thereof and then grained the surface thereof using three nylon brushes embedded with bundles of nylon bristle having a diameter of 0.3 mm and an aqueous suspension (specific gravity: 1.1 g/cm$^3$) of pumice having a median size of 25 μm, followed by thorough washing with water. The plate was subjected to etching by immersing in a 25% by weight aqueous sodium hydroxide solution of 45°C for 9 seconds, washed with water, then immersed in a 20% by weight aqueous nitric acid solution at 60°C for 20 seconds, and washed with water. The etching amount of the grained surface was about 3 g/m$^2$.

Then, using an alternating current of 60 Hz, an electrochemical roughening treatment was continuously carried out on the plate. The electrolytic solution used was a 1% by weight aqueous nitric acid solution (containing 0.5% by weight of aluminum ion) and the temperature of electrolytic solution was 50°C. The electrochemical roughening treatment was conducted using an alternating current source, which provides a rectangular alternating current having a trapezoidal waveform such that the time TP necessary for the current value to reach the peak from zero was 0.8 msec and the duty ratio was 1:1, and using a carbon electrode as a counter electrode. A ferrite was used as an auxiliary anode. The current density was 30 A/dm$^2$ in terms of the peak value of the electric current and 5% of the electric current flowing from the electric source was divided to the auxiliary anode. The quantity of electricity in the nitric acid electrolysis was 175 C/dm$^2$ in terms of the quantity of electricity when the aluminum plate functioned as an anode. The plate was then washed with water by spraying.

The plate was further subjected to an electrochemical roughening treatment in the same manner as in the nitric acid electrolysis above using as an electrolytic solution, a 0.5% by weight aqueous hydrochloric acid solution (containing 0.5% by weight of aluminum ion) having temperature of 50°C and under the condition that the quantity of electricity was 50 C/dm$^2$ in terms of the quantity of electricity when the aluminum plate functioned as an anode. The plate was then washed with water by spraying. The plate was then subjected to an anodizing treatment using as an electrolytic solution, a 15% by weight aqueous sulfuric acid solution (containing 0.5% by weight of aluminum ion) at a current density of 15 A/dm$^2$ to form a direct current anodized firm of 2.5 g/m$^2$, washed with water and dried. The center line average roughness (Ra indication according to JIS B0601) of the surface of Support 1 thus-obtained was measured using a stylus having a diameter of 2 μm and found to be 0.51 μm.

(Formation of Intermediate layer)

Coating solution (1) for intermediate layer having the composition shown below was coated using a bar on Support 1 described above and dried in an oven at 80°C for 10 seconds to form an intermediate layer having a dry coating amount of 10 mg/m$^2$.

<Coating solution (1) for intermediate layer>

| | |
|---|---|
| Polymer shown in Table A below | 0.017 g |
| Methanol | 9.00 g |
| Water | 1.00 g |

(Formation of Photosensitive layer and Protective layer)

On the intermediate layer described above, Coating solution (1) for photosensitive layer having the composition shown below was coated using a bar and dried in an oven at 70°C for 60 seconds to form a photosensitive layer having a dry coating amount of 1.1 g/m$^2$. On the photosensitive layer, Coating solution (1) for protective layer having the composition shown below was coated using a bar so as to have a dry coating amount of 0.75 g/m$^2$ and dried at 125°C for 70 seconds to form a protective layer, thereby preparing Lithographic printing plate precursor 1.

<Coating solution (1) for photosensitive layer>

| | |
|---|---|
| Binder Polymer (1) | 0.48 g |
| Methacrylic acid/methyl methacrylate copolymer (weight average molecular weight: 40,000, molar ratio: 30/70) | |
| Polymerizable Compound (1) shown below | 0.54 g |
| Sensitizing Dye (1) shown below | 0.06 g |
| Polymerization Initiator (1) shown below | 0.08 g |
| Co-Sensitizer (1) shown below | 0.07 g |
| Dispersion of ε-phthalocyanine pigment | 0.40 g |
| [pigment: 15 parts by weight; dispersing agent (Binder Polymer (1)): 10 parts by weight; solvent: (cyclohexanone/methoxypropyl acetate/1-methoxy-2-propanol = 15 parts by weight/20 parts by weight/40 parts by weight)] | |
| Thermal polymerization inhibitor | 0.01 g |
| N-Nitrosophenylhydroxylamine aluminum salt | |
| Fluorine-Based Surfactant (1) shown below (weight average molecular weight: 11,000) | 0.001 g |
| Polyoxyethylene-polyoxypropylene condensate | 0.04 g |
| (PLURONIC L44, produced by ADEKA Corp.) | |
| Tetraethylamine hydrochloride | 0.01 g |
| 1-Methoxy-2-propanol | 3.5 g |
| Methyl ethyl ketone | 8.0 g |

Sensitizing Dye (1):

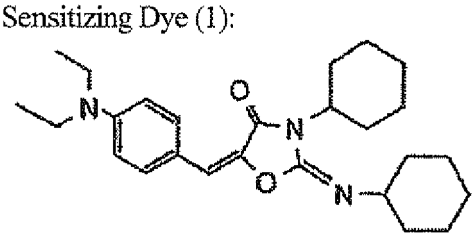

Polymerization Initiator (1):

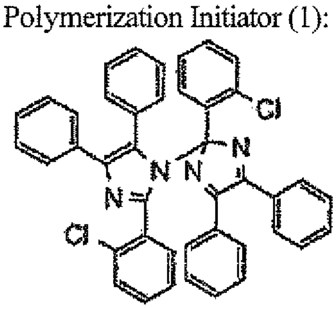

Co-Sensitizer (1):

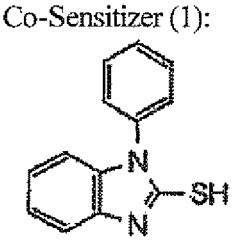

Fluorine-Based Surfactant (1):

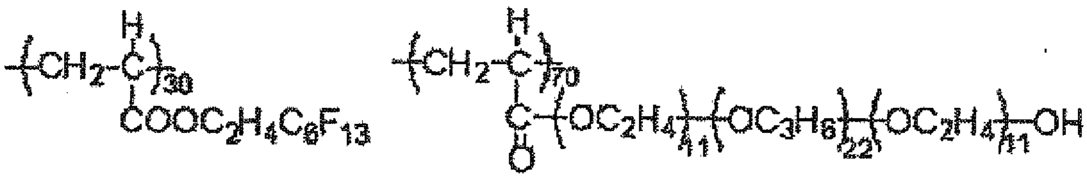

Polymerizable Compound (1):

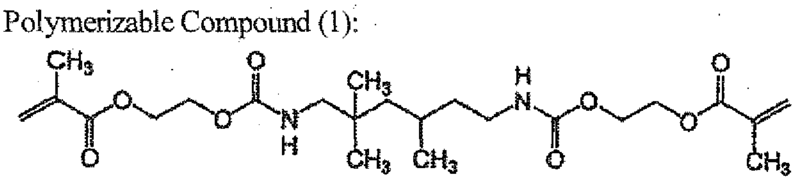

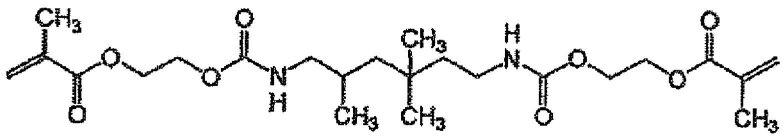

(Mixture of the isomers shown above)

<Coating solution (1) for protective layer>

| | |
|---|---|
| Polyvinyl alcohol (saponification degree: 98% by mole; polymerization degree: 500) | 40 g |
| Polyvinyl pyrrolidone (weight average molecular weight: 50,000) | 5 g |
| Vinyl pyrrolidone/vinyl acetate (1/1) copolymer (weight average molecular weight: 70,000) | 0.5 g |

(continued)

| | |
|---|---|
| Surfactant (EMALEX 710, produced by Nihon-Emulsion Co., Ltd.) | 0.5 g |
| Water | 950 g |

[Preparation of Lithographic printing plate precursors 2 to 50 and Comparative lithographic printing plate precursors 1 to 3]

Lithographic printing plate precursors 2 to 50 and Comparative lithographic printing plate precursors I to 3 were prepared in the same manner as in the preparation of Lithographic printing plate precursor 1 except for changing the components used to those shown in Table A below, respectively. The respective components used are described below.

Binder Polymer (2)

Polyvinyl alcohol (weight average molecular weight: 50,000; saponification degree: 55%) Binder Polymer (3)
Polyvinyl butyral (weight average molecular weight: 80,000; butyral ratio: 65% by mole; acetate ratio: less than 1% by mole)

Binder Polymer (4)

Methacrylic acid/methyl methacrylate copolymer (weight average molecular weight: 50,000; molar ratio: 15/85)

Binder Polymer (5) (weight average molecular weight: 80,000):

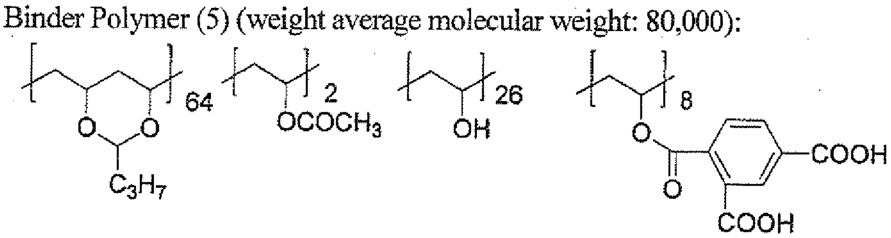

Binder Polymer (6) (weight average molecular weight: 70,000):

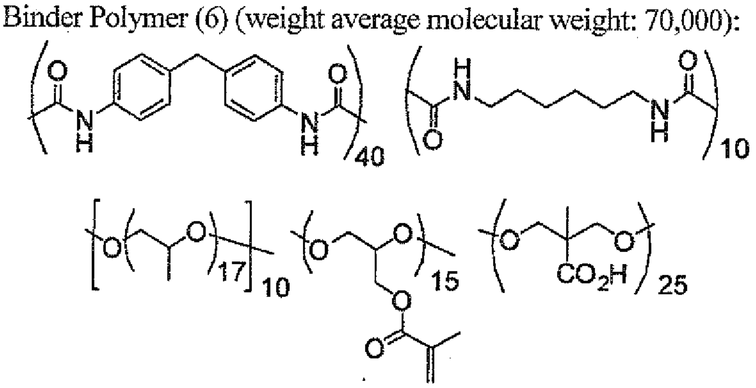

Polymerizable Compound (2):

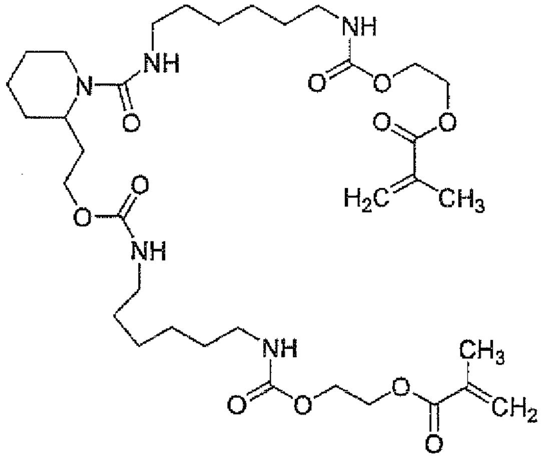

Polymerizable Compound (3):

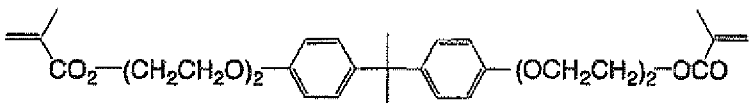

Sensitizing Dye (2):

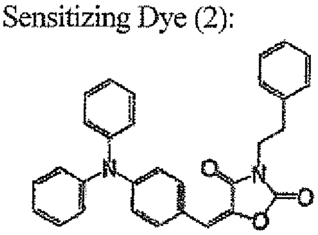

Sensitizing Dye (3):

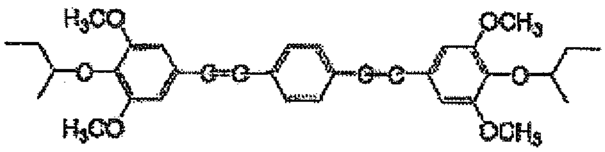

Polymerization Initiator (2):

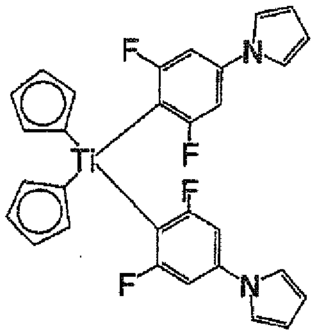

Co-Sensitizer (2):

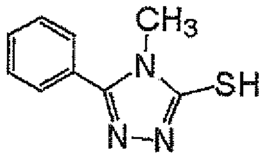

Co-Sensitizer (3):

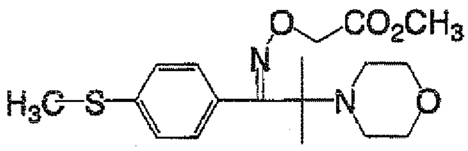

Co-Sensitizer (4):

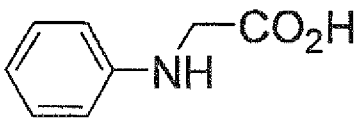

Comparative Polymers (DH-1), (DH-2) and (DH-3)

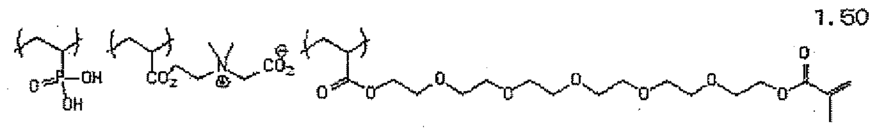

DH-1 65/25/10 2

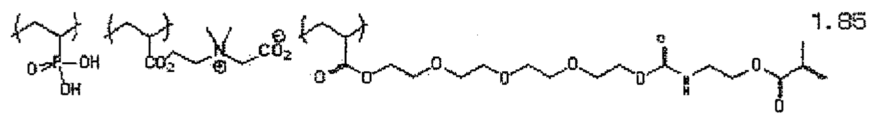

DH-2 65/25/10 2

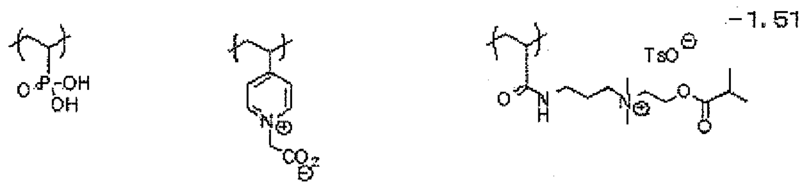

DH-3 45/40/15 4

[Exposure, Development and Printing]

Each of Lithographic printing plate precursors 1 to 50 and Comparative lithographic printing plate precursors 1 to 3 was subjected to image exposure by Violet semiconductor laser plate setter Vx9600 (equipped with InGaN semiconductor laser; emission: 405 nm ± 10 nm/output: 30 mW) produced by FUJIFILM Electronic Imaging, Ltd. The image exposure was conducted at a resolution of 2,438 dpi with halftone dots of 50% using an FM screen (TAFFETA 20, produced by FUJIFILM Corp.) under condition of a plate surface exposure amount of 0.05 mJ/$cm^2$.

Then, the exposed lithographic printing plate precursor was subjected to development processing in an automatic development processor having a structure as shown in Fig. 1 using each of Developers (1) and (2) and Comparative

Developer (1) having the composition shown below to prepare a lithographic printing plate (without heating). The automatic development processor had two rotating brush rollers. The first brush roller was a brush roller having an outer diameter of 90 mm and being implanted with fiber of polybutylene terephthalate (bristle diameter: 200 μm, bristle length: 17 mm), and the brush roller was rotated at 200 rpm (peripheral velocity at the tip of brush: 0.94 m/sec) in the same direction as the transporting direction of the lithographic printing plate precursor. The second brush roller was a brush roller having an outer diameter of 60 mm and being implanted with fiber of polybutylene terephthalate (bristle diameter: 200μm, bristle length: 17 mm), and the brush roller was rotated at 200 rpm (peripheral velocity at the tip of brush: 0.63 m/sec) in the opposite direction to the transporting direction of the lithographic printing plate precursor. The transportation of the lithographic printing plate precursor was conducted at a transporting speed so as to regulate the immersion time (developing time) in the developer of 20 seconds.

The developer was supplied on the surface of the lithographic printing plate precursor by showering from a spray pipe using a circulation pump. The tank volume for the developer was 10 liters.

Developer (1)(pH: 9.7)

| | |
|---|---|
| Water | 8329.8 g |
| Sodium carbonate | 130 g |
| Sodium hydrogen carbonate | 70 g |
| Surfactant (NEWCOL B13, produced by Nippon Nyukazai Co., Ltd. (naphthol ethyleneoxide adduct)) | 500 g |
| Gum arabic (Mw: 200,000) | 250 g |
| Hydroxy-alkylated starch (PENON JE66, produced by Nippon Starch Chemical Co., Ltd.) | 700 g |
| Ammonium primary phosphate | 20 g |
| 2-Bromo-2-nitropropane-1,3-diol | 0.1 g |
| 2-Methyl-4-isothiazolin-3-one | 0.1 g |

Developer (2) (pH: 9.7)

| | |
|---|---|
| Water | 8260 g |
| Potassium carbonate | 150 g |
| Potassium hydrogen carbonate | 80 g |
| Surfactant (ELEMINOL MON, produced by Sanyo Chemical Industries, Ltd. (sodium alkyldiphenyl ether disulfonate) (calculated in terms of 100%)) | 350 g |
| Yellow dextrin (AKADAMA DEXTRIN 102, produced by Nippon Starch Chemical Co., Ltd.) | 800 g |
| Ammonium primary phosphate | 180 g |
| Sodium hexametaphosphate | 180 g |

Comparative Developer (1) (pH: 9.7)

| | |
|---|---|
| Water | 8399.8 g |
| Sodium carbonate | 130 g |
| Surfactant (NEWCOL B 13, produced by Nippon Nyukazai Co., Ltd.) | 500 g |
| Gum arabic (Mw: 200,000) | 250 g |
| Hydroxy-alkylated starch (PENON JE66, produced by Nippon Starch Chemical Co., Ltd.) | 700 g |
| Ammonium primary phosphate | 20 g |
| 2-Bromo-2-nitropropane-1,3-diol | 0.1 g |
| 2-Methyl-4-isothiazolin-3-one | 0.1 g |

(pH was adjusted to 9.7 by adding sodium hydroxide and phosphoric acid)

The lithographic printing plate thus-obtained was mounted on a printing machine (SOR-M, produced by Heidelberg) and printing was performed at a printing speed of 6,000 sheets per hour using dampening water (EU-3 (etching solution, produced by FUJIFILM Corp.))/water/isopropyl alcohol = 1/89/10 (by volume ratio)) and TRANS-G (N) black ink (produced by Dai-Nippon Ink & Chemicals, Inc.).

[Evaluation]

With each lithographic printing plate precursor, stain resistance, stain resistance after preservation, printing durability and chemical resistance were evaluated in the manner described below. The results obtained are shown in Table A.

<Stain resistance>

The 500th sheet of the printed material from the initiation of printing was picked up and the density of ink adhered on the non-image area was measured to relatively evaluate the stain resistance. Specifically, the stain resistance was calculated according to the formula shown below using Comparative Example 1 as the criterion (100). When the value is larger, it is meant that the density of ink adhered on the non-image area is lower, that is, the stain resistance is better.

Stain resistance = (Ink density of non-image area on printed material from criterion lithographic printing plate)/(Ink density of non-image area on printed material from subject lithographic printing plate) x 100

<Stain resistance after preservation>

The lithographic printing plate precursor was preserved at 60°C for 3 days and then subjected to the exposure, development, printing and evaluation of stain resistance in the same manner as described above. As the criterion (100), the stain resistance of Comparative Example 1 without preservation was used.

<Printing durability>

As increase in the number of printing sheets according to the printing described above, the photosensitive layer was gradually abraded to cause decrease in the ink receptivity, resulting in decrease of ink density on a printed material. A number of printed materials obtained until the ink density (reflection density) decreased by 0.1 from that at the initiation of printing was determined to evaluate the printing durability. Specifically, the printing durability was relatively evaluated by calculating according to the formula shown below using the number of printing sheets (10,000 sheets) of Comparative Example 1 as the criterion (100). When the value is larger, it is meant that the printing durability is higher.

Printing durability = (Number of printed materials of subject lithographic printing plate)/(Number of printed materials of criterion lithographic printing plate) x 100

<Chemical resistance>

On the lithographic printing plate obtained by the exposure and development described above was dropped a stock solution of dampening water (VEGRA E794/858, produced by Vegra GmbH) and after 30 minutes the lithographic printing plate was washed with water. A Scotch brand tape (produced by 3M) was stuck on the dropped area of the lithographic printing plate and then the tape was peeled off. The dropped area of the lithographic printing plate was visually observed to evaluate the chemical resistance according to the following criteria. The symbol "A" indicates that the chemical resistance is best.

A: The trace of the dropped area was not found.
B: Although the trace of the dropped area was found, the halftone dots were not changed.
C: The trace of the dropped area was found to be thin due to the decrease in density and the halftone dots also became thin.
D: The dropped area itself became white.

TABLE A

| | Lithographic Printing Plate Precursor | Polymer in Intermediate Layer | Polymerization Initiator | Polymerizable Compound | Binder Polymer | Sensitizing Dye | Co-Sensitizer | Developer | Stain Resistance | Stain Resistance After Reservation | Printing Durability | Chemical Resistance |
|---|---|---|---|---|---|---|---|---|---|---|---|---|
| Example 1 | 1 | D-1 | 1 | 1 | 1 | 1 | 1 | 1 | 170 | 160 | 120 | A |
| Comparative Example 1 | Comparative Precursor 1 | DH-1 | 1 | 1 | 1 | 1 | 1 | 1 | 100 | 10 | 100 | C |
| Comparative Example 2 | Comparative Precursor 2 | DH-2 | 1 | 1 | 1 | 1 | 1 | 1 | 100 | 20 | 80 | D |
| Example 2 | 2 | D-3 | 1 | 1 | 6 | 1 | 3 | 1 | 170 | 160 | 140 | A |
| Example 3 | 3 | D-6 | 1 | 1 | 4 | 3 | 1 | 1 | 180 | 170 | 120 | A |
| Example 4 | 4 | D-8 | 2 | 1 | 1 | 2 | 1 | 1 | 180 | 170 | 130 | A |
| Example 5 | 5 | D-9 | 1 | 1 | 2 | 1 | 2 | 2 | 170 | 160 | 150 | A |
| Example 6 | 6 | D-11 | 1 | 1 | 1 | 1 | 1 | 1 | 190 | 180 | 150 | A |
| Example 7 | 7 | D-12 | 1 | 1 | 6 | 1 | 1 | 2 | 180 | 170 | 150 | A |
| Example 8 | 8 | D-13 | 1 | 2 | 5 | 3 | 4 | 1 | 180 | 170 | 140 | A |
| Example 9 | 9 | D-14 | 1 | 1 | 1 | 1 | 1 | 1 | 180 | 170 | 140 | A |
| Example 10 | 10 | D-15 | 2 | 1 | 3 | 2 | 1 | 1 | 190 | 180 | 140 | A |
| Example 11 | 11 | D-18 | 1 | 1 | 1 | 1 | 1 | 1 | 180 | 170 | 150 | A |
| Example 12 | 12 | D-21 | 1 | 1 | 1 | 1 | 3 | 1 | 180 | 170 | 120 | A |
| Example 13 | 13 | D-23 | 1 | 3 | 5 | 3 | 1 | 1 | 190 | 180 | 120 | A |
| Example 14 | 14 | D-24 | 1 | 1 | 1 | 1 | 1 | 1 | 180 | 170 | 150 | A |
| Comparative Example 2 | Comparative Precursor 3 | DH-3 | 1 | 1 | 1 | 1 | 1 | 1 | 180 | 170 | 70 | C |
| Example 15 | 15 | D-27 | 1 | 1 | 1 | 1 | 2 | 1 | 190 | 180 | 150 | A |
| Example 16 | 16 | D-29 | 1 | 1 | 4 | 3 | 1 | 2 | 200 | 190 | 140 | A |
| Example 17 | 17 | D-31 | 2 | 1 | 1 | 2 | 1 | 1 | 200 | 190 | 140 | A |
| Example 18 | 18 | D-32 | 1 | 1 | 1 | 1 | 1 | 1 | 200 | 190 | 150 | A |
| Example 19 | 19 | D-33 | 1 | 3 | 6 | 1 | 2 | 1 | 200 | 190 | 130 | A |

(continued)

| | Lithographic Printing Plate Precursor | Polymer in Intermediate Layer | Polymerization Initiator | Polymerizable Compound | Binder Polymer | Sensitizing Dye | Co-Sensitizer | Developer | Stain Resistance | Stain Resistance After Reservation | Printing Durability | Chemical Resistance |
|---|---|---|---|---|---|---|---|---|---|---|---|---|
| Example 20 | 20 | D-35 | 2 | 1 | 1 | 2 | 1 | 1 | 200 | 190 | 130 | A |
| Example 21 | 21 | D-36 | 1 | 1 | 1 | 1 | 1 | 1 | 210 | 200 | 140 | A |
| Example 22 | 22 | D-39 | 1 | 2 | 4 | 3 | 1 | 2 | 210 | 200 | 140 | A |
| Example 23 | 23 | D-41 | 1 | 1 | 1 | 1 | 3 | 1 | 210 | 190 | 120 | A |
| Example 24 | 24 | D-43 | 1 | 1 | 1 | 1 | 1 | 2 | 210 | 200 | 140 | A |
| Lithographic | Lithographic Printing Plate Precursor | Polymer in Intermediate Layer | Polymerization Initiator | Polymerizable Compound | Binder Polymer | Sensitizing Dye | Co-Sensitizer | Developer | Stain Resistance | Stain Resistance After Preservation | Printing Durability | Chemical Resistance |
| Example 25 | 25 | D-45 | 1 | 1 | 1 | 1 | 1 | 1 | 210 | 200 | 120 | A |
| Example 26 | 26 | D-46 | 1 | 1 | 1 | 1 | 1 | 1 | 170 | 170 | 120 | A |
| Example 27 | 27 | D-47 | 1 | 1 | 1 | 1 | 1 | 1 | 170 | 160 | 120 | A |
| Example 28 | 28 | D-48 | 1 | 1 | 1 | 1 | 1 | 1 | 170 | 160 | 140 | A |
| Example 29 | 29 | D-49 | 1 | 1 | 1 | 1 | 1 | 1 | 180 | 170 | 140 | A |
| Example 30 | 30 | D-50 | 1 | 1 | 1 | 1 | 1 | 1 | 190 | 180 | 140 | A |
| Example 31 | 31 | D-51 | 1 | 1 | 1 | 1 | 1 | 1 | 180 | 170 | 120 | A |
| Example 32 | 32 | D-52 | 1 | 1 | 1 | 1 | 1 | 1 | 180 | 170 | 120 | A |
| Example 33 | 33 | D-53 | 1 | 1 | 1 | 1 | 1 | 1 | 180 | 170 | 120 | A |
| Example 34 | 34 | D-54 | 1 | 1 | 1 | 1 | 1 | 1 | 180 | 170 | 140 | A |
| Example 35 | 35 | D-55 | 1 | 1 | 1 | 1 | 1 | 1 | 180 | 170 | 130 | A |
| Example 36 | 36 | D-56 | 1 | 1 | 1 | 1 | 1 | 1 | 180 | 170 | 130 | A |
| Example 37 | 37 | D-57 | 1 | 1 | 1 | 1 | 1 | 1 | 180 | 170 | 120 | A |
| Example 38 | 38 | D-58 | 1 | 1 | 1 | 1 | 1 | 1 | 180 | 170 | 120 | A |
| Example 39 | 39 | D-59 | 1 | 1 | 1 | 1 | 1 | 1 | 180 | 170 | 120 | C |
| Example 40 | 40 | D-60 | 1 | 1 | 1 | 1 | 1 | 1 | 180 | 170 | 130 | A |

(continued)

| Lithographic | Lithographic Printing Plate Precursor | Polymer in Intermediate Layer | Polymerization Initiator | Polymerizable Compound | Binder Polymer | Sensitizing Dye | Co-Sensitizer | Developer | Stain Resistance | Stain Resistance After Preservation | Printing Durability | Chemical Resistance |
|---|---|---|---|---|---|---|---|---|---|---|---|---|
| Example 41 | 41 | D-61 | 1 | 1 | 1 | 1 | 1 | 1 | 210 | 200 | 130 | A |
| Example 42 | 42 | D-62 | 1 | 1 | 1 | 1 | 1 | 1 | 200 | 190 | 130 | A |
| Example 43 | 43 | D-63 | 1 | 1 | 1 | 1 | 1 | 1 | 200 | 190 | 130 | A |
| Example 44 | 44 | D-64 | 1 | 1 | 1 | 1 | 1 | 1 | 180 | 170 | 130 | A |
| Example 45 | 45 | D-65 | 1 | 1 | 1 | 1 | 1 | 1 | 190 | 180 | 130 | A |
| Example 46 | 46 | D-66 | 1 | 1 | 1 | 1 | 1 | 1 | 160 | 150 | 130 | A |
| Example 47 | 47 | D-67 | 1 | 1 | 1 | 1 | 1 | 1 | 170 | 160 | 140 | A |
| Example 48 | 48 | D-68 | 1 | 1 | 1 | 1 | 1 | 1 | 180 | 170 | 150 | A |
| Example 49 | 49 | D-69 | 1 | 1 | 1 | 1 | 1 | 1 | 190 | 180 | 160 | A |
| Example 50 | 50 | D-70 | 1 | 1 | 1 | 1 | 1 | 1 | 210 | 200 | 160 | A |

As is apparent from the results shown in Table A, according to the method of preparing a lithographic printing plate of the invention, a lithographic printing plate excellent in the stain resistance, stain resistance after preservation, printing durability and chemical resistance can be provided in spite of one solution processing using the weak alkaline developer.

Examples 51 to 100 and Comparative Examples 5 to 7

Each of Lithographic printing plate precursors 1 to 50 and Comparative lithographic printing plate precursors 1 to 3 was subjected to the laser imagewise exposure in the same manner as in Example 1. Within 30 seconds after the laser imagewise exposure, the exposed lithographic printing plate precursor was put in an oven, heated the entire surface of the lithographic printing plate precursor by blowing hot air to maintain at 110°C for 15 seconds and then subjected to the development processing within 30 seconds in the same manner as in Example 1 to prepare a lithographic printing plate (with heating). The resulting lithographic printing plate was subjected to the evaluation of stain resistance, stain resistance after preservation, printing durability and chemical resistance in the same manner as in Example 1. The results obtained are shown in Table B.

TABLE B

| | Lithographic Printing Plate Precursor | Polymer in Intermediate Layer | Stain Resistance | Stain Resistance after Preservation | Printing Durability | Chemical Resistance |
|---|---|---|---|---|---|---|
| Example 51 | 1 | D-1 | 160 | 150 | 130 | A |
| Comparative Example 5 | Comparative Precursor 1 | DH-1 | 95 | 10 | 110 | C |
| Comparative Example 6 | Comparative Precursor 2 | DH-2 | 95 | 20 | 90 | C |
| Example 52 | 2 | D-3 | 160 | 150 | 150 | A |
| Example 53 | 3 | D-6 | 170 | 160 | 130 | A |
| Example 54 | 4 | D-8 | 170 | 160 | 140 | A |
| Example 55 | 5 | D-9 | 160 | 150 | 160 | A |
| Example 56 | 6 | D-11 | 180 | 170 | 160 | A |
| Example 57 | 7 | D-12 | 170 | 160 | 160 | A |
| Example 58 | 8 | D-13 | 170 | 160 | 150 | A |
| Example 59 | 9 | D-14 | 170 | 160 | 150 | A |
| Example 60 | 10 | D-15 | 180 | 170 | 150 | A |
| Example 61 | 11 | D-18 | 170 | 160 | 160 | A |
| Example 62 | 12 | D-21 | 170 | 160 | 130 | A |
| Example 63 | 13 | D-23 | 180 | 170 | 130 | A |
| Example 64 | 14 | D-24 | 170 | 160 | 160 | A |
| Comparative Example 7 | Comparative Precursor 3 | DH-3 | 170 | 160 | 80 | C |
| Example 65 | 15 | D-27 | 180 | 170 | 160 | A |
| Example 66 | 16 | D-29 | 190 | 180 | 150 | A |
| Example 67 | 17 | C7-31 | 190 | 180 | 150 | A |
| Example 68 | 18 | D-32 | 190 | 180 | 160 | A |
| Example 69 | 19 | D-33 | 190 | 180 | 140 | A |
| Example 70 | 20 | D-35 | 190 | 180 | 140 | A |

(continued)

| | Lithographic Printing Plate Precursor | Polymer in Intermediate Layer | Stain Resistance | Stain Resistance after Preservation | Printing Durability | Chemical Resistance |
|---|---|---|---|---|---|---|
| Example 71 | 21 | D-36 | 200 | 190 | 150 | A |
| Example 72 | 22 | D-39 | 200 | 190 | 150 | A |
| Example 73 | 23 | D-41 | 200 | 180 | 130 | A |
| Example 74 | 24 | D-43 | 200 | 190 | 150 | A |
| Example 75 | 25 | D-A5 | 200 | 190 | 130 | A |
| Example 76 | 26 | D-46 | 160 | 160 | 130 | A |
| Example 77 | 27 | D-47 | 160 | 150 | 130 | A |
| Example 78 | 28 | D-48 | 160 | 150 | 150 | A |
| Example 79 | 29 | D-49 | 170 | 160 | 150 | A |
| Example 80 | 30 | D-50 | 180 | 170 | 150 | A |
| Example 81 | 31 | D-51 | 170 | 160 | 130 | A |
| Example 82 | 32 | D-52 | 170 | 160 | 130 | A |
| Example 83 | 33 | D-53 | 170 | 160 | 130 | A |
| Example 84 | 34 | D-54 | 170 | 160 | 150 | A |
| Example 85 | 35 | D-55 | 170 | 160 | 140 | A |
| Example 86 | 36 | D-56 | 170 | 160 | 140 | A |
| Example 87 | 37 | D-57 | 170 | 160 | 130 | A |
| Example 88 | 38 | D-58 | 170 | 160 | 130 | A |
| Example 89 | 39 | D-59 | 170 | 160 | 130 | A |
| Example 90 | 40 | D-60 | 170 | 160 | 140 | A |
| Example 91 | 41 | D-61 | 200 | 190 | 140 | A |
| Example 92 | 42 | D-62 | 190 | 180 | 140 | A |
| Example 93 | 43 | D-63 | 190 | 180 | 140 | A |
| Example 94 | 44 | D-64 | 170 | 160 | 140 | A |
| Example 95 | 45 | D-65 | 180 | 170 | 140 | A |
| Example 96 | 46 | D-66 | 150 | 140 | 140 | A |
| Example 97 | 47 | D-67 | 160 | 150 | 150 | A |
| Example 98 | 48 | D-68 | 170 | 160 | 160 | A |
| Example 99 | 49 | D-69 | 180 | 170 | 170 | A |
| Example 100 | 50 | D-70 | 200 | 190 | 170 | A |

As is apparent from the results shown in Table B, according to the method of preparing a lithographic printing plate of the invention, a lithographic printing plate excellent in the stain resistance, stain resistance after preservation, printing durability and chemical resistance can be provided, even when the heat treatment was conducted between the image exposure and development processing.

Examples 101 to 150 and Comparative Examples 101 to 104

[Preparation of Lithographic printing plate precursor 51]

(Preparation of Support 2)

An aluminum plate (material: 1050, refining: H16) having a thickness of 0.24 mm was immersed in an aqueous 5% by weight sodium hydroxide solution maintained at 65°C to conduct a degreasing treatment for one minute, followed by washed with water. The aluminum plate was immersed in an aqueous 10% by weight hydrochloric acid solution maintained at 25°C for one minute to neutralize, followed by washed with water. Subsequently, the aluminum plate was subjected to an electrolytic surface-roughening treatment with alternating current under condition of current density of 100 $A/dm^2$ in an aqueous 0.3% by weight hydrochloric acid solution at 25°C for 60 seconds and then subjected to a desmut treatment in an aqueous 5% by weight sodium hydroxide solution maintained at 60°C for 10 seconds. The aluminum plate was subjected to an anodizing treatment under condition of current density of 10 $A/dm^2$ and voltage of 15 V in an aqueous 15% by weight sulfuric acid solution at 25°C for one minute and then subjected to a hydrophilizing treatment using an aqueous 1% by weight polyvinyl phosphonic acid solution at 75°C to prepare Support 2. The surface roughness of the support was measured and found to be 0.44 μm (Ra indication according to JIS B0601).

(Formation of Intermediate layer)

On support 2 described above was formed the intermediate layer in the same manner as in Lithographic printing plate precursor 1.

(Formation of Photosensitive layer)

Coating solution (2) for photosensitive layer having the composition shown below was coated on the intermediate layer described above using a bar and dried in an oven at 90°C for 60 seconds to form a photosensitive layer having a dry coating amount of 1.3 $g/m^2$.

<Coating solution (2) for photosensitive layer>

| | |
|---|---|
| Binder Polymer (4) shown above | 0.04 g |
| Binder Polymer (5) shown above | 0.30 g |
| Polymerizable Compound (1) shown above | 0.17 g |
| Polymerizable Compound (2) shown above | 0.51 g |
| Sensitizing Dye (4) shown below | 0.03 g |
| Sensitizing Dye (5) shown below | 0.015 g |
| Sensitizing Dye (6) shown below | 0.015 g |
| Polymerization Initiator (1) shown above | 0.13 g |
| Chain Transfer Agent Mercaptobenzothiazole | 0.01 g |
| Dispersion of ε-phthalocyanine pigment (pigment: 15 parts by weight; dispersing agent (allyl methacrylate/methacrylic acid copolymer (weight average molecular weight: 60,000, copolymerization molar ratio: 83/17)): 10 parts by weight; cyclohexanone: 15 parts by weight) | 0.40 g |
| Thermal polymerization inhibitor N-Nitrosophenylhydroxylamine aluminum salt | 0.01 g |
| Fluorine-Based Surfactant (1) shown above (weight average molecular weight: 11,000) | 0.001 g |
| 1-Metlaoxy-2-propanol | 3.5 g |
| Methyl ethyl ketone | 8.0 g |

Sensitizing Dye (4):

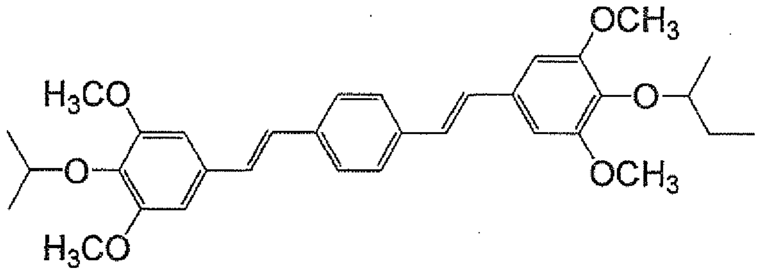

Sensitizing Dye (5):

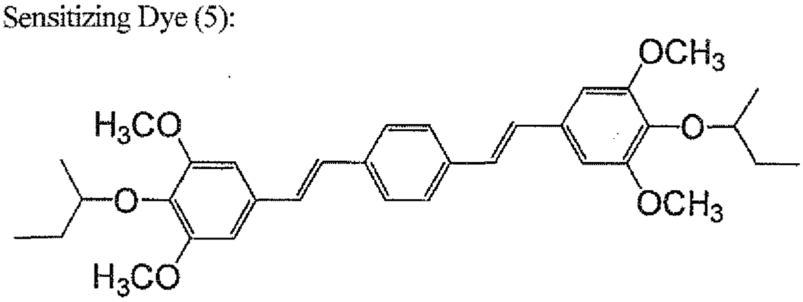

Sensitizing Dye (6):

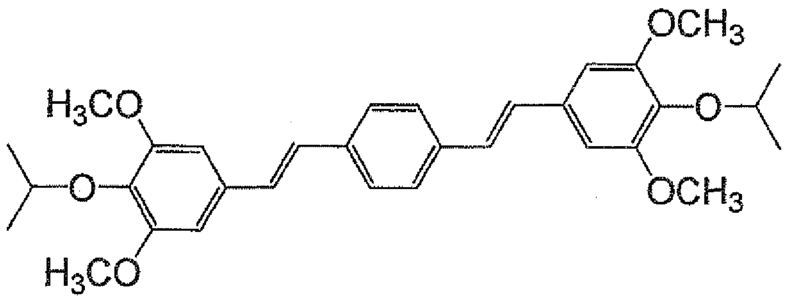

(Formation of Protective layer)

Coating solution (2) for protective layer having the composition shown below was coated on the photosensitive layer described above using a bar so as to have a dry coating amount of 1.2 g/$m^2$ and dried at 125°C for 70 seconds to form a protective layer, thereby preparing Lithographic printing plate precursor 51.

<Coating solution (2) for protective layer>

| | |
|---|---|
| PVA-205 (partially hydrolyzed polyvinyl alcohol, produced by Kuraray Co., Ltd. (saponification degree: 86.5 to 89.5% by mole; viscosity: 4.6 to 5.4 mPa·s in a 4% by weight aqueous solution at 20°C)) | 0.658 g |

(continued)

| | |
|---|---|
| PVA-105 (fully hydrolyzed polyvinyl alcohol, produced by Kuraray Co., Ltd. (saponification degree: 98.0 to 99.0% by mole; viscosity: 5.2 to 6.0 mPa·s in a 4% by weight aqueous solution at 20°C)] | 0.142 g |
| Vinyl pyrrolidone/vinyl acetate (1/1) copolymer (weight average molecular weight: 70,000) | 0.001 g |
| Surfactant (EMALEX 710, produced by Nihon Emulsion Co., Ltd.) | 0.002 g |
| Water | 13 g |

[Preparation of Lithographic printing plate precursors 52 to 75 and Comparative lithographic printing plate precursors 101 and 102]

Lithographic printing plate precursors 52 to 75 and Comparative lithographic printing plate precursors 101 and 102 were prepared in the same manner as in the preparation or Lithographic printing plate precursor 51 except for changing the polymer used in the intermediate layer to the compound shown in Table C below, respectively.

[Exposure, Development, Printing and Evaluation]

Using each of the lithographic printing plate precursors, the exposure, development, printing and evaluation were conducted in the same manner as in Example 1 with respect to Examples 101 to 125 and Comparative Examples 101 and 102. Also, the exposure, development, printing and evaluation were conducted in the same manner as in Example 51 with respect to Examples 126 to 150 and Comparative Examples 103 and 104. However, as the developer, Developer (3) shown below was used. The results obtained are shown in Table C.

Developer (3) (pH: 7.0)

| | |
|---|---|
| Water | 88.6 g |
| Nonionic Surfactant (W-1) shown below | 2.4 g |
| Nonionic Surfactant (W-2) shown below | 2.4 g |
| Nonionic surfactant (EMALEX 710, produced by Nihon Emulsion Co., Ltd.) | 1.0 g |
| Phenoxypropanol | 1.0 g |
| Octanol | 0.6 g |
| N-(2-Hydroxyethyl)morpholine | 1.0 g |
| Triethanolamine | 0.5 g |
| Sodium gluconate | 1.0 g |
| Trisodium citrate | 0.5 g |
| Tetrasodium ethylenediaminetetraacetate | 0.05 g |
| Polystyrenesulfonic acid (VERSA TL77 (30% solution) produced by Alco Chemical Inc.) | 1.0 g |

(pH was adjusted to 7.0 by adding phosphoric acid)

Nonionic Surfactant (W-1):

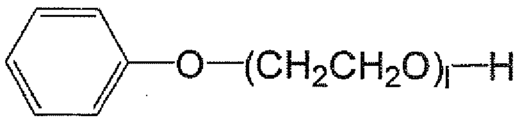

l=13-28

Nonionic Surfactant (W-2):

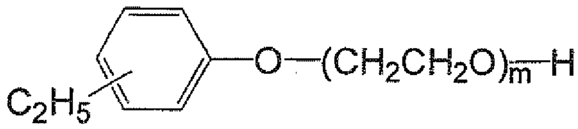

m=12-26

TABLE C

| | Lithographic Pointing Plate Precursor | Polymer in Intermediate Layer | Stain Resistance | Stain Resistance After Preservation | Printing Durability | Chemical Resistance | | Stain Resistance | Stain Resistance After Preservation | Pointing Durability | Chemical Resistance |
|---|---|---|---|---|---|---|---|---|---|---|---|
| Example 101 | 51 | D-1 | 160 | 150 | 110 | A | Example 126 | 150 | 140 | 120 | A |
| Comparative Example 101 | Comparative Precursor 101 | DH-1 | 100 | 20 | 110 | D | Comparative Example 103 | 90 | 10 | 120 | C |
| Comparative Example 102 | Comparative Precursor 101 | DH-2 | 80 | 20 | 110 | D | Comparative Example 104 | 70 | 10 | 120 | C |
| Example 102 | 52 | D-3 | 160 | 150 | 130 | A | Example 127 | 150 | 140 | 140 | A |
| Example 103 | 53 | D-6 | 170 | 160 | 110 | A | Example 128 | 160 | 150 | 120 | A |
| Example 104 | 54 | D-8 | 170 | 160 | 120 | A | Example 129 | 160 | 150 | 130 | A |
| Example 105 | 55 | D-9 | 160 | 150 | 140 | A | Example 130 | 150 | 140 | 150 | A |
| Example 106 | 56 | D-11 | 180 | 170 | 140 | A | Example 131 | 170 | 160 | 150 | A |
| Example 107 | 57 | D-12 | 170 | 160 | 140 | A | Example 132 | 160 | 150 | 150 | A |
| Example 108 | 58 | D-13 | 170 | 160 | 130 | A | Example 133 | 160 | 150 | 140 | A |
| Example 109 | 59 | D-14 | 170 | 160 | 130 | A | Example 134 | 160 | 150 | 140 | A |
| Example 110 | 60 | D-15 | 180 | 170 | 130 | A | Example 135 | 170 | 160 | 140 | A |
| Example 111 | 61 | D-18 | 170 | 160 | 140 | A | Example 136 | 160 | 150 | 150 | A |
| Example 112 | 62 | D-21 | 170 | 160 | 110 | A | Example 137 | 160 | 150 | 120 | A |
| Example 113 | 63 | D-23 | 180 | 170 | 110 | A | Example 138 | 170 | 160 | 120 | A |
| Example 114 | 64 | D-24 | 170 | 160 | 140 | A | Example 139 | 160 | 150 | 150 | A |
| Example 115 | 65 | D-27 | 180 | 170 | 140 | A | Example 140 | 170 | 160 | 150 | A |
| Example 116 | 66 | D-29 | 190 | 180 | 130 | A | Example 141 | 180 | 170 | 140 | A |
| Example 117 | 67 | D-31 | 190 | 180 | 130 | A | Example 142 | 180 | 170 | 140 | A |
| Example 118 | 68 | D-32 | 190 | 180 | 140 | A | Example 143 | 180 | 170 | 150 | A |
| Example 119 | 69 | D-33 | 190 | 180 | 120 | A | Example 144 | 180 | 170 | 130 | A |
| Example 120 | 70 | D-35 | 190 | 180 | 120 | A | Example 145 | 180 | 170 | 130 | A |

(continued)

| | Lithographic Pointing Plate Precursor | Polymer in Intermediate Layer | Stain Resistance | Stain Resistance After Preservation | Printing Durability | Chemical Resistance | | Stain Resistance | Stain Resistance After Preservation | Pointing Durability | Chemical Resistance |
|---|---|---|---|---|---|---|---|---|---|---|---|
| Example 121 | 71 | D-36 | 200 | 190 | 130 | A | Example 146 | 190 | 180 | 140 | A |
| Example 122 | 72 | D-39 | 200 | 190 | 130 | A | Example 147 | 190 | 180 | 140 | A |
| Example 123 | 73 | D-41 | 200 | 180 | 110 | A | Example 148 | 190 | 170 | 120 | A |
| Example 124 | 74 | D-43 | 200 | 190 | 130 | A | Example 149 | 190 | 180 | 140 | A |
| Example 125 | 75 | D-46 | 200 | 190 | 110 | A | Example 150 | 190 | 180 | 120 | A |

As is apparent from the results shown in Table C, according to the method of preparing a lithographic printing plate of the invention, a lithographic printing plate excellent in the stain resistance, stain resistance after preservation, printing durability and chemical resistance can be provided, in spite of the components of the photosensitive layer.

Examples 201 and 202 and Comparative Examples 201 to 203

[Preparation of Lithographic printing plate precursor 201]

(Formation of Photosensitive layer)

On an intermediate layer (containing D-71 as the polymer for intermediate layer) formed on Support 1 used in the preparation of Lithographic printing plate precursor 1 described above was coated Coating solution (3) for photosensitive layer having the composition shown below using a wire bar and dried in a hot air drying device at 125°C for 34 seconds to form a photosensitive layer having a dry coating amount of 1.4 g/$m^2$.

<Coating solution (3) for photosensitive layer>

| | |
|---|---|
| Infrared Absorbing Agent (IR-1) shown below | 0.038 parts by weight |
| Polymerization Initiator A (S-1) shown below | 0.061 parts by weight |
| Polymerization Initiator B (I-1) shown below | 0.094 parts by weight |
| Mercapto Compound (E-1) shown below | 0.015 parts by weight |
| Polymerizable Compound (M-1) shown below (A-BPE-4, produced by Shin-Nakamura Chemical Co., Ltd.) | 0.425 parts by weight |
| Binder Polymer A (B-1) (weight average molecular weight: 110,000) shown below | 0.311 parts by weight |
| Binder Polymer B (B-2) (weight average molecular weight: 100,000) shown below | 0.250 parts by weight |
| Binder Polymer C (B-3) (weight average molecular weight: 120,000) shown below | 0.062 parts by weight |
| Additive (T-1) shown below | 0.079 parts by weight |
| Polymerization Inhibitor (Q-1) shown below | 0.0012 parts by weight |
| Ethyl Violet (EV-1) shown below | 0.021 parts by weight |
| Fluorine-based surfactant (Megafac F-780-F, produced by Dainippon Ink & Chemicals Inc., 30% by weight methyl isobutyl ketone solution) | 0.0081 parts by weight |
| Methyl ethyl ketone | 5.886 parts by weight |
| Methanol | 2.733 parts by weight |
| 1-Methoxy-2-propanol | 5.886 parts by weight |

The structures of Infrared Absorbing Agent (1R-1), Polymerization Initiator A (S-1), Polymerization Initiator B (I-1), Mercapto Compound (E-1), Polymerizable Compound (M-1), Binder Polymer A (B-1), Binder Polymer B (B-2), Binder Polymer C (B-3), Additive (T-1), Polymerization Inhibitor (Q-1) and Ethyl Violet (EV-1) used in Coating solution (3) for photosensitive layer are shown below, respectively. In the structures below, Me indicates a methyl group.

(IR-1)

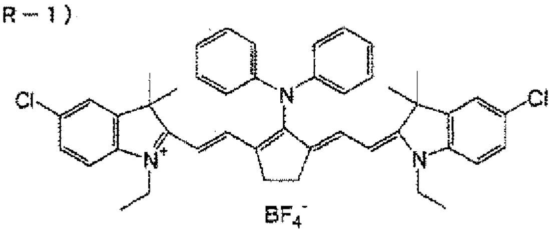

(S－1)

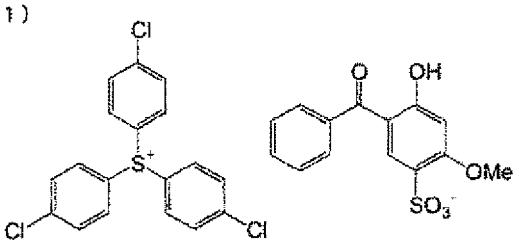

(I－1)

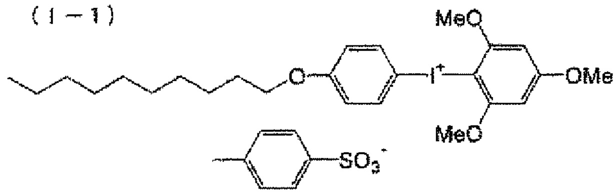

(E－1)

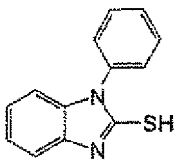

(M－1)

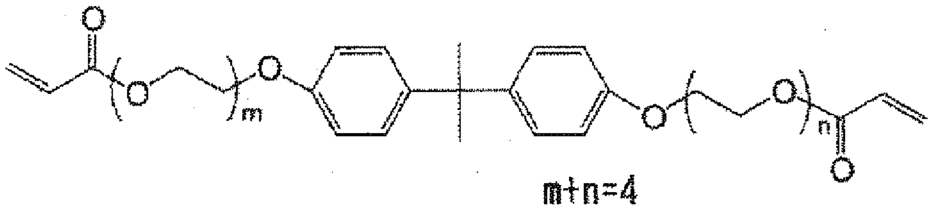

m+n=4

(B－1)

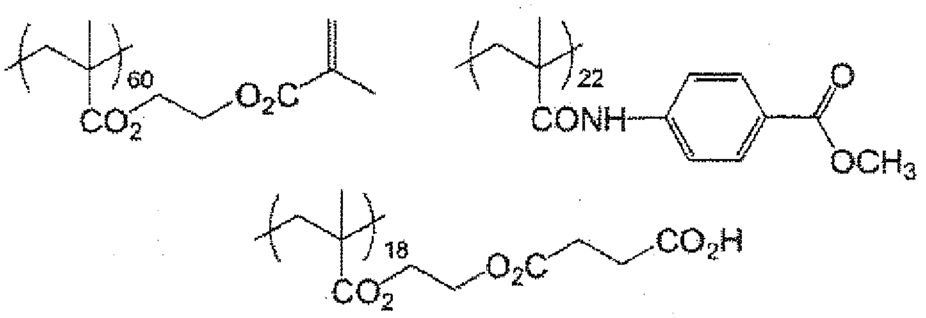

(B－2)

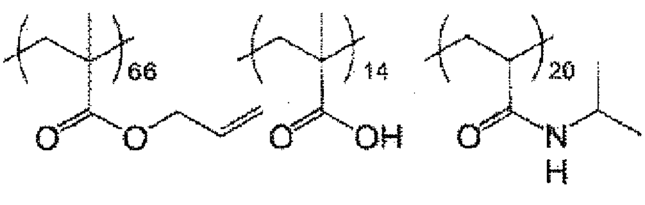

(B-3)

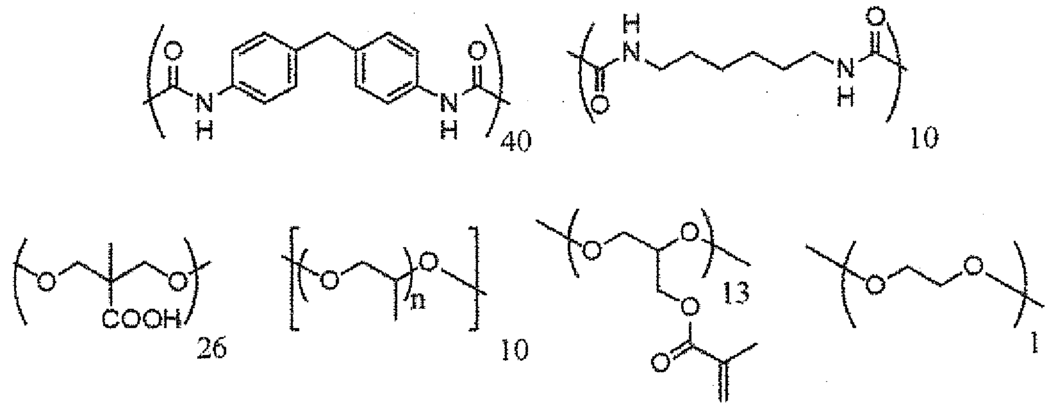

Mw: 1,000 (average value of n: 17)

(T-1)

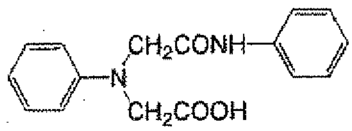

(Q-1)

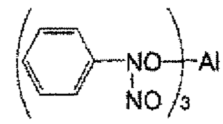

(EV-1)

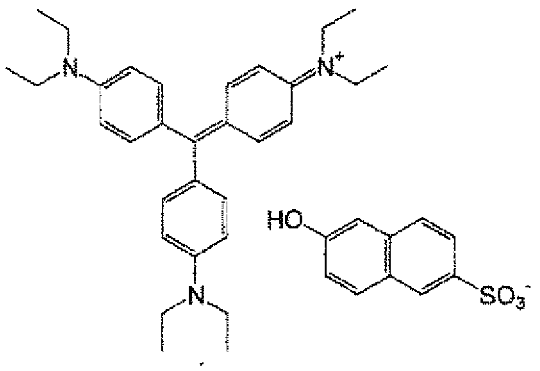

(Formation of Lower protective layer)

A mixed aqueous solution (coating solution for lower protective layer) containing synthetic mica (SOMASIF MEB-3L, aqueous 3.2% dispersion, produced by CO-OP Chemical Co., Ltd.), sulfonic acid-modified polyvinyl alcohol (GOSERAN CKS-50, (saponification degree: 99% by mole, polymerization degree: 300, produced by Nippon Synthetic Chemical Industry Co., Ltd.), Surfactant A (EMALEX 710, produced by Nihon Emulsion Co., Ltd.) and Surfactant B (ADEKA PLURONIC P-84, produced by ADEKA Corp.) was coated on the photosensitive layer with a wire bar and dried at 125°C for 30 seconds.

The content ratio of synthetic mica (solid content)/ sulfonic acid-modified polyvinyl alcohol/Surfactant A/Surfactant B in the mixed aqueous solution was 7.5/89/2/1.5 (% by weight) and a coating amount of the lower protective layer after drying was 0.5 $g/m^2$.

(Formation of Upper protective layer)

A mixed aqueous solution (coating solution for upper protective layer) containing an organic filler (ART PEARL J-7P, produced by Negami Chemical Industrial Co., Ltd.), synthetic mica (SOMASIF MEB-3L, aqueous 3.2% dispersion, produced by CO-OP Chemical Co., Ltd.), sulfonic acid-modified polyvinyl alcohol (GOSENOL L-3266, saponification degree: 87% by mole, polymerization degree: 300, produced by Nippon Synthetic Chemical Industry Co., Ltd.), thickening agent (CELOGEN FS-B, produced by Dai-Ichi Kogyo Seiyaku Co., Ltd.) and surfactant (EMALEX 710, produced by Nihon Emulsion Co., Ltd.) was coated on the lower protective layer with a wire bar and dried in a hot air drying device at 125°C. for 30 seconds.

The content ratio of organic filler/synthetic mica (solid content)/sulfonic acid-modified polyvinyl alcohol/thickening agent/surfactant was 3.2/2.0/80.5/11.5/2.8 (% by weight) and a coating amount the upper protective layer after drying was 1.76 g/m$^2$.

[Preparation of Lithographic printing plate precursor 202 and Comparative lithographic printing plate precursors 201 and 202]

Lithographic printing plate precursor 202 and Comparative lithographic printing plate precursors 201 and 202 were prepared in the same manner as in the preparation of Lithographic printing plate precursor 201 except for changing D-71 as the polymer for intermediate layer to D-72, DH-1 and DH-2, respectively.

[Exposure, Development, Printing and Evaluation]

Each of the lithographic printing plate precursors was imagewise exposed by TRENDSETTER 3244VX (produced by Creo Co.) equipped with a water-cooled 40 W infrared semiconductor laser under the conditions of output of 9 W, a plate surface energy of 110 mJ/cm$^2$, a rotational number of an external drum of 210 rpm and resolution of 2,400 dpi.

Within 30 seconds after the imagewise exposure, without conducting heat treatment and water washing treatment, the exposed lithographic printing plate precursor was developed using Developer (1) or Comparative Developer (1) described above in the same manner as in Example 1.

Using the lithographic printing plate obtained, the printing and evaluation were conducted in the same manner as in Example 1. As the criterion for the evaluation of stain resistance, stain resistance after preservation and printing durability, Comparative Example 201 was used. The results obtained are shown in Table D.

TABLE D

| | Lithographic Printing Plate Precursor | Polymer in Intermediate Layer | Developer | Stain Resistance | Stain Resistance after Preservation | Printing Durability | Chemical Resistance |
|---|---|---|---|---|---|---|---|
| Example 201 | 201 | D-71 | 1 | 150 | 140 | 130 | A |
| Example 202 | 202 | D-72 | 1 | 150 | 140 | 140 | A |
| Comparative Example 201 | Comparative Precursor 201 | DH-1 | 1 | 100 | 20 | 100 | D |
| Comparative Example 202 | Comparative Precursor 202 | DH-2 | 1 | 90 | 10 | 110 | D |
| Comparative Example 203 | 202 | D-72 | Comparative Developer 1 | 80 | 50 | 140 | A |

As is apparent from the results shown in Table D, according to the method of preparing a lithographic printing plate of the invention, a lithographic printing plate excellent in the stain resistance, stain resistance after preservation, printing durability and chemical resistance can be provided, even when the infrared laser is used as the exposure source.

## Claims

**1.** A method for preparing a lithographic printing plate comprising:

imagewise exposing a lithographic printing plate precursor comprising, in the following order, a support;
an intermediate layer containing a copolymer containing a repeating unit derived from a monomer having a C log P value of -0.14 or less wherein C log P is the logarithm of the octanol/water partition coefficient (P) of a compound calculated using the program ClogP v4.82 (available from Daylight Chemical Information System, Inc.) and having a carbon-carbon unsaturated double bond through a covalent bond; and
an image-forming layer containing (A) a polymerization initiator, (B) a polymerizable compound and (C) a binder polymer; and
reproving an unexposed area of the image-forming layer by processing the exposed lithographic printing plate precursor with an aqueous solution having a buffer function.

**2.** The method as claimed in Claim 1, wherein the repeating unit contains at least one of a carboxylate anion, a sulfonate anion, a sulfate anion, a phosphate anion, a phosphonate anion, an ammonium cation, a phosphonium cation and a hydroxy group.

**3.** The method as claimed in Claim 1 or Claim 2, wherein the repeating unit is a repeating unit represented by one of the following formulae (I) to (VI):

Formula (I):

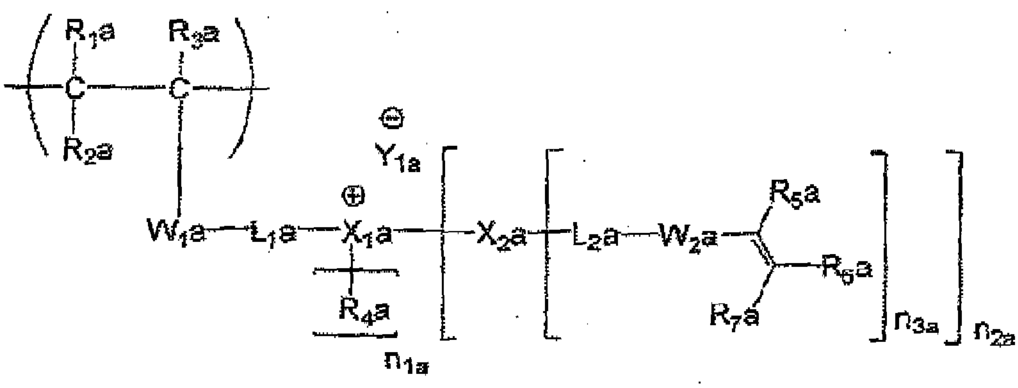

Formula (II):

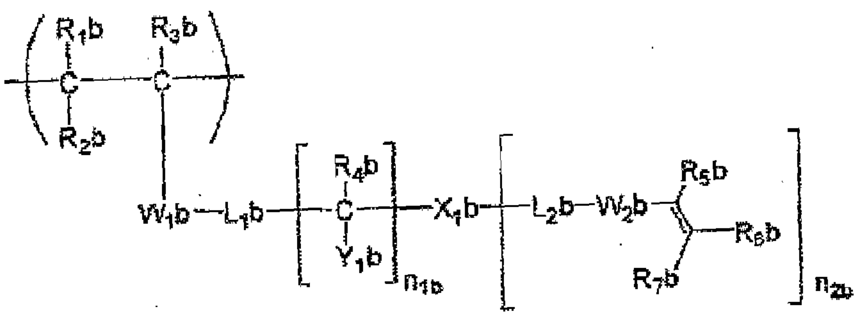

Formula (III):

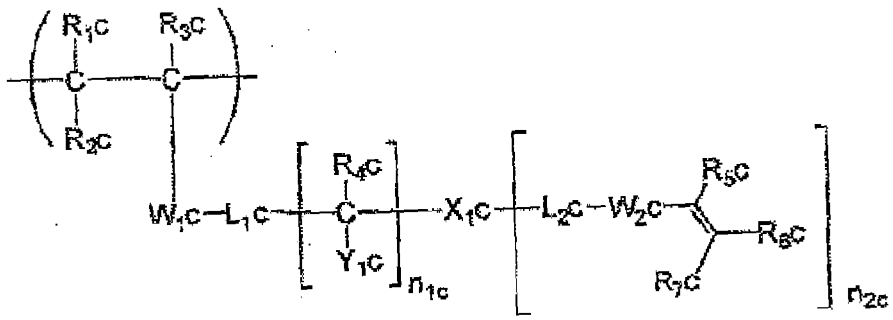

Formula (IV):

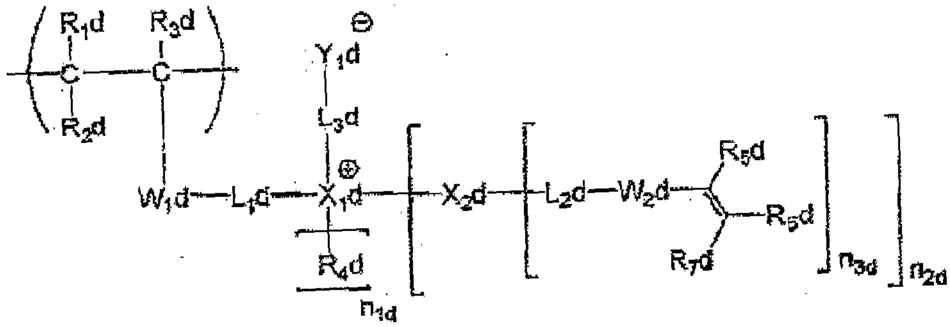

Formula (V):

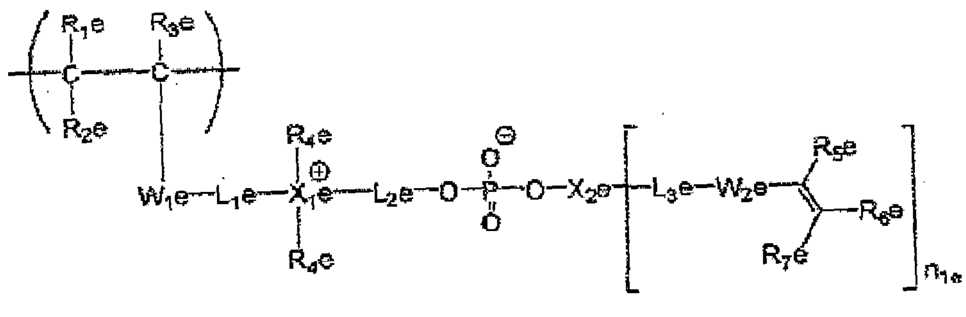

Formula (VI):

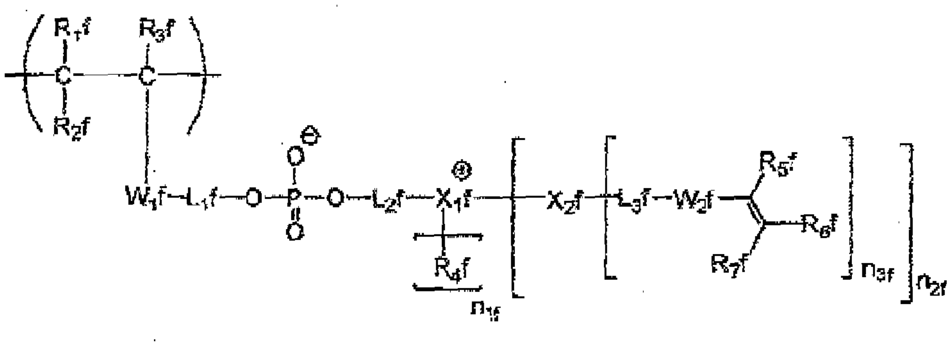

wherein, in the formula (I), $R_1$a to $R_3$a each represents a hydrogen atom, an alkyl group, a halogen atom or a cyano group, $R_4$a each represents a hydrogen atom or a substituent having from 1 to 30 carbon atoms, $R_5$a to $R_7$a each represents a hydrogen atom, an allyl group, -CO-O-Rx or -CO-N(Ry)(Rz), Rx represents an alkyl group, Ry aud Rz each represents a hydrogen atom, an aryl group or an aryl group, $L_1$a and $L_2$a each represents a single bond or a divalent connecting group, $W_1$a and $W_2$a each represents an akylene group, an arylene group, -O-, -S-, -CO-, -N(Rw)-, $-SO_2-$ or a divalent connecting group composed of an appropriate combination of these groups. Rw represents a hydrogen atom, an alkyl group or an aryl group, $X_1$a represents N or P, $X_2$a represents an ($n_3$a +1) valent connecting group, provided that when $n_3$a is 1, $X_2$a represents a single bond, $Y_1$a represents an organic or inorganic anion, $n_1$a represents an integer from 0 to 2, $n_2$a represents an integer from 1 to 3, provided that $n_1$a + $n_2$a = 3, and $n_3$a represents an integer from 1 to 4;
in the formula (II), $R_1$b to $R_3$b, $R_4$b, $R_5$b to $R_7$b, $L_1$b, $L_2$b, $W_1$b and $W_3$b have the same meanings as $R_1$a to $R_3$a, $R_4$a, $R_5$a to $R_7$a, $L_1$a, $L_2$a, $W_1$a and $W_2$a in formulae (I), respectively, $X_1$b represents an ($n_2$b + 1) valent connecting group, provided that when $n_2$b is 1, $X_1$b represents a single bond, $Y_1$b each represents a hydrogen atom, a hydroxy group or an alkyl group, provided that at least one of $Y_1$b represents a hydroxy group, $n_1$b represents an integer from 1 to 10, and $n_2$b represents an integer from 1 to 4;
in the formula (III), $R_1$c to $R_3$c, $R_4$c, $R_5$c to $R_7$c, $L_1$c, $L_2$c, $W_1$c and $W_2$c have the same meanings as $R_1$a to $R_3$a, $R_4$a, $R_5$a to $R_7$a, $L_1$a, $L_2$a, $W_1$a and $W_2$a in formula (I), respectively, $n_1$c and $n_2$c have the same meanings as $n_1$b and $n_2$b in formulae (II), respectively, $X_1$c represents an ($n_2$c + 1) valent connecting group, provided that when $n_2$c is 1, $X_1$c represents a single bond, $Y_1$c each represents a hydrogen atom, a hydroxy group, an alkyl group or a group represented by $L_3$c-Q, provided that at least one of $Y_1$c represents a group represented by $L_3$c-Q, $L_3$c represents a single bond or a divalent connecting group, Q represents $-CO_2M$, $-SO_3M$, $-OSO_3M$, $-OPO(OM_1(OM_2)$ or-$PO(OM_3)(OM_4)$, M, $M_1$ and $M_3$ each represents a monovalent metal ion or $W(R_o)_4$, $M_2$ and each represents a hydrogen atom, a monovalent metal ion or $N^+(R_0)_4$,r and $R_0$ each represents a hydrogen atom or an alkyl group;
in the formula (IV), $R_1$d to $R_3$d, $R_4$d, $R_5$d to $R_7$d, $L_1$d, $L_2$d, $W_1$d, $W_2$d, $n_3$d and $X_1$d have the same meanings as $R_1$a to $R_3$a, $R_4$a, $R_5$a to $R_7$a, $L_1$a, $L_2$a, $W_1$a, $W_2$a, $n_3$a and $X_1$a in formula (I), respectively, $L_3$d represents a divalent connecting group, $X_2$d represents an ($n_3$d +1) valent connecting group, provided that when $n_3$d is 1, $X_2$d represents a single bond, $Y_1$d represents $-CO_2^-$, $-SO_3^-$ or $-OPO(O^-)(ORp)$, Rp represents an alkyl group, $n_1$d represent 0 or 1, and $n_2$d represents 1 or 2, provided that $n_1$d + $n_2$d = 2;
in the formula (V), $R_1$e to $R_3$e, $R_4$e, $R_5$e to $R_7$e, $W_1$e, $W_2$e and $X_1$e have the same meanings as $R_1$a to $R_3$a, $R_4$a, $R_5$a to $R_7$a, $W_1{}^a$, $W_2$3 and $X_1$a in formula (I), respectively, $L_1$e and $L_2$e have the same meanings as $L_1$a in formula (I), respectively, $L_3$e has the same meaning as $L_2$a in formulae (I), $n_1$e has the same meaning as $n_2$b in formula (II), $X_2$e represents an ($n_1$e + 1) valent connecting group, provided that when $n_1$e is 1, $X_2$e represents a single bond; and in the formula (VI), $R_1$f to $R_3$f, $R_4$f, $R_5$f to $R_7$f, $W_1$f, $W_2$f, $X_1$f, $X_2$f and $n_1$f, to $n_3$f have the same meanings as $R_1$a to $R_3$a, $R_4$a, $R_5$a to $R_7$a, $W_1$a, $W_2$a, $X_1$a, $X_2$a and $n_1$a to $n_3$a in formula (1), respectively, $L_1$f and $L_2$f have the same meanings as $L_1$a in formula (I), respectively, and $L_3$f has the same meaning as $L_2$a in formula (I).

**4.** The method as claimed in any one of Claims 1 to 3, wherein the aqueous solution having a buffer function contains at least one of (a) a carbonate ion and a hydrogen carbonate ion, (b) a borate ion, and (c) a water-soluble amine compound and an ion of the amine compound.

**5.** The method as claimed in any one of Claims 2 to 4, wherein the repeating unit contains at least one of a sulfonate anion, a phosphate anion, an ammonium cation and a phosphonium cation.

## Patentansprüche

**1.** Verfahren zur Herstellung einer Lithographiedruckplatte, umfassend:

bildweises Belichten eines Lithographiedruckplattenvorläufers, der in der folgenden Reihenfolge auf einem Träger umfasst:

eine Zwischenschicht, die ein Copolymer enthält, welches eine Wiederholungseinheit enthält, die aus einem Monomer abgeleitet ist, das einen C-log-P-Wert von -0,14 oder kleiner aufweist, worin C-log-P der Logarithmus des Octanol/Wasser-Verteilungskoeffizienten (P) einer Verbindung ist, berechnet unter Verwendung des Programms ClogP v4.82 (erhältlich von Daylight Chemical Information System, Inc.), und das eine ungesättigte Kohlenstoff-Kohlenstoff-Doppelbindung über eine kovalente Bindung aufweist; und
eine bildgebende Schicht, die (A) einen Polymerisationsinitiator, (B) eine polymerisierbare Verbindung und (C) ein Bindepolymer enthält; und

Entfernen eines nicht-belichteten Bereichs der bildgebenden Schicht durch Verarbeiten des belichteten Lithographiedruckplattenvorläufers mit einer wässrigen Lösung, die eine Pufferfunktion aufweist.

2. Verfahren gemäß Anspruch 1, worin die Wiederholungseinheit mindestens eines von einem Carboxylat-Anion, einem Sulfonat-Anion, einem Sulfat-Anion, einem Phosphat-Anion, einem Phosphonat-Anion, einem Ammonium-Kation, einem Phosphonium-Kation und einer Hydroxygruppe enthält.

3. Verfahren gemäß Anspruch 1 oder Anspruch 2, worin die Wiederholungseinheit eine durch irgendeine der folgenden Formeln (I) bis (VI) dargestellt Wiederholungseinheit ist:

Formel (I):

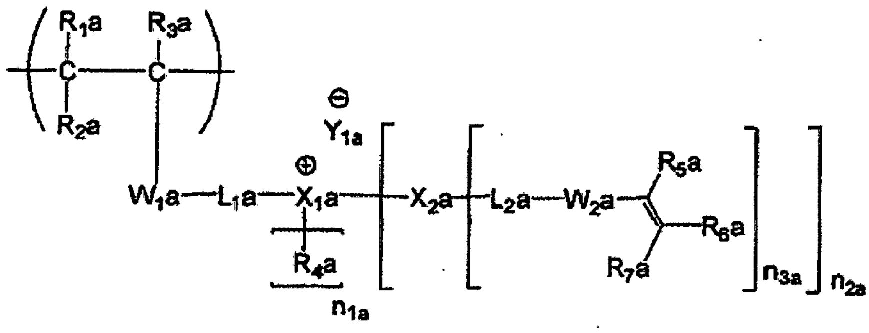

Formel (II):

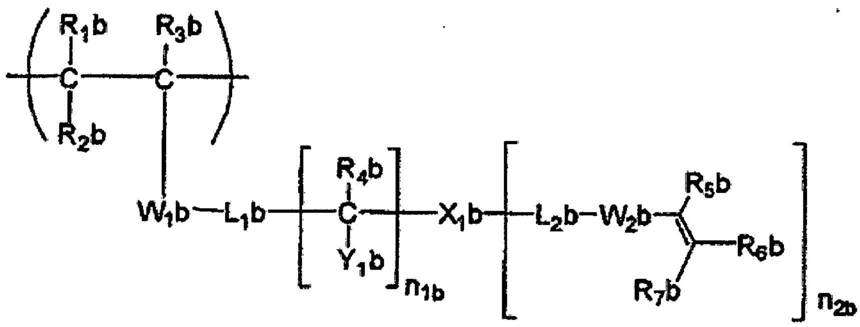

Formel (III):

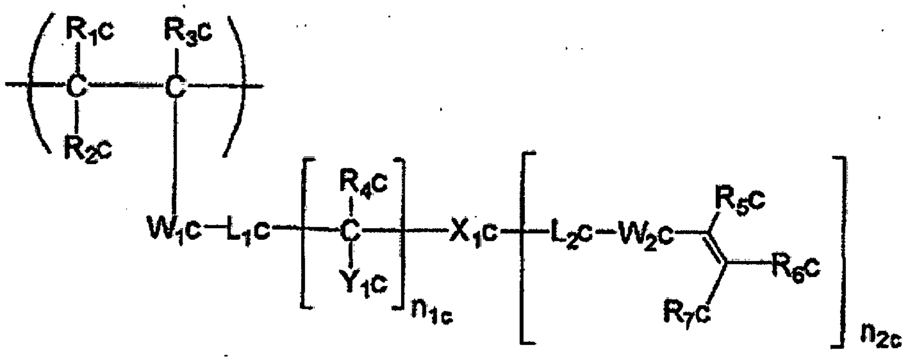

Formel (IV):

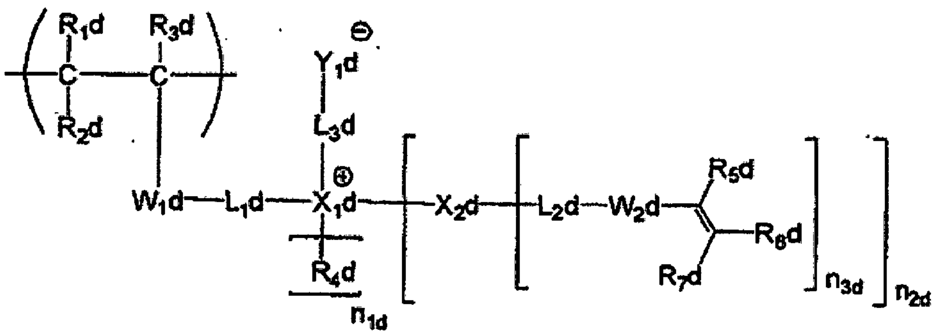

Formel (V):

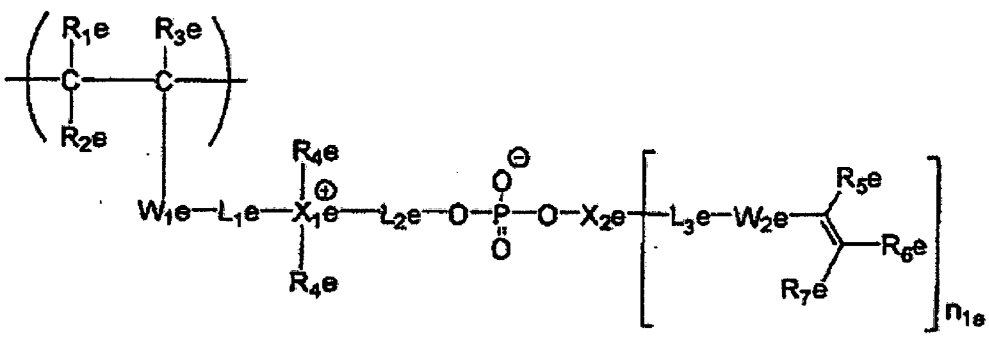

Formel (VI):

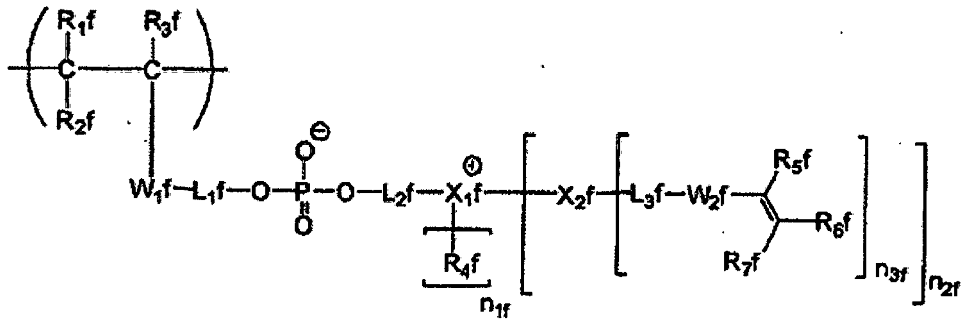

worin in der Formel (I) $R_1a$ bis $R_3a$ jeweils ein Wasserstofatom, eine Alkylgruppe, ein Halogenatom oder eine Cyanogruppe darstellen, $R_4a$ jeweils ein Wasserstoffatom oder einen Substituenten mit von 1 bis 30 Kohlenstoffatomen darstellt, $R_5a$ bis $R_7a$ jeweils ein Wasserstoffatom, eine Alkylgruppe, -CO-O-Rx oder - CO-N(Ry)(Rz) darstellen, Rx eine Alkylgruppe darstellt, Ry und Rz jeweils ein Wasserstoffatom, eine Alkylgruppe oder eine Arylgruppe darstellen, $L_1a$ und $L_2a$ jeweils eine Einfachbindung oder eine divalente Verknüpfungsgruppe darstellen, $W_1a$ und $W_2a$ jeweils eine Alkylengruppe, eine Arylengruppe, -O-, -S-, -CO-, -N(Rw)-, $-SO_2-$ oder eine divalente Verknüpfungsgruppe, die aus einer geeigneten Kombination von diesen Gruppen aufgebaut ist, darstellen, Rw ein Wasserstoffatom, eine Alkylgruppe oder eine Arylgruppe darstellt, $X_1a$ N oder P darstellt, $X_2a$ eine ($n_3a$ + 1) valente Verknüpfungsgruppe darstellt, vorausgesetzt, dass, wenn $n_3a$ 1 ist, $X_2a$ eine Einfachbindung darstellt, $Y_1a$ ein organisches oder anorganisches Anion darstellt, $n_1a$ eine ganze Zahl von 0 bis 2 darstellt, $n_2a$ eine ganze Zahl von 1 bis 3 darstellt, vorausgesetzt, dass $n_1a + n_2a = 3$ und $n_3a$ eine ganze Zahl von 1 bis 4 darstellt;
in der Formel (II), $R_1b$ bis $R_3b$, $R_4b$, $R_5b$ bis $R_7b$, $L_1b$, $L_2b$, $W_1b$ und $W_2b$ die gleichen Bedeutungen wie $R_1a$ bis $R_3a$, $R_4a$, $R_5a$ bis $R_7a$, $L_1a$, $L_2a$, $W_1a$ und $W_2a$ in Formel (I) besitzen, $X_1b$ eine ($n_2b$ + 1)-valente Verknüpfungsgruppe darstellt, vorausgestzt, dass, wenn $n_2b$ 1 ist, $X_1b$ eine Einfachbindung darstellt, $Y_1b$ jeweils ein Wasserstofatom, eine Hydroxygruppe oder eine Alkylgruppe darstellt, vorausgesetzt, dass mindestens eines der $Y_1b$ eine Hydroxygruppe darstellt, $n_1b$ eine ganze Zahl von 1 bis 10 darstellt und $n_2b$ eine ganze Zahl von 1 bis 4 darstellt;
in der Formel (III) $R_1c$ bis $R_3c$, $R_4c$, $R_5c$ bis $R_7c$, $L_1c$, $L_2c$, $W_1c$ und $W_2c$ die gleichen Bedeutungen wie $R_1a$ bis $R_3a$, $R_4a$, $R_5a$ bis $R_7a$, $L_1a$, $L_2a$, $W_1a$ und $W_2a$ in Formel (I) besitzen, $n_1c$ und $n_2c$ die gleichen Bedeutungen wie $n_1b$ und $n_2b$ in Formel (II), besitzen, $X_1c$ eine ($n_2c$ + 1)-valente Verknüpfungsgruppe darstellt, vorausgesetzt, dass, wenn $n_2c$ 1 ist, $X_1c$ eine Einfachbindung darstellt, $Y_1c$ jeweils ein Wasserstofatom, eine Hydroxygruppe, eine Alkylgruppe oder eine durch $L_3c$-Q dargestellte Gruppe darstellt, vorausgesetzt, dass mindestens eines der $Y_1c$ eine durch $L_3c$-Q dargestellte Gruppe darstellt, $L_3c$ eine Einfachbindung oder eine divalente Verknüpfungsgruppe darstellt, Q $-CO_2M$, $-SO_3M$, $-OSO_3M$, $-OPO(OM_1)(OM_2)$ oder - $PO(OM_3)(OM_4)$ darstellt, M, $M_1$ und $M_3$ jeweils ein monovalentes Metallion oder $N^+(R_0)_4$ darstellen, $M_2$ und $M_4$ jeweils ein Wasserstoffatom, ein monovalentes Metallion oder $N^+(R_0)_4$ darstellen, und $R_0$ jeweils ein Wasserstoffatom oder eine Alkylgruppe darstellt;
in der Formel (IV) $R_1d$ bis $R_3d$, $R_4d$, $R_5d$ bis $R_7d$, $L_1d$, $L_2d$, $W_1d$, $W_2d$, $n_3d$ und $X_1d$ die gleichen Bedeutungen wie $R_1a$ bis $R_3a$, $R_4a$, $R_5a$ bis $R_7a$, $L_1a$, $L_2a$, $W_1a$, $W_2a$, $n_3a$ und $X_1a$ in Formel (I) besitzen, $L_3d$ eine divalente Verknüpfungsgruppe darstellt, $X_2d$ eine ($n_3d$ + 1)-valente Verknüpfungsgruppe darstellt, vorausgesetzt, dass, wenn $n_3d$ 1 ist, $X_2d$ eine Einfachbindung darstellt, $Y_1d$ $-CO_2^-$, $-SO_3^-$ oder $-OPO(O^-)(ORp)$ darstellt, Rp eine Alkylgruppe darstellt, $n_1d$ 0 oder 1 darstellt und $n_2d$ 1 oder 2 darstellt, vorausgesetzt, dass $n_1d + n_2d = 2$;
in der formel (V) $R_1e$ bis $R_3e$, $R_4e$, $R_5e$ bis $R_7e$, $W_1e$, $W_2e$ und $X_1e$ die gleichen Bedeutungen wie $R_1a$ bis $R_3a$, $R_4a$, $R_5a$ bis $R_7a$, $W_1a$, $W_2a$ und $X_1a$ in Formel (I) besitzen, $L_1e$ und $L_2e$ die gleichen Bedeutungen wie $L_1a$ in Formel (I) besitzen, $L_3e$ die gleiche Bedueutng wie $L_2a$ in Formel (I) besitzt, $n_1e$ die gleiche Bedeutung wie $n_2b$ in Formel (II) besitzt, $X_2e$ eine ($n_1e$ + 1)-valente Verknüpfungsgruppe darstellt, vorausgesetzt, dass wenn $n_1e$ 1 ist, $X_2e$ eine Einfachbindung darstellt; und
in der Formel (VI) $R_1f$ bis $R_3f$, $R_4f$, $R_5f$ bis $R_7f$, $W_1f$, $W_2f$, $X_1f$, $X_2f$ und $n_1f$ bis $n_3f$ die gleichen Bedeutungen wie $R_1a$ bis $R_3a$, $R_4a$, $R_5a$ bis $R_7a$, $W_1a$, $W_2a$, $X_1a$, $X_2a$ und $n_1a$ bis $n_3a$ in Formel (I) besitzen, $L_1f$ und $L_2f$ die gleichen Bedeutungen wie $L_1a$ in Formel (I) besitzen und $L_3f$ die gleiche Bedeutung wie $L_2a$ in Formel (I) besitzt.

**4.** Verfahren gemäß irgendeinem der Ansprüche 1 bis 3, worin die wässrige Lösung mit Pufferfunktion mindestens eines von (a) einem Carbonat-Ion und einem Hydrogencarbonat-Ion, (b) einem Borat-Ion und (c) einer wasserlöslichen Aminverbindung und einem Ion der Aminverbindung enthält.

**5.** Verfahren gemäß irgendeinem der Ansprüche 2 bis 4, worin die Wiederholungseinheit mindestens eines von einem Sulfonat-Anion, einem Phosphat-Anion, einem Ammonium-Kation und einem Phosphonium-Kation enthält.

## Revendications

**1.** Procédé de préparation d'une plaque d'impression lithographique, comprenant :

l'exposition selon une image d'un précurseur de plaque d'impression lithographique comprenant, dans l'ordre suivant, un support ;
une couche intermédiaire contenant un copolymère contenant un motif répétitif tiré d'un monomère présentant une valeur C log P de -0,14 ou moins, C log P étant le logarithme du coefficient de partage octanol/eau (P) d'un composé calculé en utilisant le programme ClogP v4.82 (disponible chez Daylight Chemical Information system, Inc.) et contenant une double liaison carbone-carbone insaturée par l'intermédiaire d'une liaison covalente ; et
une couche de formation d'image contenant (A) un initiateur de polymérisation, (B) un composé polymérisable et (C) un polymère liant ; et
l'élimination d'une zone non exposée de la couche de formation d'image par traitement du précurseur de plaque d'impression lithographique exposé avec une solution aqueuse ayant une fonction tampon.

**2.** Procédé selon la revendication 1, dans lequel le motif répétitif contient au moins un motif parmi un anion carboxylate, un anion sulfonate, un anion sulfate, un anion phosphate, un anion phosphonate, un cation ammonium, un cation phosphonium et un groupement hydroxy.

**3.** Procédé selon la revendication 1 ou la revendication 2, dans lequel le motif répétitif est un motif répétitif représenté par l'une des formules (I) à (VI) suivantes :

Formule (I) :

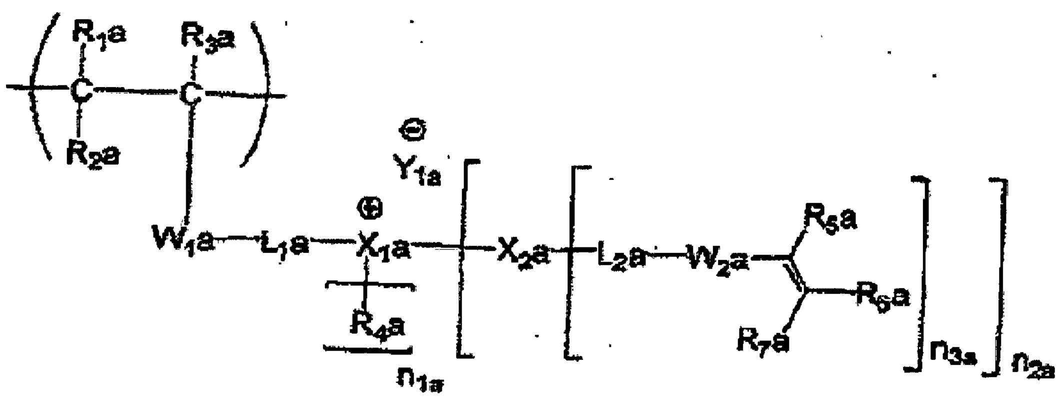

Formule (II) :

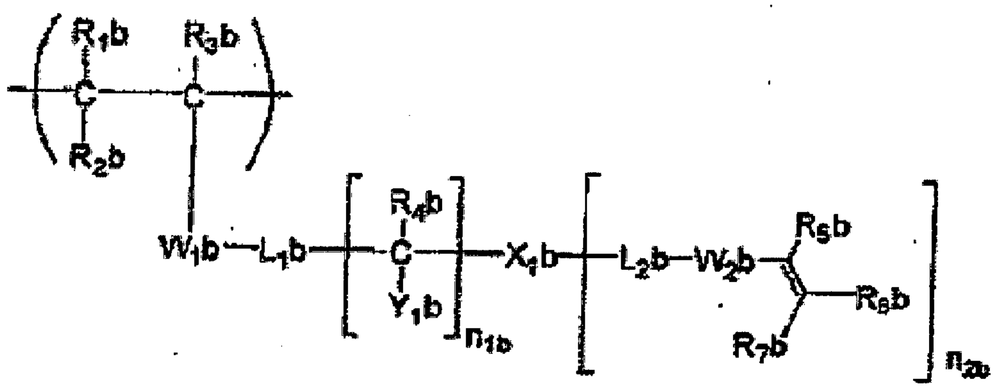

Formule (III) :

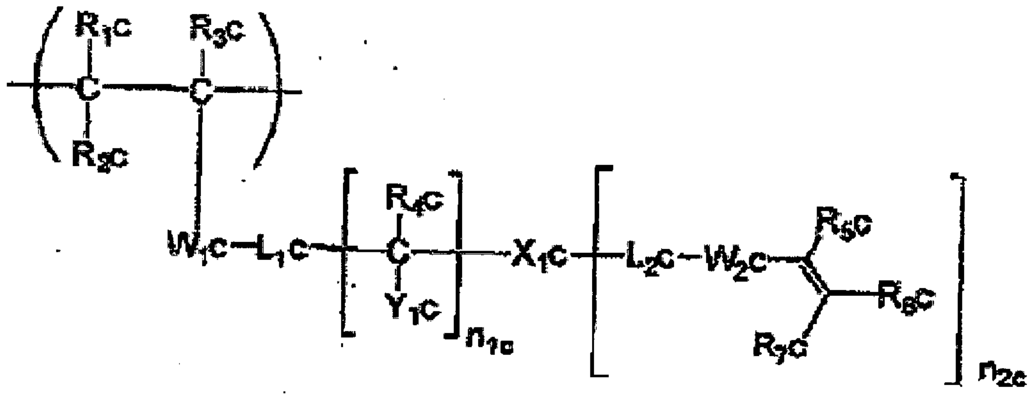

Formule (IV) :

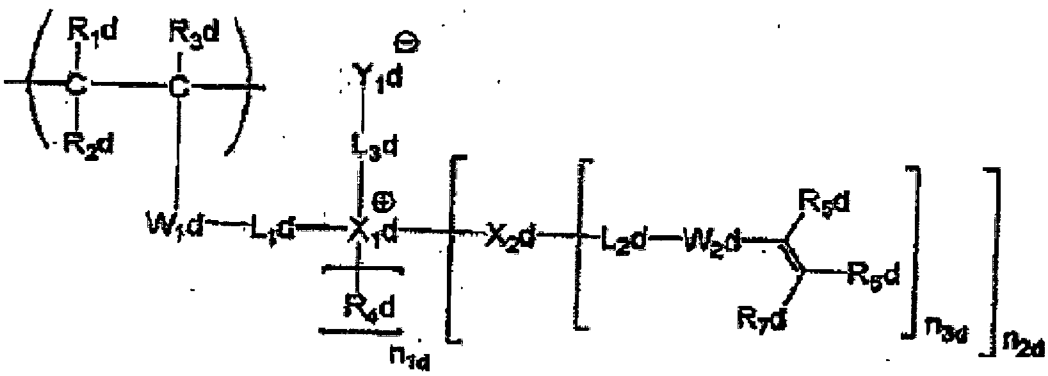

Formule (V) :

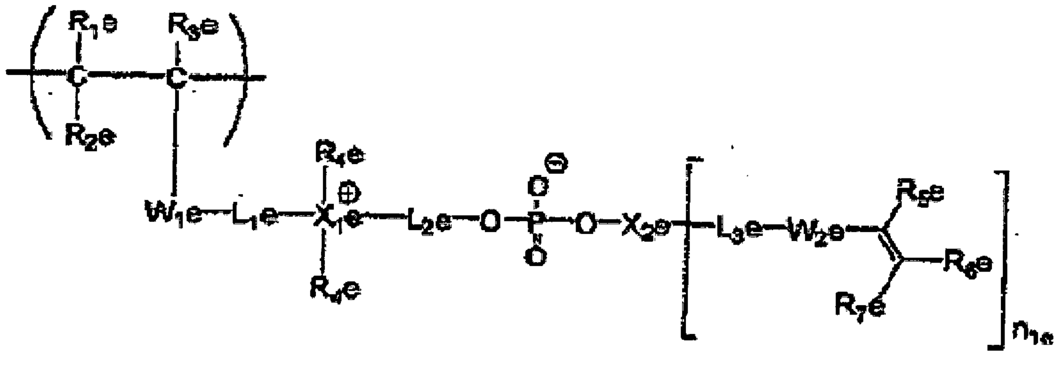

Formule (VI) :

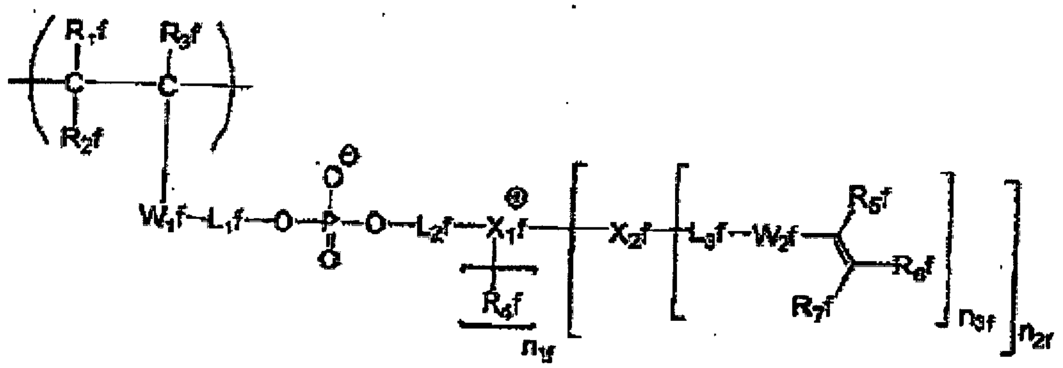

dans lesquelles, dans la formule (I), $R_1a$ à $R_3a$ représentent chacun un atome d'hydrogène, un groupement alkyle, un atome d'halogène ou un groupement cyano, $R_4a$ représentent chacun un atome d'hydrogène ou un substituant contenant 1 à 30 atomes de carbone, $R_5a$ à $R_7a$ représentent chacun un atome d'hydrogène, un groupement alkyle, -CO-O-Rx ou -CO-N(Ry)(Rz), Rx représente un groupe alkyle, Ry et Rz représentent chacun un atome d'hydrogène, un groupement alkyle ou un groupement aryle, $L_1a$ et $L_2a$ représentent chacun une liaison simple ou un groupement divalent de liaison, $W_1a$ et $W_2a$ représentent chacun un groupement alkylène, un groupement arylène, -O-, -S-, -CO-, -N(Rw)-, $-SO_2$-ou un groupement divalent de liaison composé d'une composition appropriée de ces groupements, Rw représente un atome d'hydrogène, un groupement alkyle ou un groupement aryle, $X_1a$ représente N ou P, $X_2a$ représente un groupement ($n_3a$ + 1)-valent de liaison, à condition que, quand $n_3a$ est 1, $X_2a$ représente une liaison simple, $Y_1a$ représente un anion organique ou inorganique, $n_1a$ représente un nombre entier de 0 à 2, $n_2a$ représente un nombre entier de 1 à 3, à condition que $n_1a + n_2a = 3$, et $n_3a$ représente un nombre entier de 1 à 4 ; dans la formule (II), $R_1b$ à $R_3b$, $R_4b$, $R_5b$ à $R_7b$, $L_1b$, $L_2b$, $W_1b$ et $W_2b$ ont respectivement les mêmes significations que $R_1a$ à $R_3a$, $R_4a$, $R_5a$ à $R_7a$, $L_1a$, $L_2a$, $W_1a$ et $W_2a$ dans la formule (I), $X_1b$ représente un groupe ($n_2b$ + 1) -valent de liaison, à condition que, quand $n_2b$ est 1, $X_1b$ représente une liaison simple, $Y_1b$ représentent chacun un atome d'hydrogène, un groupement hydroxy ou un groupement alkyle, à condition qu'au moins l'un des $Y_1b$ représente un groupement hydroxy, $n_1b$ représente un nombre entier de 1 à 10 et $n_2b$ représente un nombre entier de 1 à 4 ; dans la formule (III), $R_1c$ à $R_3c$, $R_4c$, $R_5c$ à $R_7c$, $L_1c$, $L_2c$, $W_{1c}$ et $W_2c$ ont respectivement les mêmes significations que $R_1a$ à $R_3a$, $R_4a$, $R_5a$ à $R_7a$, $L_1a$, $L_2a$, $W_1a$ et $W_2a$ dans la formule (I), $n_1c$ et $n_2c$ ont respectivement les mêmes significations que $n_1b$ et $n_2b$ dans la formule (II), $X_1c$ représente un groupe ($n_2c$ + 1)-valent de liaison, à condition que, quand $n_2c$ est 1, $X_1c$ représente une liaison simple, $Y_1c$ représentent chacun un atome d'hydrogène, un groupement hydroxy, un groupement alkyle ou un groupement représenté par $L_3c$-Q, à condition qu'au moins l'un des $Y_1c$ représente un groupement représenté par $L_3c$-Q, $L_3c$ représente une liaison simple ou un groupement divalent de liaison, Q représente $-CO_2M$, $-SO_3M$, $-OSO_3M$, $-OPO(OM_1)$ $(OM_2)$ ou - $PO(OM_3)$ $(OM_4)$, M, $M_1$ et $M_3$ représentent chacun un ion métallique monovalent ou $N^+(R_o)_4$, $M_2$ et $M_4$ représentent chacun un atome d'hydrogène, un ion métallique monovalent ou $N^+(R_o)_4$ et $R_o$ représentent chacun un atome d'hydrogène ou un groupement alkyle ;

dans la formule (IV), $R_1d$ à $R_3d$, $R_4d$, $R_5d$ à $R_7d$, $L_1d$, $L_2d$, $W_1d$, $W_2d$, $n_3d$ et $X_1d$ ont respectivement les mêmes significations que $R_1a$ à $R_3a$, $R_4a$, $R_5a$ à $R_7a$, $L_1a$, $L_2a$, $W_1a$, $W_2a$, $n_3a$ et $X_1a$ dans la formule (I), $L_3d$ représente un groupement divalent de liaison, $X_2d$ représente un groupement ($n_3d$ + 1)-valent de liaison, à condition que, quand $n_3d$ est 1, $X_2d$ représente une liaison simple, $Y_1d$ représente $-CO_2^-$, $-SO_3^-$ ou $OPO(O^-)(ORp)$, Rp représente un groupement alkyle, $n_1d$ représente 0 ou 1, et $n_2d$ représente 1 ou 2, à condition que $n_1d + n_2d = 2$ ;
dans la formule (V), $R_1e$ à $R_3e$, $R_4e$, $R_5e$ à $R_7e$, $W_1e$, $W_2e$ et $X_1e$ ont respectivement les mêmes significations que $R_1a$ à $R_3a$, $R_4a$, $R_5a$ à $R_7a$, $W_1a$, $W_2a$ et $X_1a$ dans la formule (I), $L_1e$ et $L_2e$ ont respectivement les mêmes significations que $L_1a$ dans la formule (I), $L_3e$ a la même signification que $L_2a$ dans la formule (I), $n_1e$ a la même signification que $n_2b$ dans la formule (II), $X_2e$ représente un groupement ($n_1e$ + 1)-valent de liaison, à condition que, quand $n_1e$ est 1, $X_2e$ représente une liaison simple ; et
dans la formule (VI), $R_1f$ à $R_3f$, $R_4f$, $R_5f$ à $R_7f$, $W_1f$, $W_2f$, $X_1f$, $X_2f$ et $n_1f$ à $n_3f$ ont respectivement les mêmes significations que $R_1a$ à $R_3a$, $R_4a$, $R_5a$ à $R_7a$, $W_1a$, $W_2a$, $X_1a$, $X_2a$ et $n_1a$ à $n_3a$ dans la formule (I), $L_1f$ et $L_2f$ ont respectivement la même signification que $L_1a$ dans la formule (I) et $L_3f$ a la même signification que $L_2a$ dans la formule (I).

**4.** Procédé selon l’une quelconque des revendications 1 à 3, dans lequel la solution aqueuse ayant une fonction tampon contient au moins l’un parmi (a) un ion carbonate et un ion hydrogénocarbonate, (b) un ion borate et (c) un composé aminé hydrosoluble et un ion du composé aminé.

**5.** Procédé selon l’une quelconque des revendications 2 à 4, dans lequel le motif répétitif contient au moins l’un d’un anion sulfonate, d’un anion phosphate, d’un cation ammonium et d’un cation phosphonium.

FIG. 1

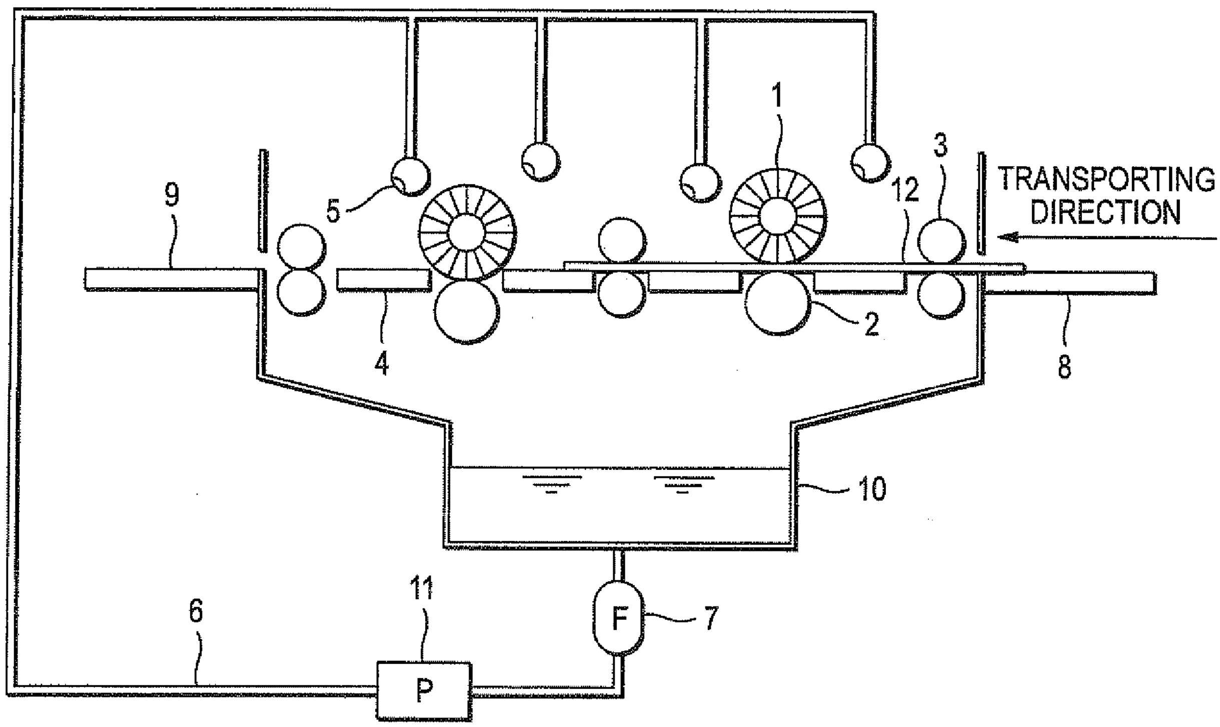

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2006239867 A
- JP 2008256742 A
- EP 2226681 A
- EP 2107422 A
- EP 2006738 A
- EP 1767352 A
- JP 2005125749 A
- JP 2006215263 A
- JP 10282679 A
- JP 2304441 A
- JP 2005238816 A
- JP 4537377 B
- JP 4486516 B
- JP 2007206217 A
- JP 48041708 B
- JP 51037193 A
- JP 2032293 B
- JP 2016765 B
- JP 58049860 B
- JP 56017654 B
- JP 62039417 B
- JP 62039418 B
- JP 2007187836 A
- JP 2008276155 A
- JP 2005250438 A
- JP 2005250158 A
- JP 2001075279 A
- JP 2007058170 A
- JP 2007093866 A
- JP 2007072816 A
- JP 2007171406 A
- JP 2007206216 A
- JP 2007225701 A
- JP 2007225702 A
- JP 2007316582 A
- JP 2007328243 A
- JP 2001133969 A
- JP 2002023360 A
- JP 2002040638 A
- JP 2002278057 A
- JP 2008195018 A
- JP 2007090850 A
- JP 5005005 A
- JP 2001222101 A
- JP 2009029124 A
- JP 2005250216 A
- JP 2006025913 A
- JP 5045885 A
- JP 6035174 A
- JP 2008203359 A
- JP 2008276166 A
- JP 2009047927 A


### Non-patent literature cited in the description


- **A.J. LEO.** Comprehensive Medicinal Chemistry. Pergamon Press, 1990, vol. 4, 295
- **C. HANSCH ; A.J. LEO.** Substituent Constants for Correlation Analysis in Chemistry and Biology. John Wiley & Sons
- **A.J. LEO.** Calculating logPoct from Structure. *Chem. Rev.,* 1993, vol. 93, 1281-1306
- Shin Kobunshi Jikkengaku 3. Kobunshi no Gosei to Hanno. Kyoritsu Shuppan Co., Ltd, vol. 1
- Shin Jikken Kagaku Koza 19. Kobunshi Kagaku. Maruzen Co., Ltd, vol. I)
- Busshitsu Kogaku Koza. Kobunshi Gosei Kagaku. Tokyo Denki University Press
- Senryo Binran (Dye Handbook). *The Society of Synthetic Organic Chemistry,* 1970
- Colour Index (C.I.), Saishin Ganryo Binran (Handbook of the Newest Pigments). Pigment Technology Society of Japan. 1977
- Saishin Ganryo Oyou Gijutsu. CMC Publishing Co., Ltd, 1986
- Insatsu Ink Gijutsu (Printing Ink Technology). CMC Publishing Co., Ltd, 1984
- Kobunshi Jiten. The Society of Polymer Science. 2005, 683-684